(19) Europäisches Patentamt
European Patent Office
Office européen des brevets

(11) EP 3 872 240 A1

(12) **EUROPEAN PATENT APPLICATION**
published in accordance with Art. 153(4) EPC

(43) Date of publication:
**01.09.2021 Bulletin 2021/35**

(21) Application number: **19876084.5**

(22) Date of filing: **23.10.2019**

(51) Int Cl.:
***C30B 29/60*** *(2006.01)* ***C01B 33/00*** *(2006.01)*
***C01B 33/12*** *(2006.01)*

(86) International application number:
**PCT/JP2019/041579**

(87) International publication number:
**WO 2020/085403 (30.04.2020 Gazette 2020/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.10.2018 JP 2018200047**

(71) Applicant: **NATIONAL INSTITUTE OF ADVANCED INDUSTRIAL SCIENCE AND TECHNOLOGY**
**Chiyoda-ku**
**Tokyo 100-8921 (JP)**

(72) Inventors:
- **IGARASHI, Masayasu**
  **Tsukuba-shi, Ibaraki 305-8560 (JP)**
- **MATSUMOTO, Tomohiro**
  **Tsukuba-shi, Ibaraki 305-8560 (JP)**
- **NOZAWA, Takeshi**
  **Tsukuba-shi, Ibaraki 305-8560 (JP)**
- **YAGIHASHI, Fujio**
  **Tsukuba-shi, Ibaraki 305-8560 (JP)**
- **SATO, Kazuhiko**
  **Tsukuba-shi, Ibaraki 305-8560 (JP)**

(74) Representative: **V.O.**
**P.O. Box 87930**
**2508 DH Den Haag (NL)**

# (54) CRYSTAL, METHOD FOR PRODUCING CRYSTAL, AND METHOD FOR SELF-ASSEMBLING SILANOL COMPOUNDS

(57) The present invention provides a crystal comprising a plurality of silanol compounds of at least one selected from the group consisting of a hexamer represented by following formula (1), an octamer represented by following formula (2), and a decamer represented by following formula (3), and having an interaction via a hydrogen bond by at least one hydroxy group between the silanol compounds.

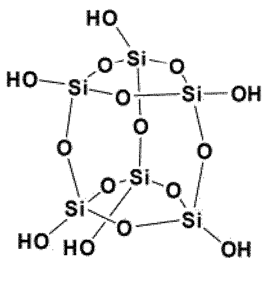
(1)

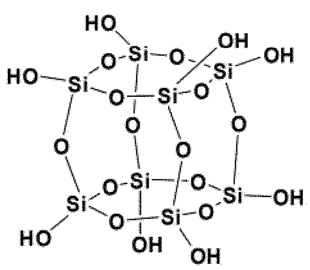
(2)

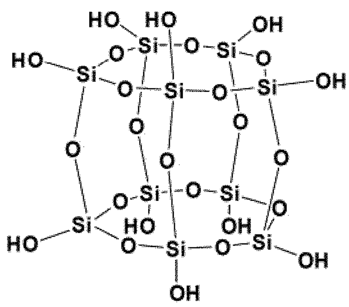
(3)

EP 3 872 240 A1

[Figure 2]

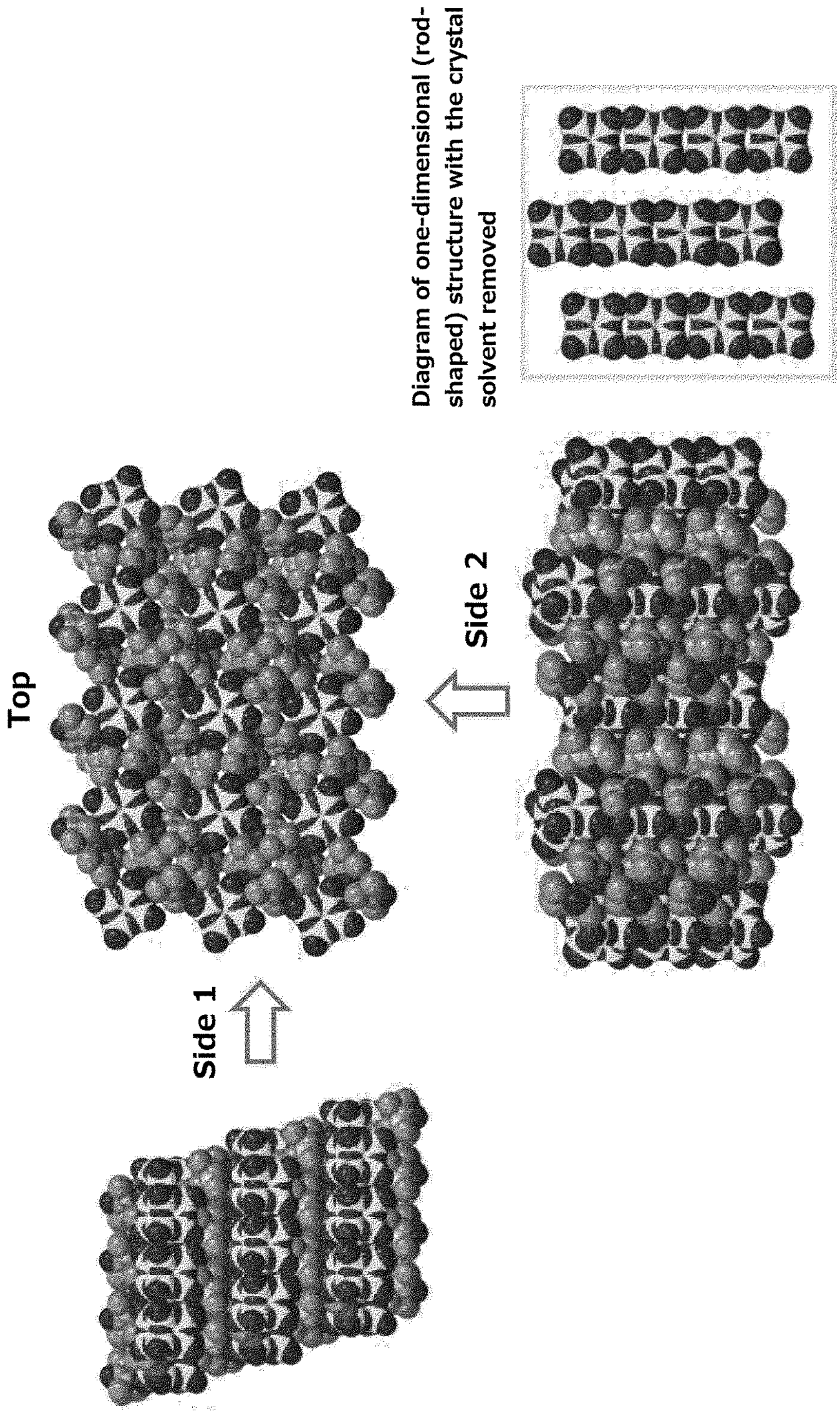
Top
Side 1
Side 2
Diagram of one-dimensional (rod-shaped) structure with the crystal solvent removed

## Description

Technical Field

The present invention relates to a crystal, a method of producing a crystal, and a method of self-organizing a silanol compound.

Background Art

Construction by controlling a substance at the atomic level can develop an unprecedented physical property to provide a useful material. For example, a fullerene, a carbon nanotube, and a graphene are nanocarbon materials in which carbon is put up in 0 dimensions, 1 dimension, and 2 dimensions, respectively, and each have a unique physical property.

$SiO_2$ is a material that exists inexhaustibly on the earth, as does carbon, and has been used until now. As a method of obtaining a $SiO_2$ material constructed by controlling $SiO_2$ at the atomic level, like a nanocarbon material, a method of putting up orthosilicic acid ($Si(OH)_4$), which is a basic unit of $SiO_2$, is considered to be efficient.

It is known that $Si(OH)_4$ can be synthesized and isolated, for example, by reacting a silicon compound having a benzyl protecting group that can be removed by hydrocracking in the presence of a Pd or Pt/C catalyst (Non-Patent Literature 1). In addition, the above method has succeeded in synthesizing and isolating a dimer, a cyclic trimer, and a cyclic tetramer of $Si(OH)_4$. Oligomers such as these dimer, cyclic trimer, and cyclic tetramer of $Si(OH)_4$ are also useful as a raw material for obtaining a $SiO_2$ material.

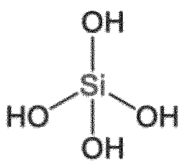 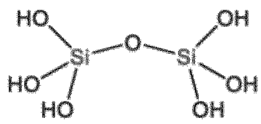 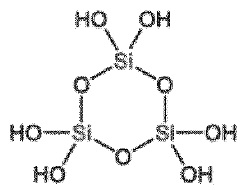 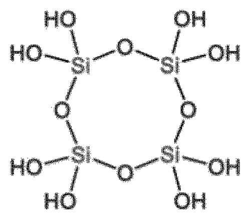

Citation List

Non-Patent Literature

Non-Patent Literature 1: Nature Communications, 2017, 8, 140.

Summary of Invention

Technical Problem

In order to obtain a $SiO_2$ material constructed by controlling $SiO_2$ at the atomic level, as described above, a method of putting up orthosilicic acid ($Si(OH)_4$), which is a basic unit of $SiO_2$, is considered. As described above, although the isolation of $Si(OH)_4$ and the dimer, the cyclic trimer, and the cyclic tetramer of $Si(OH)_4$ has been achieved, there is a demand for a raw material suitable for more efficiently controlling and putting up the basic unit of $SiO_2$ in order to obtain a $SiO_2$ material.

The present invention has been made in view of the above circumstances, and an object of the present invention is to provide a raw material useful for obtaining a $SiO_2$ material.

Solution to Problem

As a result of intensive studies to solve the above problem, the present inventors have found that a predetermined oligomer of $Si(OH)_4$ self-organizes while being controlled at the atomic level, and the oligomer can be obtained as a regularly aligned crystal, and have completed the present invention.

That is, this application provides the following inventions.

[1] A crystal
comprising a plurality of silanol compounds of at least one selected from the group consisting of a hexamer represented by following formula (1), an octamer represented by following formula (2), and a decamer represented by

following formula (3), and
having an interaction via a hydrogen bond by at least one hydroxy group between the silanol compounds.

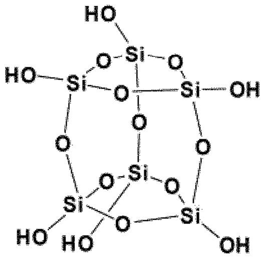

(1)

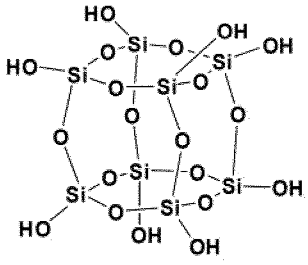

(2)

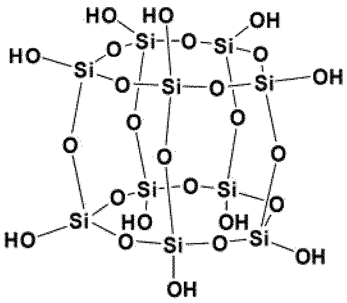

(3)

[2] The crystal according to [1], wherein the crystal has a one-dimensional structure in which the silanol compounds are linearly aligned by the interaction via the hydrogen bond.
[3] The crystal according to [1], wherein the crystal has a two-dimensional structure in which the silanol compounds are planarly aligned by the interaction via the hydrogen bond.
[4] The crystal according to [1], wherein the crystal has a three-dimensional structure in which the silanol compounds are sterically aligned by the interaction via the hydrogen bond.
[5] The crystal according to any of [1] to [4], wherein the crystal comprises at least one substance selected from the group consisting of an organic compound, a transition metal complex, an inorganic substance, and an elemental substance.
[6] A method of producing the crystal according to any of [1] to [5], the method comprising:

a step of preparing a solution containing the silanol compounds; and
a step of carrying out recrystallization by a vapor diffusion process applied to the solution and, optionally, by further adding at least one substance selected from the group consisting of an organic compound, a transition metal complex, an inorganic substance, and an elemental substance to the solution.

[7] A method of producing the crystal according to any of [1] to [5], the method comprising:

a step of preparing a solution containing the silanol compounds; and
a step of carrying out recrystallization by concentrating the solution under reduced pressure and, optionally, by further adding at least one substance selected from the group consisting of an organic compound, a transition metal complex, an inorganic substance, and an elemental substance to the solution.

[8] A method of producing the crystal according to any of [1] to [5], the method comprising:

a step of preparing a solution containing the silanol compounds; and
a step of carrying out recrystallization by cooling the solution and, optionally, by further adding at least one substance selected from the group consisting of an organic compound, a transition metal complex, an inorganic substance, and an elemental substance to the solution.

[9] A method of producing a crystal (P) comprising at least one substance selected from the group consisting of an organic compound, a transition metal complex, an inorganic substance, and an elemental substance, the method comprising:

a step of preparing a crystal (S) comprising a plurality of silanol compounds of at least one selected from the group consisting of a hexamer represented by following formula (1), an octamer represented by following formula (2), and a decamer represented by following formula (3), having an interaction via a hydrogen bond by at least one hydroxy group between the silanol compounds, and comprising at least one first substance selected from the group consisting of an organic compound, a transition metal complex, an inorganic substance, and an elemental substance; and
a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second

substance.

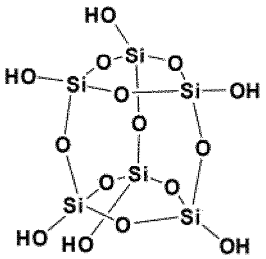

(1)

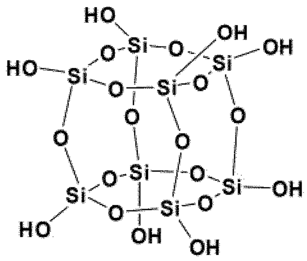

(2)

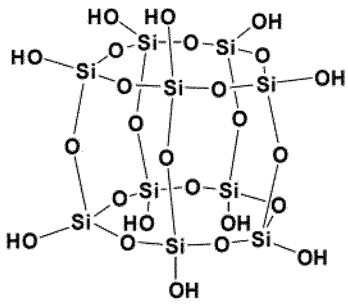

(3)

[10] The method according to [9], wherein
the step of preparing a crystal (S) comprises:

a step of preparing a solution containing the silanol compounds; and
a step of carrying out recrystallization by a vapor diffusion process applied to the solution or by concentrating the solution under reduced pressure or by cooling the solution, and, optionally, by further adding at least one substance selected from the group consisting of an organic compound, a transition metal complex, an inorganic substance, and an elemental substance to the solution.

[11] A method of self-organizing at least one silanol compound selected from the group consisting of a hexamer represented by following formula (1), an octamer represented by following formula (2), and a decamer represented by following formula (3), the method comprising:
a step of forming an interaction by a hydrogen bond by a vapor diffusion process applied to a solution containing the silanol compound or by concentrating the solution under reduced pressure or by cooling the solution.

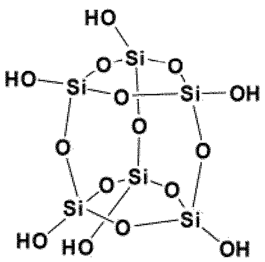

(1)

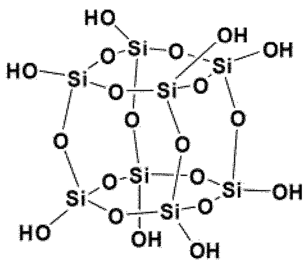

(2)

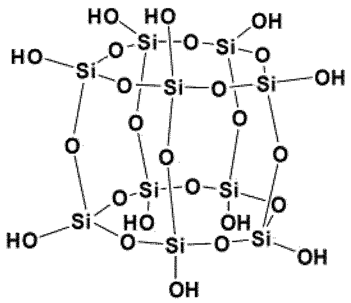

(3)

Advantageous Effect of Invention

According to the present invention, a crystal in which an oligomer of $Si(OH)_4$ is regularly aligned can be provided.

Brief Description of Drawings

[Figure 1] Figure 1 shows a diagram illustrating face 1 and face 2 in a schematic representation of an aligned structure viewed in a perspective direction.
[Figure 2] Figure 2 shows a diagram showing a crystal structure determined from single crystal X-ray crystal structure analysis of the crystal (one-dimensional (rod-shaped) structure) produced in Example 1.
[Figure 3] Figure 3 shows a diagram showing a crystal structure determined from single crystal X-ray crystal structure analysis of the crystal (two-dimensional (sheet-shaped) structure) produced in Example 3.
[Figure 4] Figure 4 shows a diagram showing a crystal structure determined from single crystal X-ray crystal structure analysis of the crystal (three-dimensional (nanohoneycomb-shaped) structure) produced in Example 5.

Description of Embodiments

Hereinafter, the present invention will be described in detail, but the present invention is not limited thereto, and various modifications can be made without departing from the gist thereof.

[Crystal]

The crystal of the present invention includes at least one silanol compound selected from the group consisting of a hexamer represented by the following formula (1) (hereinafter, simply referred to as a "hexamer"), an octamer represented by the following formula (2) (hereinafter, simply referred to as an "octamer"), and a decamer represented by the following formula (3) (hereinafter, simply referred to as a "decamer"). In addition, the number of compounds constituting the crystal of the present invention is plural. Further, the crystal of the present invention has an interaction via a hydrogen bond by at least one hydroxy group between the silanol compounds.

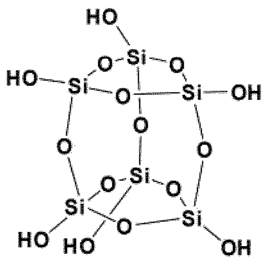

(1)

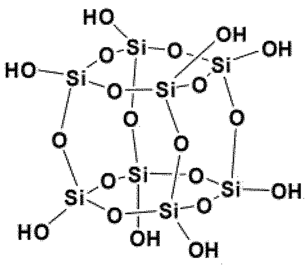

(2)

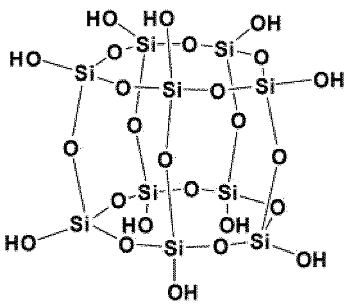

(3)

A plurality of silanol compounds contained in the crystal of the present invention interact with each other via a hydrogen bond by at least one hydroxy group in the silanol compound.

The interaction via a hydrogen bond in the present invention refers to a non-covalent interaction formed by the hydrogen atom of a hydroxy group contained in any silanol compound molecule in the crystal with an unshared electron pair of an oxygen atom in another silanol compound molecule. The interaction via a hydrogen bond is preferably formed between hydrogen and oxygen in hydroxy groups of silanol compounds.

The crystal as used herein is solid and includes an assemblage in which silanol compounds are regularly aligned by an interaction via a hydrogen bond. In the above assemblage, the silanol compounds may be aligned to form a chain or form a ring.

It can be confirmed by carrying out X-ray crystal structure analysis of the crystal that the crystal includes an interaction via a hydrogen bond between silanol compounds.

The crystal of the present invention contains a plurality of silanol compounds of at least one selected from the group consisting of the hexamer, the octamer, and the decamer described above. Preferable examples of the crystal of the present invention include a crystal (I) containing a plurality of hexamer silanol compounds, a crystal (II) containing a plurality of octamer silanol compounds, and a crystal (III) containing a plurality of decamer silanol compounds. In addition, the crystal of the present invention may contain a plurality of at least two silanol compounds selected from the group consisting of a hexamer silanol compound, an octamer silanol compound, and a decamer silanol compound. Further, the crystal of the present invention may be a mixture of at least two crystals, for example, a mixture of at least two selected from the group consisting of the above crystal (I), crystal (II), and crystal (III).

In the crystal of the present invention, the hydroxy group forming a hydrogen bond in the silanol compound is arbitrary. That is, the hydroxy group forming a hydrogen bond in the silanol compound may be any of 6 hydroxy groups of a hexamer, any of 8 hydroxy groups of an octamer, or any of 10 hydroxy groups of a decamer.

The number of hydroxy groups forming a hydrogen bond in the silanol compound may be one or more per molecule.

However, from the viewpoint of forming a crystal, when silanol compounds are aligned to form a chain assemblage, the number of hydroxy groups forming a hydrogen bond in the silanol compounds is 2 or more per molecule, except for the terminal silanol compounds.

In addition, when the silanol compounds are aligned to form a cyclic assemblage, the number of hydroxy groups forming a hydrogen bond in the silanol compounds is two or more per molecule.

When the crystal of the present invention contains a hexamer silanol compound and the silanol compound forms a chain assemblage, the number of hydroxy groups forming a hydrogen bond may be any of 2, 3, 4, 5, and 6 per molecule, except for the terminal silanol compounds of the chain assemblage. In addition, when the crystal of the present

invention contains a hexamer silanol compound and the silanol compound is aligned to form a cyclic assemblage, the number of hydroxy groups forming a hydrogen bond may be any of 2, 3, 4, 5, and 6 per molecule.

When the crystal of the present invention contains an octamer silanol compound and the silanol compound forms a chain assemblage, the number of hydroxy groups forming a hydrogen bond may be any of 2, 3, 4, 5, 6, 7, and 8 per molecule, except for the terminal silanol compounds of the chain assemblage. In addition, when the crystal of the present invention contains an octamer silanol compound and the silanol compound is aligned to form a cyclic assemblage, the number of hydroxy groups forming a hydrogen bond may be any of 2, 3, 4, 5, 6, 7, and 8 per molecule.

When the crystal of the present invention contains a decamer silanol compound and the silanol compound forms a chain assemblage, the number of hydroxy groups forming a hydrogen bond may be any of 2, 3, 4, 5, 6, 7, 8, 9, and 10 per molecule, except for the terminal silanol compounds of the chain assemblage. In addition, when the crystal of the present invention contains a decamer silanol compound and the silanol compound is aligned to form a cyclic assemblage, the number of hydroxy groups forming a hydrogen bond may be any of 2, 3, 4, 5, 6, 7, 8, 9, and 10 per molecule.

The hexamer, octamer, and decamer silanol compounds contained in the crystal of the present invention self-organize and are regularly aligned to form an assemblage. Hereinafter, the forms of hexamer, octamer, and decamer silanol compounds will be illustrated, but in the present specification, in the structures of a hexamer, an octamer, and a decamer, by omitting one Si-O-Si bond and expressing it as one side and omitting the OH group as follows, the structures of formulas (1), (2), and (3) may also be abbreviated as follows.

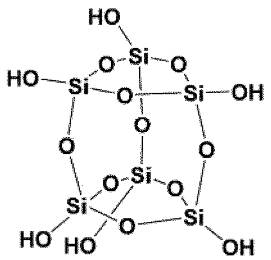

(1)

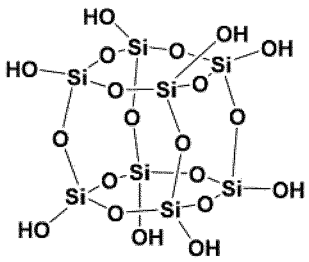

(2)

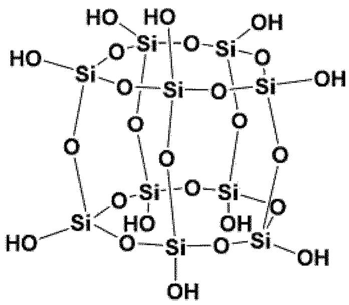

(3)

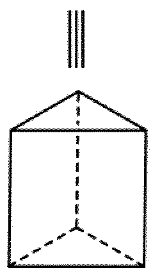

(1)

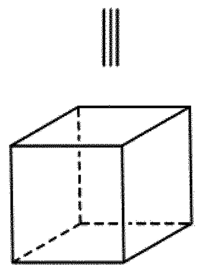

(2)

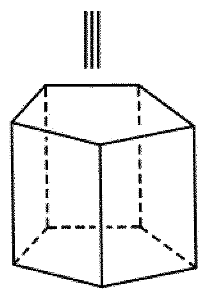

(3)

The form of alignment is not particularly limited, and examples thereof include a one-dimensional structure in which silanol compounds are linearly aligned.

The one-dimensional structures of a hexamer, an octamer, and a decamer are not particularly limited, and examples thereof include the structures shown in the following Table 1-1, Table 1-2, Table 2, and Table 3-1, Table 3-2, and Table 4. The structures shown in these tables are intended to schematically represent the alignment of silanol compounds constituting the one-dimensional structure by indicating the arrangement of the silanol compounds and/or the orientation of the face of the cyclic silanol in the silanol compounds, and the one-dimensional structure in the present invention also allows the silanol compound to deviate from these schematically represented alignments and/or the face of the cyclic silanol to deviate from the axis of alignment.

In the structures shown in the following Table 1-1, Table 1-2, Table 2, Table 3-1 and Table 3-2, and Table 4, the mode of a hydrogen bond is arbitrary, as long as the hydrogen bond is formed in such a way as to allow for the alignments. Therefore, in the structures shown in the following Table 1-1, Table 1-2, Table 2, Table 3-1 and Table 3-2, and Table 4, the hydrogen bond is omitted. As used herein, the mode of the hydrogen bond refers to the number and position of a hydrogen bond formed between silanol compounds. In addition, the number of aligned silanol compounds is, of course, not limited to the numbers shown in each table.

For example, in form 4 of Table 1-1, for example, the mode of the hydrogen bond may be the forms of the hydrogen bond shown in the following structures A and B, and, even in one form, the number and position of the hydrogen bond formed is arbitrary.

A B

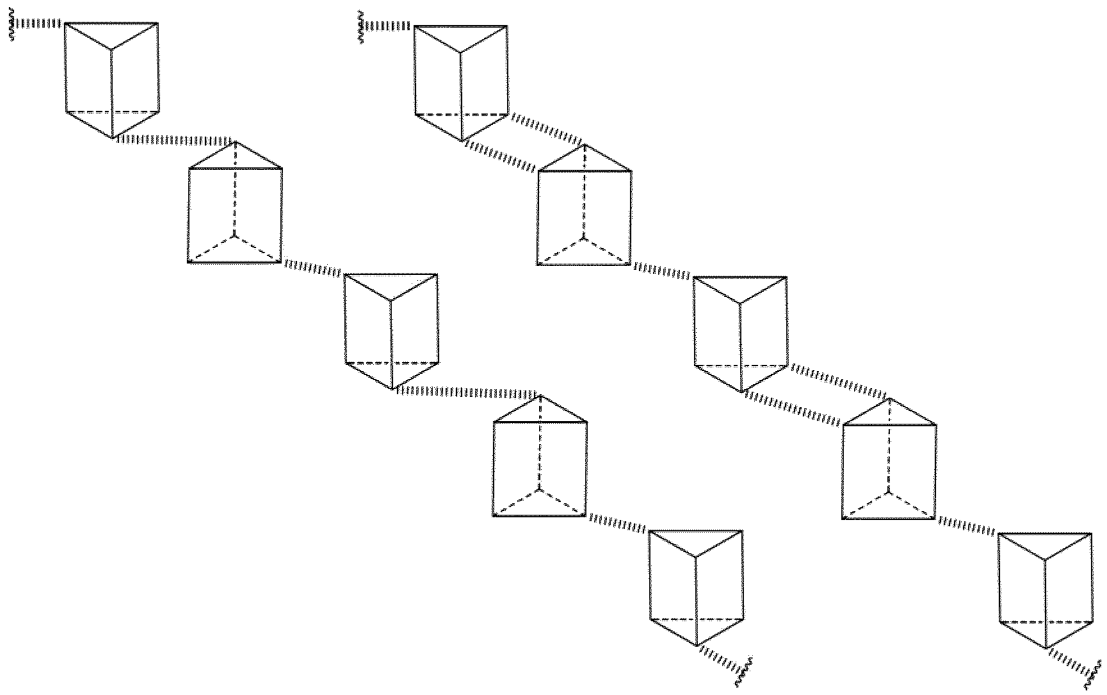

As used herein,
the bond between silanol compounds represented by

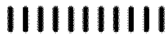

refers to omission of a bond including at least the following hydrogen bond:

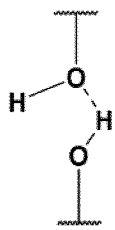

and in the following tables, the bond is omitted. This bond may include, in addition to the above hydrogen bond, hydrogen bonds by an interaction with a hydroxy group of yet another silanol compound and/or an interaction with a substance such as an organic compound, a transition metal complex, an inorganic substance, and an elemental substance.

However, in the above structures A and B, the bond refers to a single hydrogen bond.

In addition, in the tables, face 1 refers to an alignment structure when the alignment structure viewed in a perspective direction is viewed in direction 1 (on the paper, from the top) in Figure 1, and face 2 refers to an alignment structure when the alignment structure viewed in a perspective direction is viewed in direction 2 (on the paper, from the front) in Figure 1.

[Table 1]

Table 1-1

| Form name | | Alignment |
|---|---|---|
| 1 | Perspective | 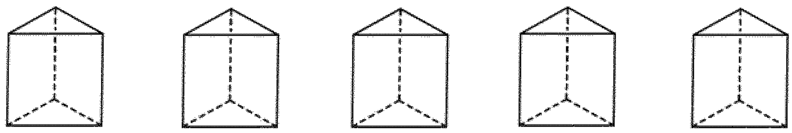 |
| | Face 1 | 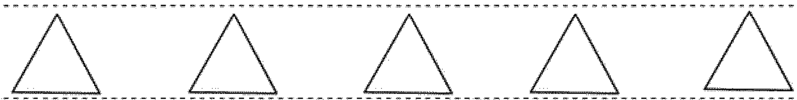 |
| | Face 2 | 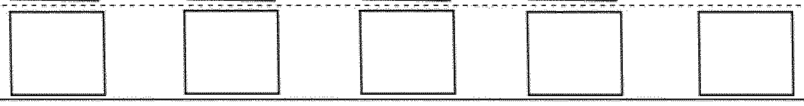 |
| 2 | Perspective | 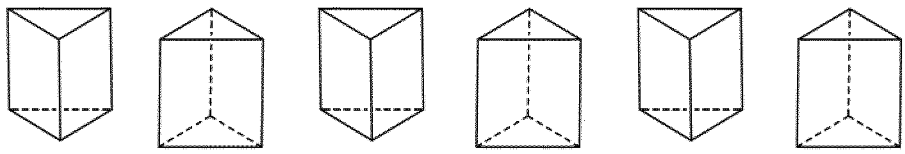 |
| | Face 1 | 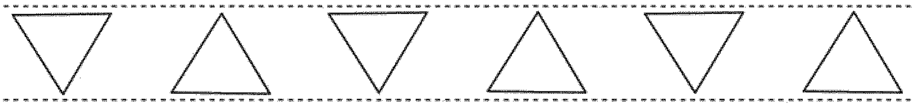 |
| | Face 2 | 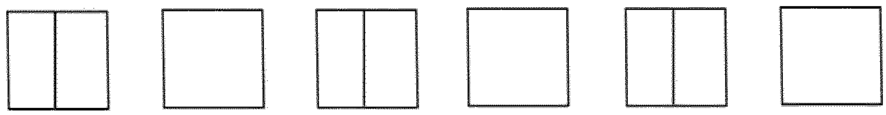 |
| 3 | Perspective | 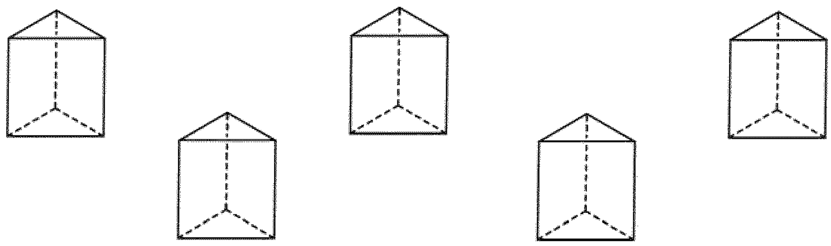 |
| | Face 1 | 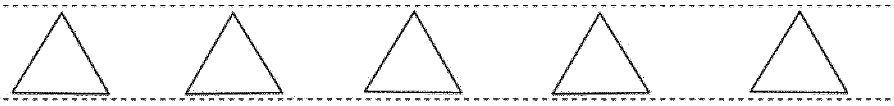 |
| | Face 2 | 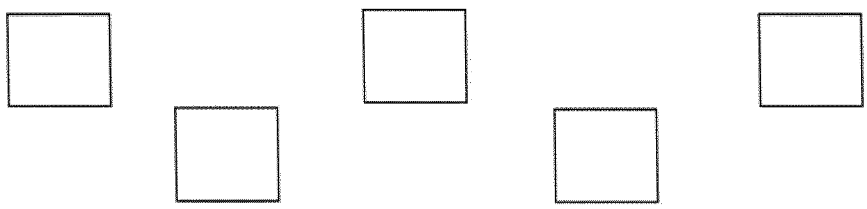 |

[Table 2]

Continued from Table 1-1

| | | |
|---|---|---|
| 4 | Perspective | 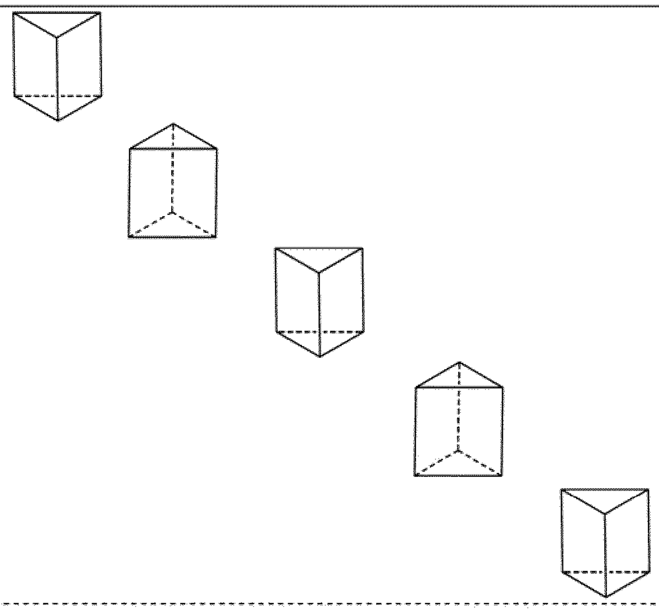 |
| | Face 1 | 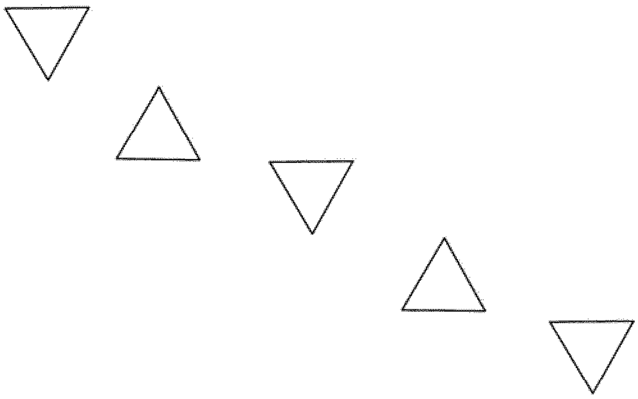 |
| | Face 2 | 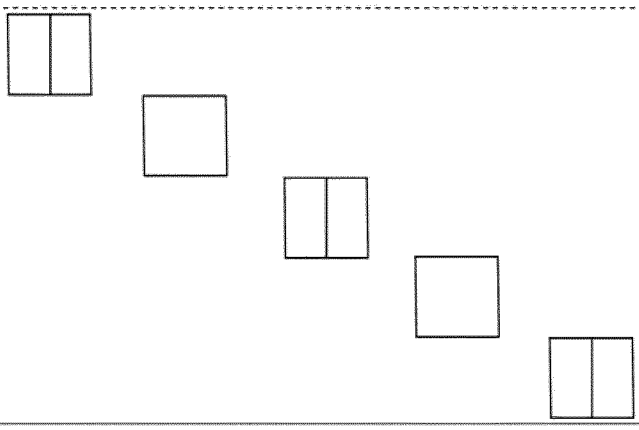 |

[Table 3]

Table 1-2

| Form | Perspective | Face 1 | Face 2 |
|---|---|---|---|
| 5 | 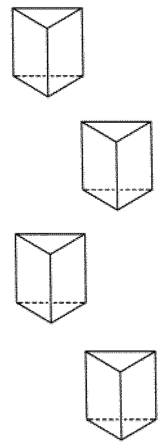 | 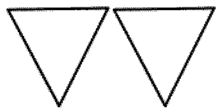 | 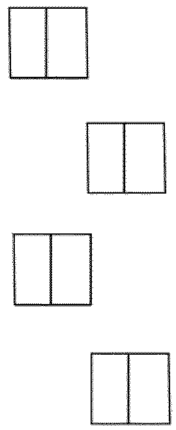 |
| 6 | 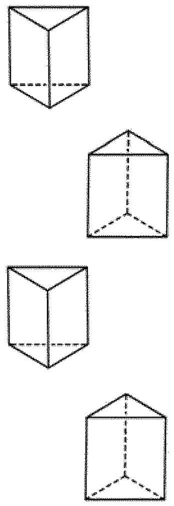 | 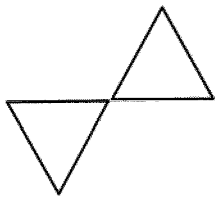 | 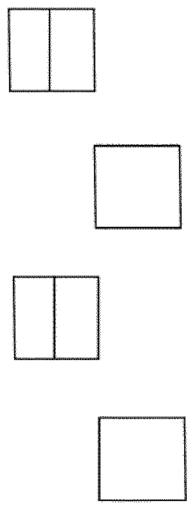 |

[Table 4]

Continued from Table 1-2

| | | | |
|---|---|---|---|
| | 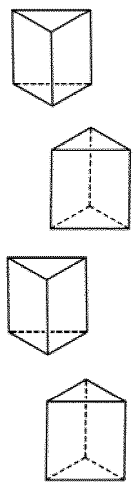 | 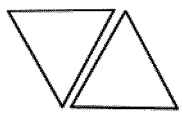 | 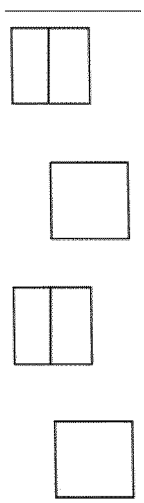 |

(continued)

| | | | |
|---|---|---|---|
| 8 | 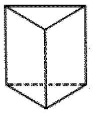 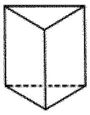 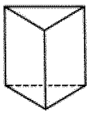 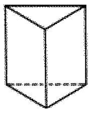 | 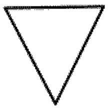 | 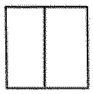 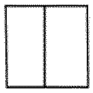 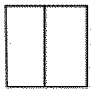 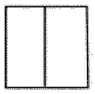 |

[Table 5]

Table 2

| Form | Alignment form | |
|---|---|---|
| 9 | Perspective | 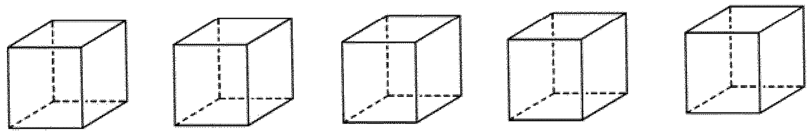 |
| | Face 1 | 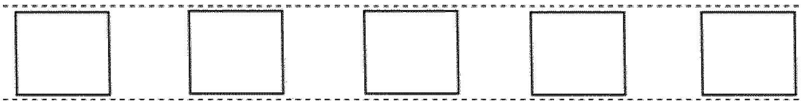 |
| | Face 2 | 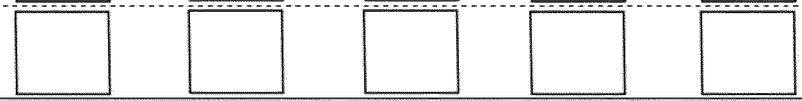 |
| 10 | Perspective | 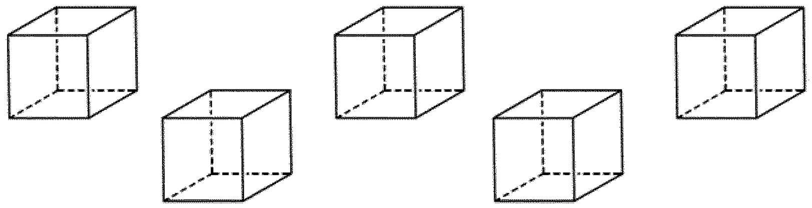 |
| | Face 1 | 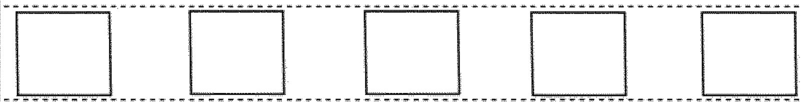 |
| | Face 2 | 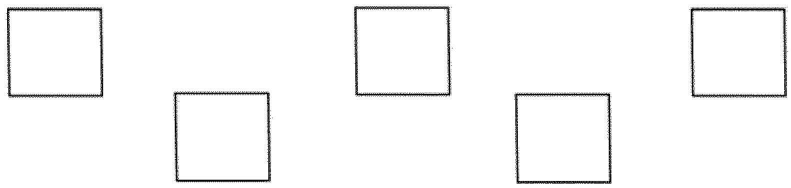 |
| 11 | Perspective | 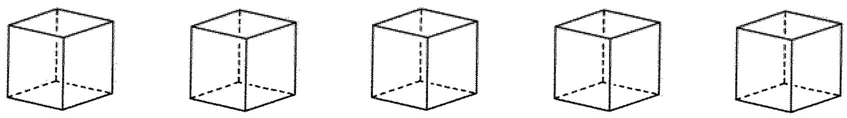 |
| | Face 1 | 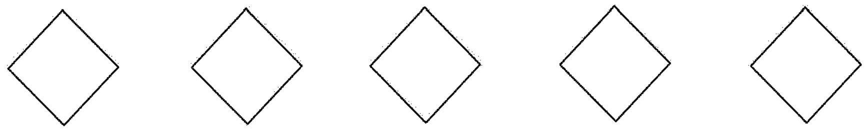 |
| | Face 2 | 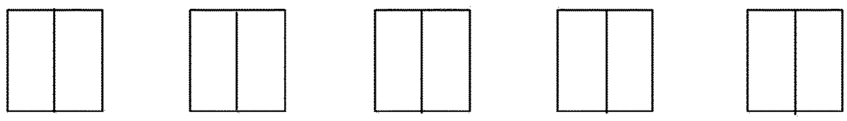 |

[Table 6]

Continued from Table 2

| | | |
|---|---|---|
| 12 | Perspective | 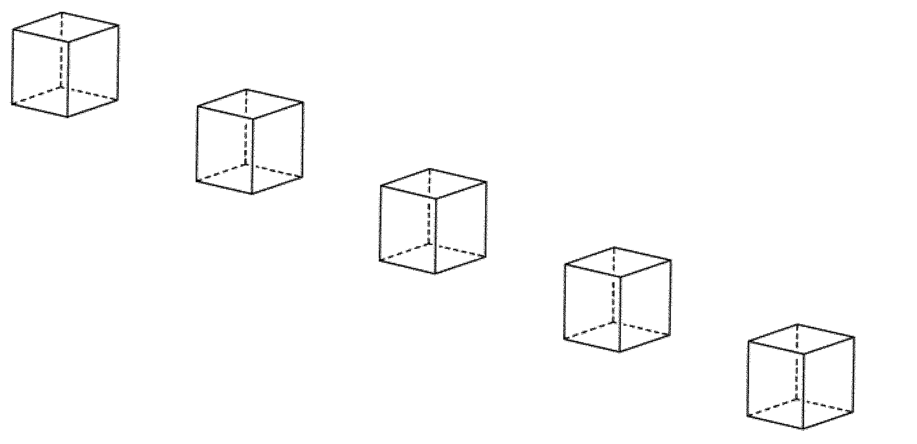 |
| | Face 1 | 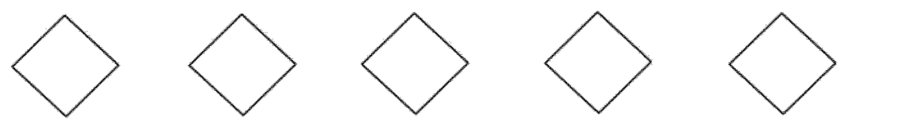 |
| | Face 2 | 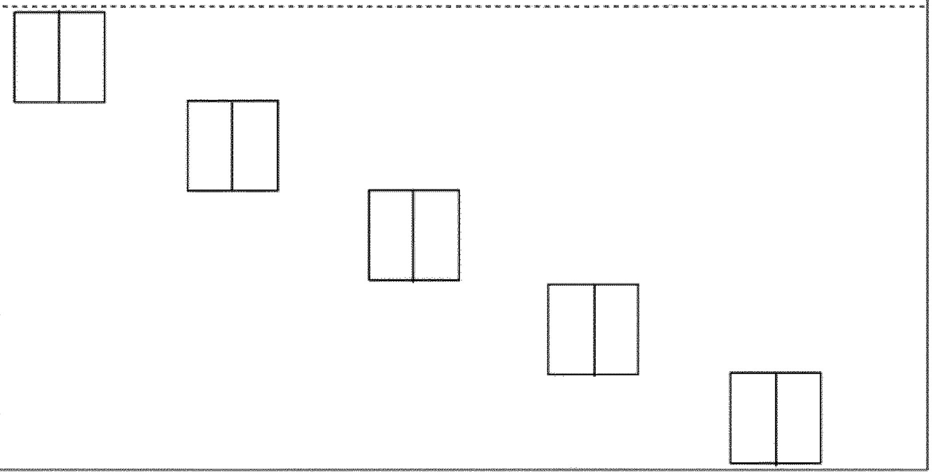 |

[Table 7]

Table 3-1

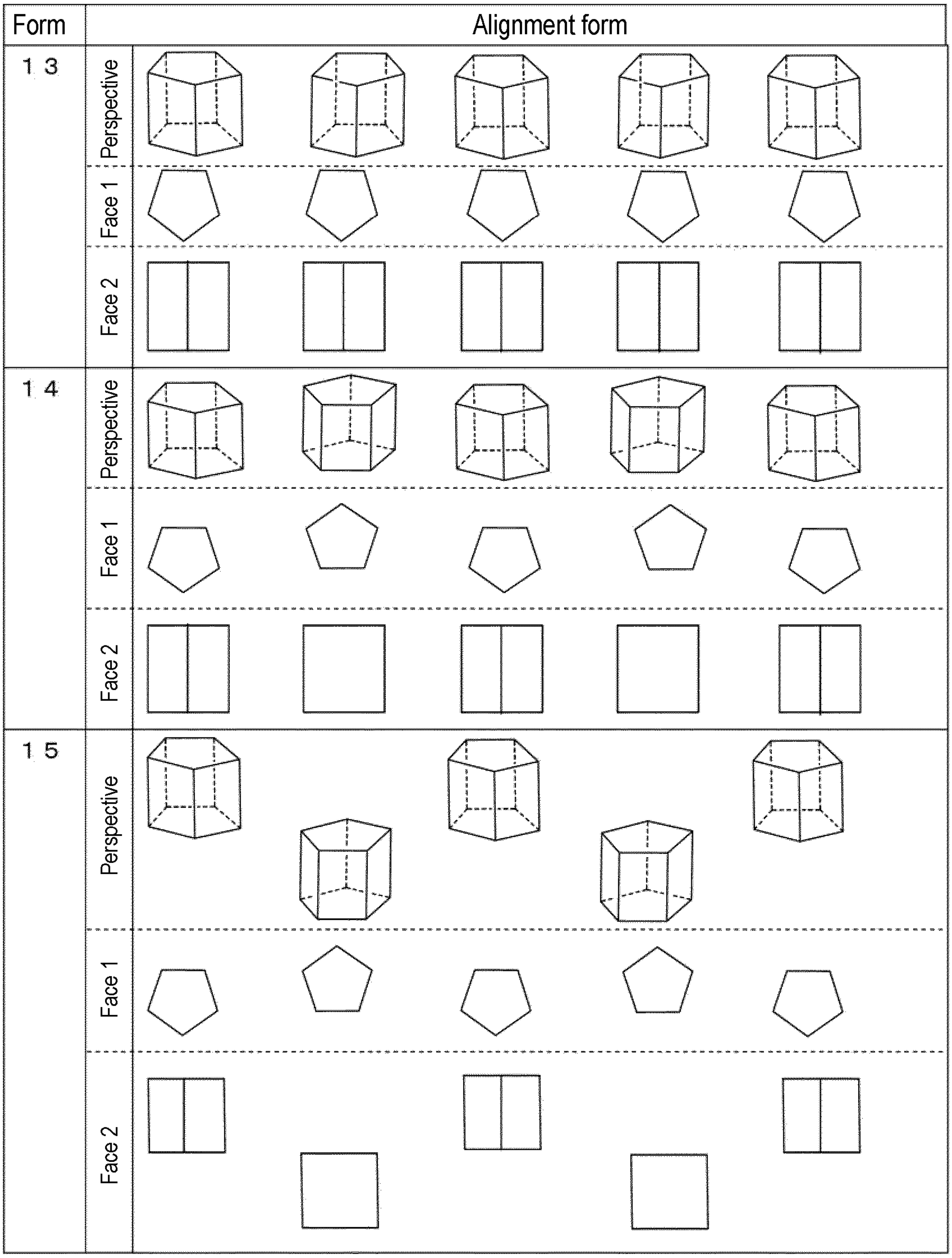


[Table 8]

Continued from Table 3-1

| | | |
|---|---|---|
| 16 | Perspective | 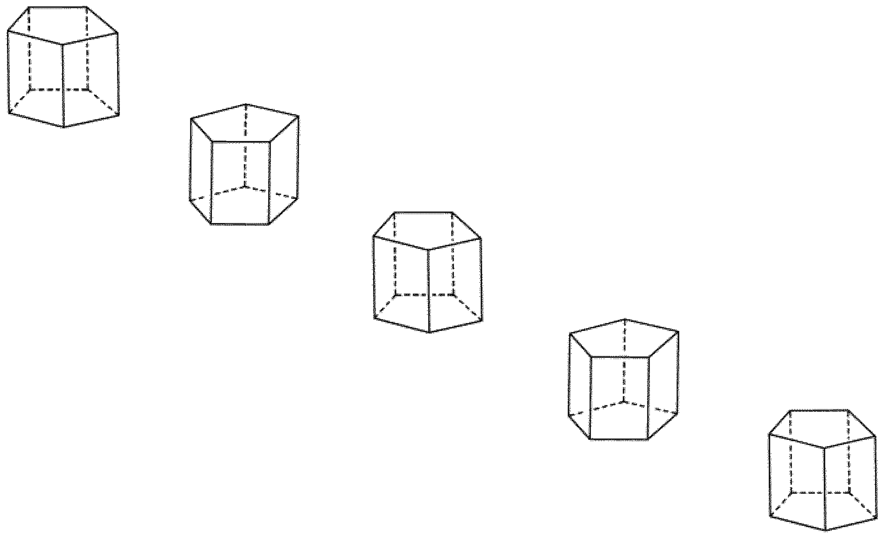 |
| | Face 1 | 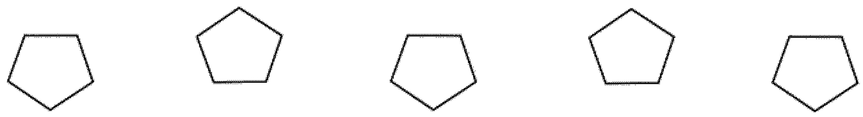 |
| | Face 2 | 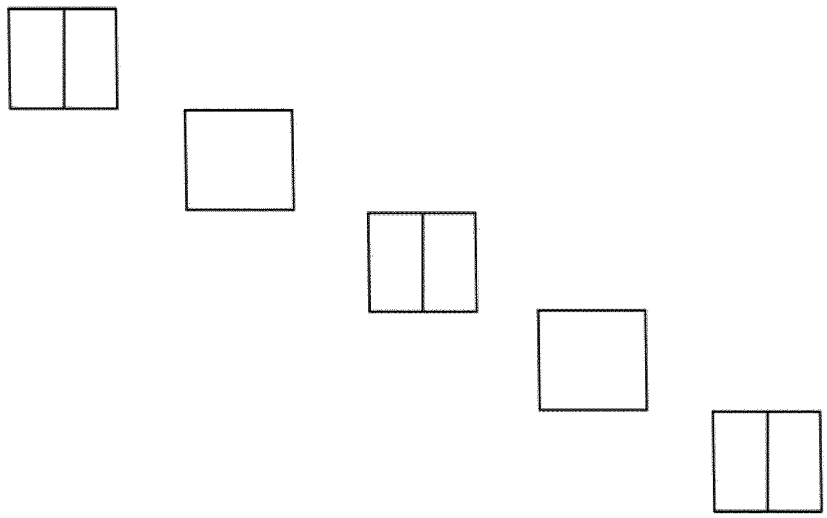 |

[Table 9]

Table 3-2

| Form | Perspective | Face 1 | Face 2 |
|---|---|---|---|
| 17 | Change in width X is allowed depending on the mode of hydrogen bond formation, as in 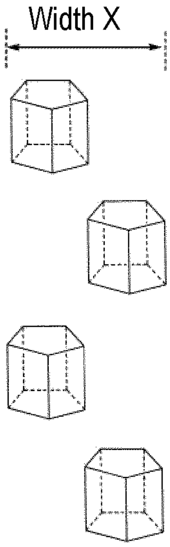  . | Overlapping of cyclopentasiloxane skeletons is allowed depending on the mode of hydrogen bond formation, as in 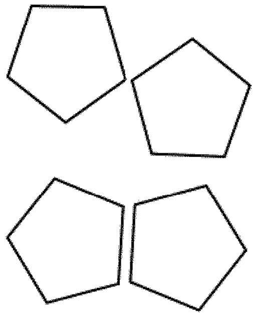 , , and the like. | Change in width X is allowed depending on the mode of hydrogen bond formation, as in 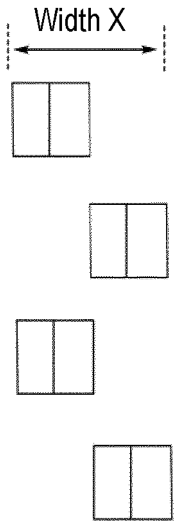  . |
| 18 | 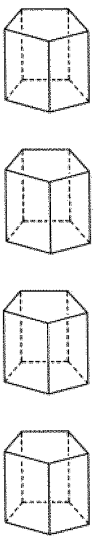 | 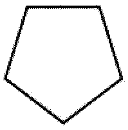 | 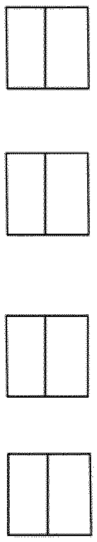 |

As described above, the crystal of the present invention may contain an assemblage in which silanol compounds are aligned to form a ring. At this time, the number of silanol compounds in forming a cyclic assemblage is arbitrary, and in the hexamer and decamer silanol compounds, for example, 6 assemblages (form 19) and 10 assemblages (form 20), respectively, can each form a ring. In addition, the crystal of the present invention may have a stacked structure in which one-dimensional structures of cyclic assemblages, such as form 19 and form 20, are stacked on top of each other via face 1.

[Table 10]

Table 4

| Form | Perspective | Face 1 |
|---|---|---|
| 19 | 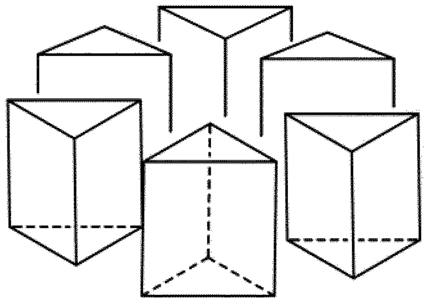 | 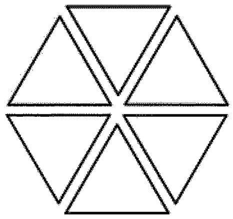 |
| 20 | 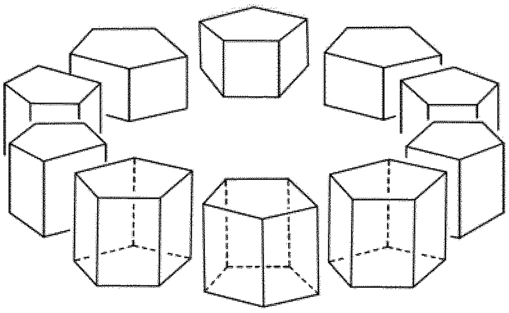 | 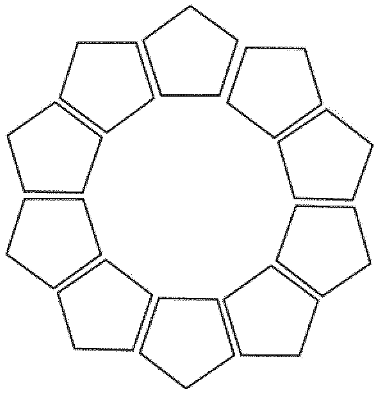 |

Hereinafter, the mode of the hydrogen bond will be described by taking the alignment forms shown in the above table as an example.

Examples of the mode of a hydrogen bond for forming the above linearly aligned one-dimensional structure include a mode in which the one-dimensional structure is formed by interactions by hydrogen bonds between two hydroxy groups contained in one silanol compound and hydroxy groups of different silanol compounds, respectively, and the two hydroxy groups forming a hydrogen bond may be two hydroxy groups on adjacent silicon atoms in one silanol compound, or may be two hydroxy groups on silicon atoms separated by one or more siloxane bonds (-O-Si-O- bonds). Here, the "adjacent silicon atom" means a silicon atom located with respect to a certain silicon atom with one oxygen atom sandwiched therebetween, and the "silicon atom separated by one or more siloxane bonds" means a silicon atom located with respect to a certain silicon atom with two or more oxygen atoms and one or more silicon atoms sandwiched therebetween. In other words, the "adjacent silicon atom" means a silicon atom located with respect to a certain silicon atom with a structure represented by the following formula (a) in which n is 0 sandwiched therebetween, and the "silicon atom separated by one or more siloxane bonds" means a silicon atom located with respect to a certain silicon atom with a structure represented by the following formula (a) in which n is an integer of 1 or more sandwiched therebetween.

$$O\text{-}(Si\text{-}O)_n \qquad (a)$$

wherein n represents an integer of 1 or more.

When the assemblage is formed by hydrogen bonds of two hydroxy groups on adjacent silicon atoms, preferable examples of the one-dimensional structure include the alignments of forms 1, 2, and 3 in the above Table 1-1, forms 5 and 6 in the above Table 1-2, forms 9 and 10 in the above Table 2, and form 14 in Table 3-1.

The bond modes of the hydrogen bond of the alignment of form 1 in the above Table 1-1, form 9 in the above Table 2, and form 14 in Table 3-1 are represented, for example, by the following i-1, i-2, and i-3, respectively.

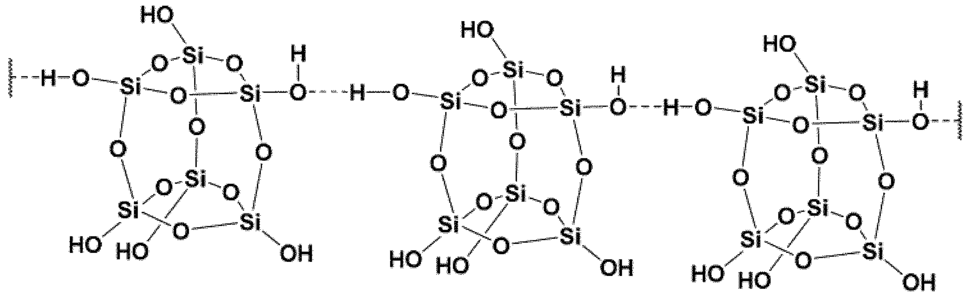

i-1

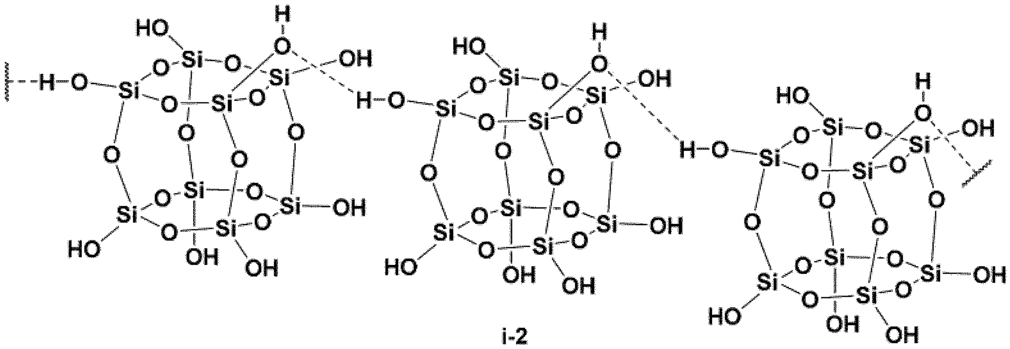

i-2

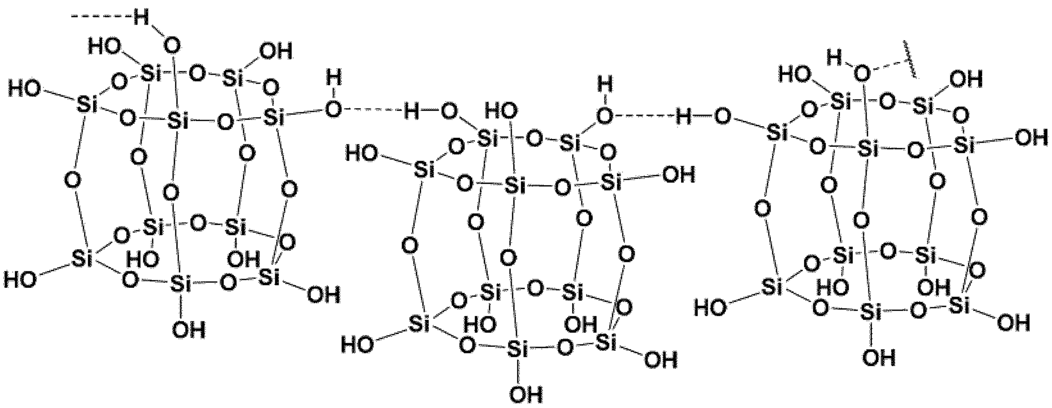

i-3

wherein a dashed line means a hydrogen bond.

In addition thereto, examples of a one-dimensional structure when the above assemblage is formed by a hydrogen bond between two hydroxy groups on adjacent silicon atoms include, as shown in forms 5 and 6, a one-dimensional structure formed by causing a hydroxy group on an upper silicon atom of a certain hexamer to form a hydrogen bond with a hydroxy group on a lower silicon atom of another hexamer, causing a hydroxy group on a lower silicon atom adjacent to the upper silicon atom of the certain hexamer to form a hydrogen bond with a hydroxy group on an upper silicon atom of yet another hexamer, and repeating these (see the following structure). The upper-and-lower positional relationship shall be based on the positional relationship on the paper shown in the structural formula (the same applies hereinafter).

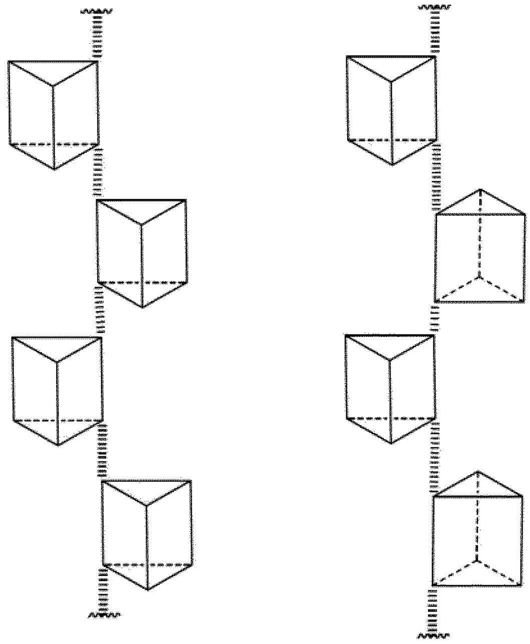

Similarly, examples of a one-dimensional structure when the above assemblage is formed by a hydrogen bond between two hydroxy groups on adjacent silicon atoms include, as shown in form 10, a one-dimensional structure formed by causing a hydroxy group on an upper silicon atom of a certain octamer to form a hydrogen bond with a hydroxy group on a lower silicon atom of another octamer, causing a hydroxy group on an upper silicon atom adjacent to the upper silicon atom of the certain octamer to form a hydrogen bond with a hydroxy group on a lower silicon atom of yet another octamer, and repeating these (see the following structure).

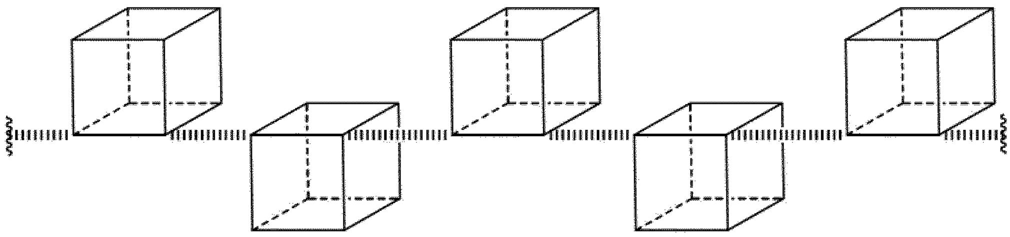

Further similarly, examples of a one-dimensional structure when the above assemblage is formed by a hydrogen bond between two hydroxy groups on adjacent silicon atoms include, as shown in form 17, a one-dimensional structure formed by causing a hydroxy group on an upper silicon atom of a certain decamer to form a hydrogen bond with a hydroxy group on a lower silicon atom of another decamer, causing a hydroxy group on a lower silicon atom adjacent to the upper silicon atom of the certain decamer to form a hydrogen bond with a hydroxy group on an upper silicon atom of yet another decamer, and repeating these (see the following structure).

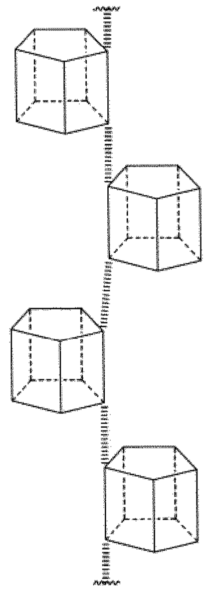

Examples of a one-dimensional structure when the above assemblage is formed by hydrogen bonds between two hydroxy groups on silicon atoms separated by one or more siloxane bonds include form 4 in the above Table 1-1, form 12 in the above Table 2, and form 16 in Table 3-1. The bond modes of the hydrogen bond of form 4 in the above Table 1-1, form 12 in the above Table 2, and form 16 in Table 3-1 are represented, for example, by the following ii-1, ii-2, and ii-3, respectively.

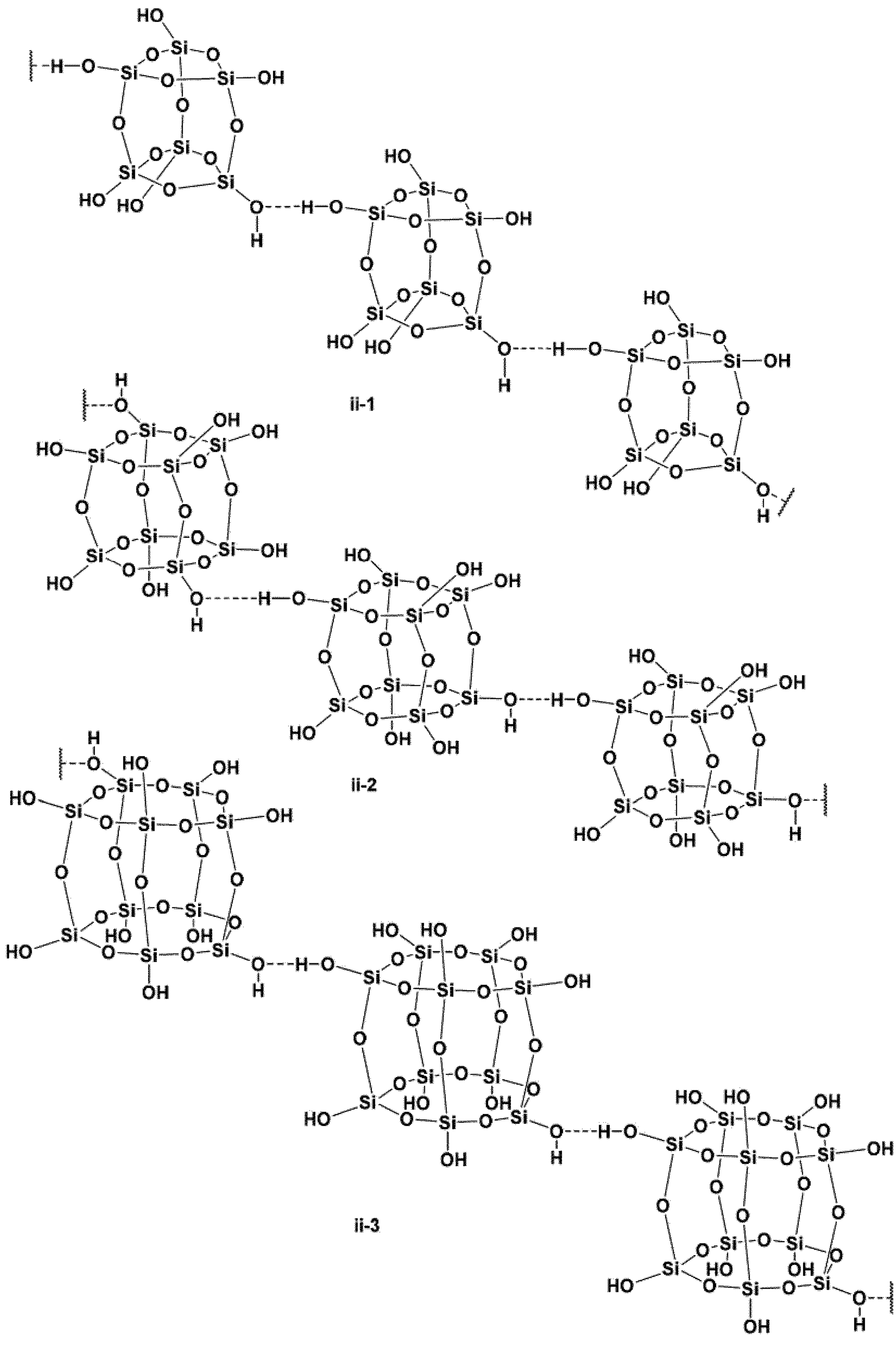

ii-1

ii-2

ii-3

wherein a dashed line means a hydrogen bond.

In addition thereto, examples of a one-dimensional structure when the above assemblage is formed by a hydrogen bond between two hydroxy groups on silicon atoms separated by one or more siloxane bonds include, as shown in form 11, a one-dimensional structure formed by causing a hydroxy group on an upper silicon atom of a certain octamer to form a hydrogen bond with a hydroxy group on an upper silicon atom of another octamer, causing a hydroxy group on an upper silicon atom separated by one siloxane bond (located with the structure represented by the above

formula (a) in which n is 1 sandwiched) from the upper silicon atom of the certain octamer to form a hydrogen bond with a hydroxy group on an upper silicon atom of yet another octamer, and repeating these (see the following structure).

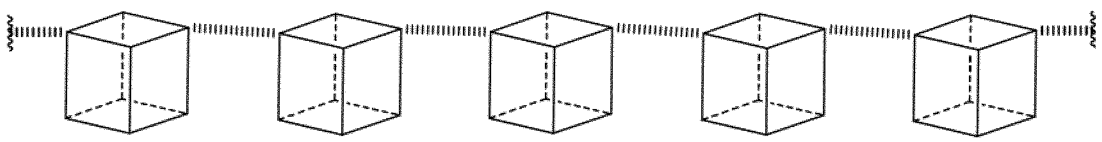

Further similarly, examples of a one-dimensional structure when the above assemblage is formed by a hydrogen bond between two hydroxy groups on silicon atoms separated by one or more siloxane bonds include, as shown in form 13, a one-dimensional structure formed by causing a hydroxy group on an upper silicon atom of a certain decamer to form a hydrogen bond with a hydroxy group on an upper silicon atom of another decamer, causing a hydroxy group on an upper silicon atom separated by one siloxane bond (located with the structure represented by the above formula (a) in which n is 1 sandwiched) from the upper silicon atom of the certain decamer to form a hydrogen bond with a hydroxy group on an upper silicon atom of yet another decamer, and repeating these (see the following structure).

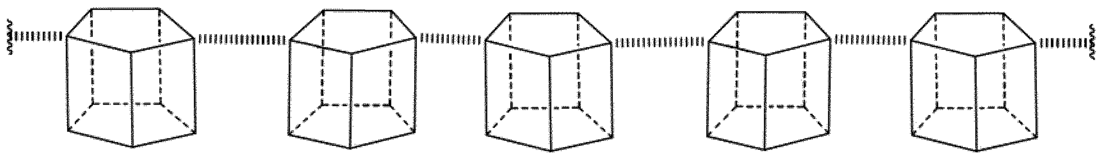

Further similarly, examples of a one-dimensional structure when the above assemblage is formed by a hydrogen bond between two hydroxy groups on silicon atoms separated by one or more siloxane bonds include, as shown in form 15, a one-dimensional structure formed by causing a hydroxy group on an upper silicon atom of a certain decamer to form a hydrogen bond with a hydroxy group on a lower silicon atom of another decamer, causing a hydroxy group on a lower silicon atom separated by one or two siloxane bonds (located with the structure represented by the above formula (a) in which n is 1 or 2 sandwiched) from the upper silicon atom of the certain decamer to form a hydrogen bond with a hydroxy group on an upper silicon atom of yet another decamer, and repeating these (see the following structure).

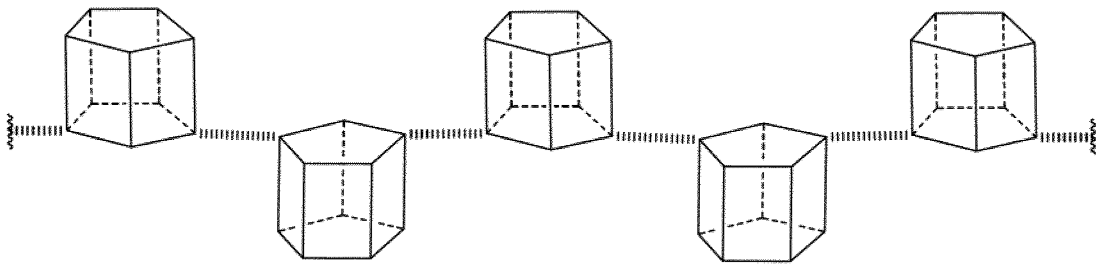

Examples of the linearly aligned one-dimensional structure also include an assemblage which is formed by interactions by hydrogen bonds between four hydroxy groups contained in one silanol compound and hydroxy groups of another silanol compound.

Specific examples of the one-dimensional structure include a structure in which two hydroxy groups, bonded to adjacent silicon, of four hydroxy groups contained in one silanol compound are hydrogen-bonded to two hydroxy groups, respectively, bonded to adjacent silicon atoms of another silanol compound, the remaining two hydroxy groups contained in the one silanol compound, which are bonded to the adjacent silicon atoms, are hydrogen-bonded to two hydroxy groups, respectively, which are bonded to adjacent silicon atoms, of yet another silanol compound, and include forms 1 and 2 in the above Table 1-1, form 7 in the above Table 1-2, forms 9, 10, and 11 in the above Table 2, and forms 13, 14, 15, and 16 in Table 3-1. The bond modes of the hydrogen bond of form 1 in the above Table 1-1, form 11 in the above Table 2, and form 14 in Table 3-1 are represented, for example, by the following iii-1, iii-2, and iii-3, respectively, but are not limited thereto.

The structures represented by iii-1, iii-2, and iii-3 are also referred to as ladder-shaped.

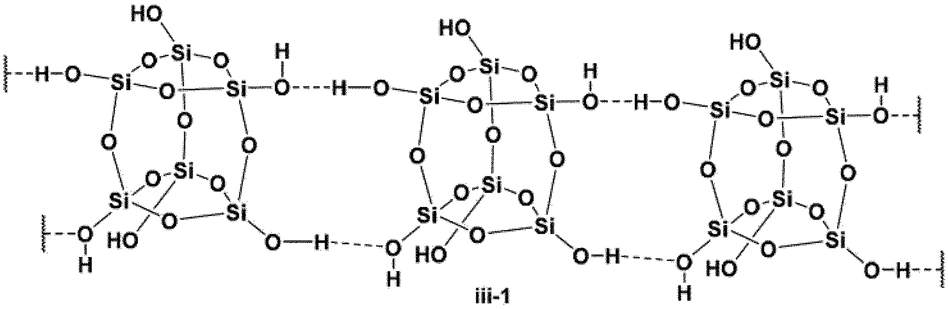

iii-1

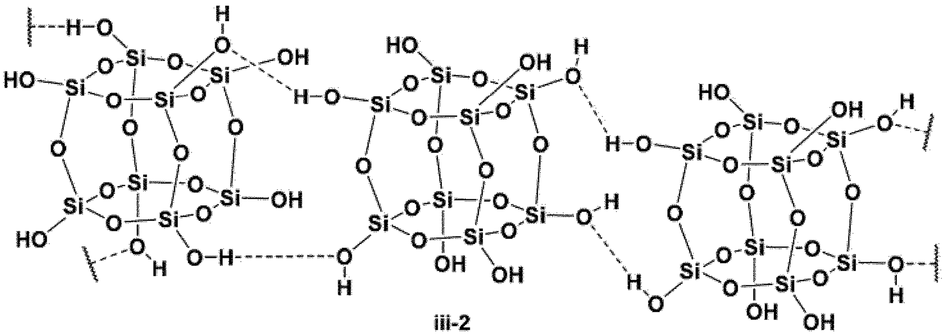

iii-2

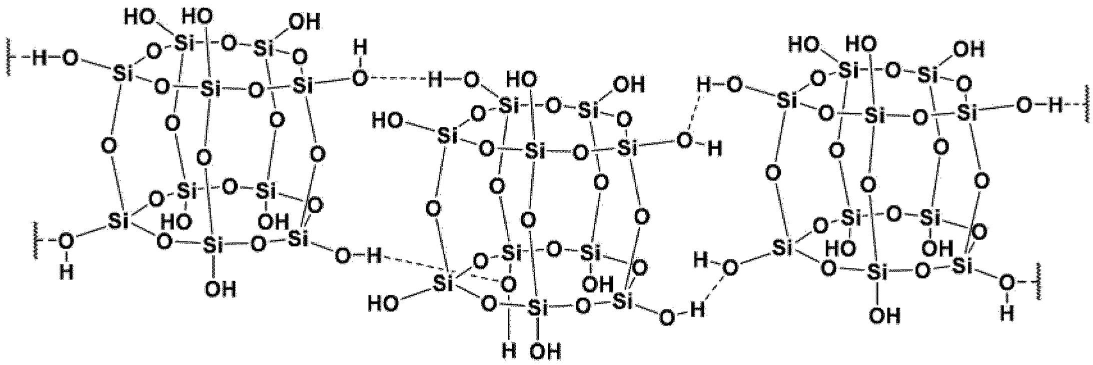

iii-3

wherein a dashed line means a hydrogen bond.

Examples of the one-dimensional structure include structures in which faces of cyclic silanol are aligned in such a way as to overlap each other, as shown in forms 8, 9, and 18.

Specific examples of the one-dimensional structure include a structure in which a face of cyclic silanol contained in one silanol compound and a face of cyclic silanol of another silanol compound interact with each other via a hydrogen bond (hereinafter, also referred to as a rod-shaped structure), and such structures are represented, for example, by the following iv-1, iv-2, and iv-3, but are not limited thereto. The face of the cyclic silanol is preferably a face of a 6-membered ring when the silanol compound is a hexamer represented by formula (1), preferably a face of an 8-membered ring when the silanol compound is an octamer represented by formula (2), and preferably a face of a 10-membered ring when the silanol compound is a decamer represented by formula (3).

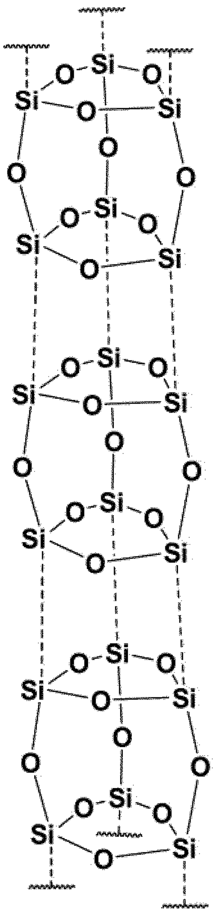

iv-1

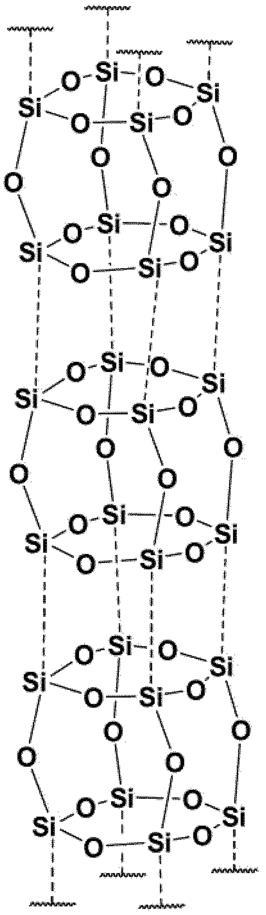

iv-2

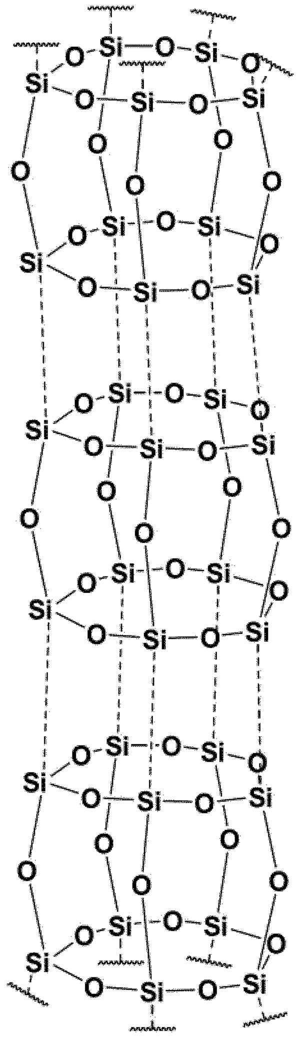

iv-3

wherein a dashed line refers to omission of a bond including the following structure including a hydrogen bond:

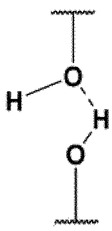

iv-1, iv-2, and iv-3 are aligned in such a way that the faces overlap each other, to be rod-shaped. In the above iv-1, iv-2, and iv-3, faces may be aligned in such a way that the faces overlap each other, to form a hydrogen bond network, and it is not necessary for all hydroxy groups to form hydrogen bonds.

Examples of the rod-shaped structure also include a structure in which in the alignment of hexamer and decamer silanol compounds, faces of the cyclotetrasiloxane skeletons of the hexamer and decamer interact with each other via hydrogen bonds. Specific examples thereof include the alignment forms shown in form 2 and form 14. In the alignment forms shown in form 2 and form 14, faces may be aligned in such a way that the faces overlap each other, to form a hydrogen bond network, and it is not necessary for all hydroxy groups to form hydrogen bonds.

Examples of the one-dimensional structures including the above one-dimensional structure are shown in Table 5. However, the one-dimensional structures are not limited thereto. For example, in the following Table 5, the number of hydrogen bonds in one molecule is an even number, but the number of hydrogen bonds in one molecule may be an

odd number. For example, as illustrated above, the number of hydrogen bonds in one molecule is an odd number when forming one hydrogen bond with another silanol compound, forming two hydrogen bonds with yet another silanol compound, and the like.

[Table 11]

Table 5

| Crystal No. | Silanol compound | Number of hydrogen bonds per molecule | Position and number of hydrogen bonds in one molecule (position× number) | n in formula (a) (positional relationship of silicon atoms to which a hydroxy group forming a hydrogen bond in one molecule is bonded positional relationship between the same ones) | Positional relationship of hydrogen bonds formed between silanol compounds | Schematic structure form |
|---|---|---|---|---|---|---|
| i-1 | hexamer-hexamer-hexamer | 2 | upper ×2 | n=0 | Upper one forms hydrogen bond with upper one of another silanol compound, another upper one forms hydrogen bond with upper one of yet another silanol compound | Form 1 |
| | hexamer-hexamer-hexamer | 2 | upper×1, lower×1 | n=0 | Upper one forms hydrogen bond with lower one of another silanol compound, lower one forms hydrogen bond with upper one of yet another silanol compound | Form 7 |
| ii-1 | hexamer-hexamer-hexamer | 2 | upper×1, lower×1 | n=1 | Upper one forms hydrogen bond with lower one of another silanol compound, lower one forms hydrogen bond with upper one of yet another silanol compound | Form 4 |
| i-2 | octamer-octamer-octamer | 2 | upper×2 | n=0 | Upper one forms hydrogen bond with upper one of another silanol compound, another upper one forms hydrogen bond with upper one of yet another silanol compound | Form 9 |

(continued)

| Crystal No. | Silanol compound | Number of hydrogen bonds per molecule | Position and number of hydrogen bonds in one molecule (position× number) | n in formula (a) (positional relationship of silicon atoms to which a hydroxy group forming a hydrogen bond in one molecule is bonded positional relationship between the same ones) | Positional relationship of hydrogen bonds formed between silanol compounds | Schematic structure form |
|---|---|---|---|---|---|---|
| | octamer-octamer-octamer | 2 | upper×2 | n=1 | Upper one forms hydrogen bond with upper one of another silanol compound, another upper one forms hydrogen bond with upper one of yet another silanol compound | Form 11 |
| ii-2 | octamer-octamer-octamer | 2 | upper×1, lower×1 | n=2 | Upper one forms hydrogen bond with lower one of another silanol compound, lower one forms hydrogen bond with upper one of yet another silanol compound | Form 12 |
| i-3 | decamer-decamer-decamer | 2 | upper×2 | n=0 | Upper one forms hydrogen bond with upper one of another silanol compound, another upper one forms hydrogen bond with upper one of yet another silanol compound | Form 14 |
| | decamer-decamer-decamer | 2 | upper×2 | n=1 | Upper one forms hydrogen bond with upper one of another silanol compound, another upper one forms hydrogen bond with upper one of yet another silanol compound | Form 13, Form 14 |
| | decamer-decamer-decamer | 2 | upper×1, lower×1 | n=0 | Upper one forms hydrogen bond with lower one of another silanol compound, lower one forms hydrogen bond with upper one of yet another silanol compound | Form 17 |

(continued)

| Crystal No. | Silanol compound | Number of hydrogen bonds per molecule | Position and number of hydrogen bonds in one molecule (position × number) | n in formula (a) (positional relationship of silicon atoms to which a hydroxy group forming a hydrogen bond in one molecule is bonded positional relationship between the same ones) | Positional relationship of hydrogen bonds formed between silanol compounds | Schematic structure form |
|---|---|---|---|---|---|---|
| | decamer-decamer-decamer | 2 | upper×1, lower×1 | n=1 | Upper one forms hydrogen bond with lower one of another silanol compound, lower one forms hydrogen bond with upper one of yet another silanol compound | Form 17 |
| ii-3 | decamer-decamer-decamer | 2 | upper×1, lower×1 | n=2 | Upper one forms hydrogen bond with lower one of another silanol compound, lower one forms hydrogen bond with upper one of yet another silanol compound | Form 16 |
| iii-1 | hexamer-hexamer-hexamer | 4 | upper×2, lower×2 | for upper ones and lower ones, n = 0, for both upper one and lower one, n = 0 | Upper one and lower one form hydrogen bond with upper one and lower one of another silanol compound, another upper one and another lower one forms hydrogen bond with upper one and lower one of yet another silanol compound | Form 1, Form 2 |
| | hexamer-hexamer-hexamer | 4 | upper×2, lower×2 | for upper ones and lower ones, n = 0, for both upper one and lower one, n = 0 | Upper two form hydrogen bond with lower two of another silanol compound, lower two form hydrogen bond with upper two of yet another silanol compound | Form 6 |
| | hexamer-hexamer-hexamer | 4 | upper×2, lower×2 | for upper ones and lower ones, n = 0, for both upper one and lower one, n = 1 | Upper two form hydrogen bond with lower two of another silanol compound, lower two form hydrogen bond with upper two of yet another silanol compound | Form 4 |

[Table 12]

Continued from Table 5

| | | | | | | |
|---|---|---|---|---|---|---|
| | octamer-octamer-octamer | 4 | upper×2, lower×2 | for upper ones and lower ones, n = 0, for both upper one and lower one, n = 0 | Upper one and lower one form hydrogen bond with upper one and lower one of another silanol compound, another upper one and another lower one forms hydrogen bond with upper one and lower one of yet another silanol compound | Form 10 |
| iii-2 | octamer-octamer-octamer | 4 | upper×2, lower×2 | for upper ones and lower ones, n = 1, for both upper one and lower one, n = 0 | Upper one and lower one form hydrogen bond with upper one and lower one of another silanol compound, another upper one and another lower one forms hydrogen bond with upper one and lower one of yet another silanol compound | Form 11 |
| | octamer-octamer-octamer | 4 | upper×2, lower×2 | for upper ones and lower ones, n = 1, for both upper one and lower one, n = 0 | Upper two form hydrogen bond with lower two of another silanol compound, lower two form hydrogen bond with upper two of yet another silanol compound | Form 11 |
| | octamer-octamer-octamer | 4 | upper×2, lower×2 | for upper ones and lower ones, n = 0, for one of upper one and lower one, n = 0, for the other, n = 2 | Upper two form hydrogen bond with lower two of another silanol compound, lower two form hydrogen bond with upper two of yet another silanol compound | Form 10 |
| | decamer-decamer-decamer | 4 | upper×2, lower×2 | for upper ones and lower ones, n = 0, for both upper one and lower one, n = 0 | Upper one and lower one form hydrogen bond with upper one and lower one of another silanol compound, another upper one and another lower one forms hydrogen bond with upper one and lower one of yet another silanol compound | Form 13, Form 14 |
| | decamer-decamer-decamer | 4 | upper×2, lower×2 | for upper ones and lower ones, n = 0, for both upper one and lower one, n = 0 | Upper two form hydrogen bond with lower two of another silanol compound, lower two form hydrogen bond with upper two of yet another silanol compound | Form 17 |
| iii-3 | decamer-decamer-decamer | 4 | upper×2, lower×2 | for upper ones and lower ones, n = 1, for both upper one and lower one, n = 0 | Upper one and lower one form hydrogen bond with upper one and lower one of another silanol compound, another upper one and another lower one forms hydrogen bond with upper one and lower one of yet another silanol compound | Form 14 |
| | decamer-decamer-decamer | 4 | upper×2, lower×2 | for upper ones and lower ones, n = 1, for both upper one and lower one, n = 0 | Upper two form hydrogen bond with lower two of another silanol compound, lower two form hydrogen bond with upper two of yet another silanol compound | Form 17 |

(continued)

| | | | | | | |
|---|---|---|---|---|---|---|
| | decamer-decamer-decamer | 4 | upper×2, lower×2 | for upper ones and lower ones, n = 0, for one of upper one and lower one, n = 0, for the other, n = 1 | Upper two form hydrogen bond with lower two of another silanol compound, lower two form hydrogen bond with upper two of yet another silanol compound | Form 17 |
| | decamer-decamer-decamer | 4 | upper×2, lower×2 | for upper ones and lower ones, n = 0, for one of upper one and lower one, n = 1, for the other, n = 2 | Upper two form hydrogen bond with lower two of another silanol compound, lower two form hydrogen bond with upper two of yet another silanol compound | Form 16 |
| | decamer-decamer-decamer | 4 | upper×2, lower×2 | for upper ones and lower ones, n = 1, for one of upper one and lower one, n = 0, for the other, n = 1 | Upper two form hydrogen bond with lower two of another silanol compound, lower two form hydrogen bond with upper two of yet another silanol compound | Form 17, Form 18 |
| | decamer-decamer-decamer | 4 | upper×2, lower×2 | for upper ones and lower ones, n = 1, for both upper one and lower one, n =2 | Upper two form hydrogen bond with lower two of another silanol compound, lower two form hydrogen bond with upper two of yet another silanol compound | Form 16, Form 17 |
| | hexamer-hexamer-hexamer | 6 | upper×3, lower×3 | --- | Upper three form hydrogen bond with lower three of another silanol compound, lower three form hydrogen bond with upper three of yet another silanol compound | Form 8 |
| | octamer-octamer-octamer | 8 | upper×4, lowerx4 | --- | Upper four form hydrogen bond with lower four of another silanol compound, lower four form hydrogen bond with upper four of yet another silanol compound | Form 9 |
| | decamer-decamer-decamer | 10 | upper×5, lower×5 | --- | Upper five form hydrogen bond with lower five of another silanol compound, lower five form hydrogen bond with upper five of yet another silanol compound | Form 18 |

In the one-dimensional structure described above, the number of a hydrogen bond formed between each hydroxy group bonded to one silicon atom contained in one silanol compound and a hydroxy group of another silanol compound is 1. On the other hand, the number of hydrogen bonds that can be formed by the above hydroxy group may be 2 or more, and it is possible to form a hydrogen bond with a hydroxy group of yet another silanol compound. By forming a hydrogen bond with a hydroxy group of yet another silanol compound, the crystal has a two-dimensionally or three-dimensionally aligned structure.

That is, the crystal of the present invention may also be a crystal having a two-dimensional structure in which silanol compounds are planarly aligned by an interaction via a hydrogen bond, and a crystal having a three-dimensional structure in which silanol compounds are sterically aligned by an interaction via a hydrogen bond.

In the crystal having a two-dimensional structure according to the present invention, the bond form of the hydrogen bond is not particularly limited as long as the structure is a structure in which silanol compounds are planarly aligned. Here, the planarly aligned structure as used herein can also be referred to as a structure in which a plurality of silanol compounds are regularly aligned in two directions, the X-axis direction and the Y-axis direction.

Examples of the crystal having a two-dimensional structure according to the present invention include a structure in which the one-dimensional structure described above interacts with yet another one-dimensional structure via a hydrogen bond to be planarly aligned. In addition, the two-dimensional structure in the present invention also includes a structure in which ends of the planarly aligned structures interact with each other by a hydrogen bond to form a ring.

Preferable examples of the structure of the crystal having a two-dimensional structure include a structure

planarly formed by causing one side in the longitudinal direction in the one-dimensional structure of the above rod-shaped structure to interact with one side in the longitudinal direction in another one-dimensional structure via a hydrogen bond, and specifically, the structure is represented by the following v, but is not limited thereto.

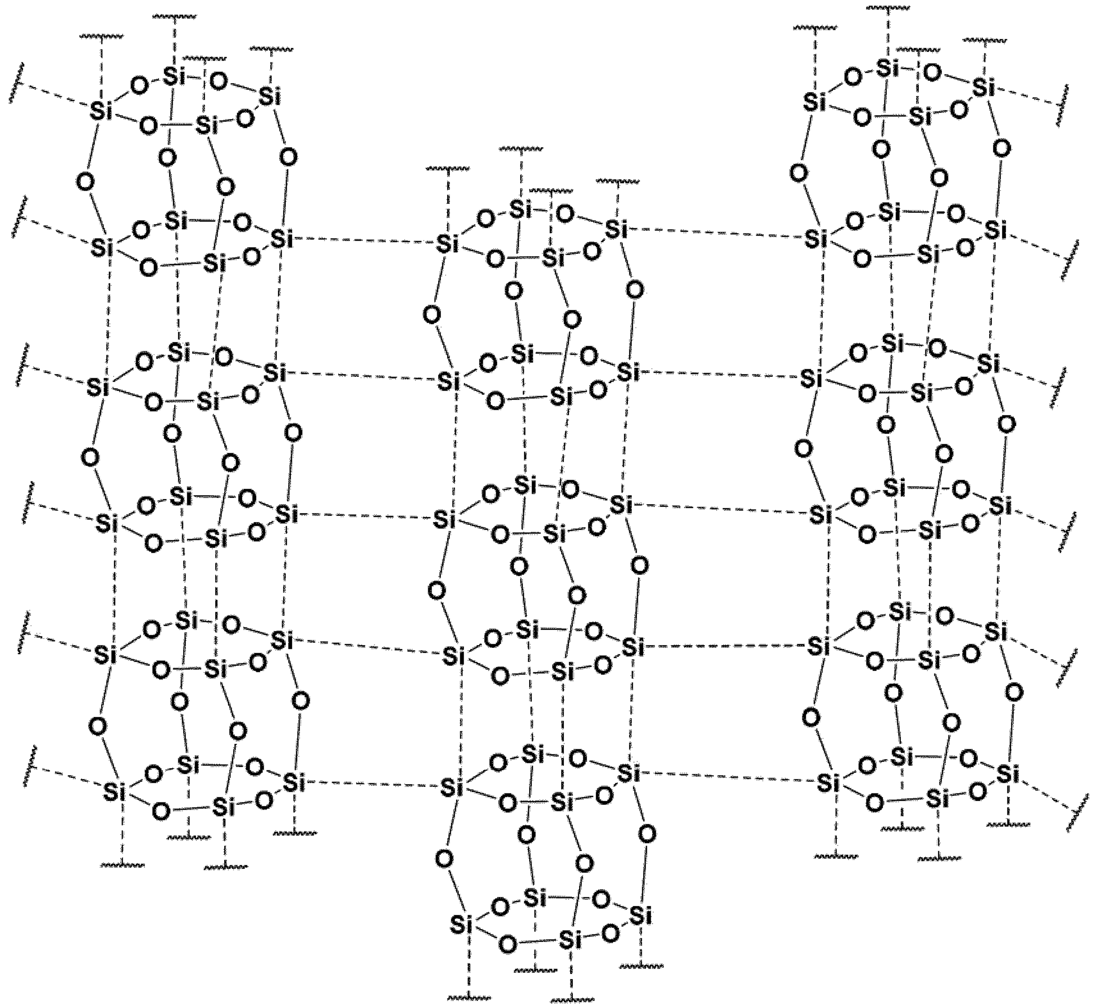

v

wherein a dashed line refers to omission of a bond including the following structure including a hydrogen bond:

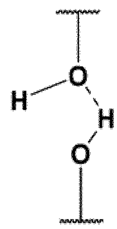

One of the two-dimensional structures, as represented by v, is planarly formed by causing one side in the longitudinal direction in a one-dimensional structure to interact with one side in the longitudinal direction in another one-dimensional structure via a hydrogen bond.

Here, the mode of the hydrogen bond between one-dimensional structures is, for example, schematically represented as follows. The following mode of the hydrogen bond is an example, and the network structure by hydrogen bonds (direction of hydrogen bonds) is not limited.

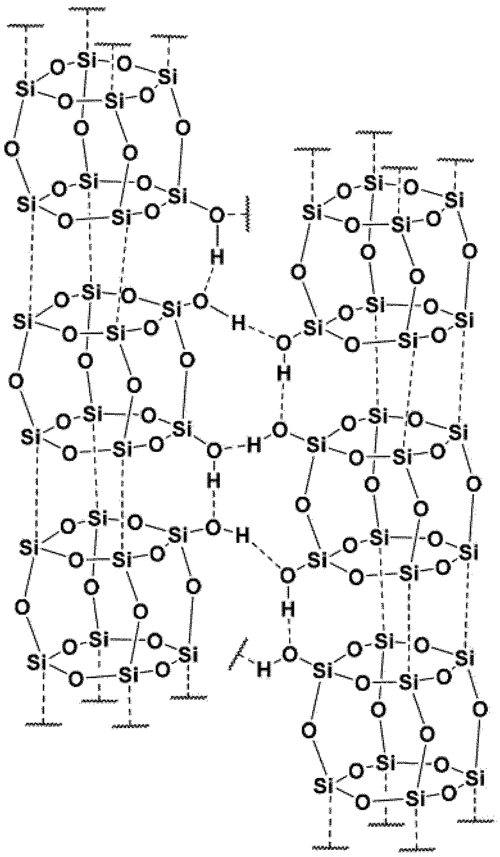

In the crystal having a three-dimensional structure according to the present invention, the bond form of the hydrogen bond is not particularly limited as long as the structure is a structure in which silanol compounds are sterically aligned. Here, the sterically aligned structure as used herein can also be referred to as a structure in which a plurality of silanol compounds are regularly aligned in three directions, the X-axis direction, the Y-axis direction, and Z-axis direction.

Examples of the crystal having a three-dimensional structure according to the present invention include a structure in which the three-dimensional structure described above interacts with yet another plurality of one-dimensional structures via a hydrogen bond to be sterically aligned. In addition, preferable examples of the structure of the crystal having a three-dimensional structure include a structure sterically formed by causing two adjacent sides in the longitudinal direction in the one-dimensional structure of the above rod-shaped structure to interact with one side in the longitudinal direction in a different one-dimensional structure via a hydrogen bond, and specifically, the structure is represented by the following vi (hereinafter, also referred to as nanohoneycomb-shaped), but is not limited thereto.

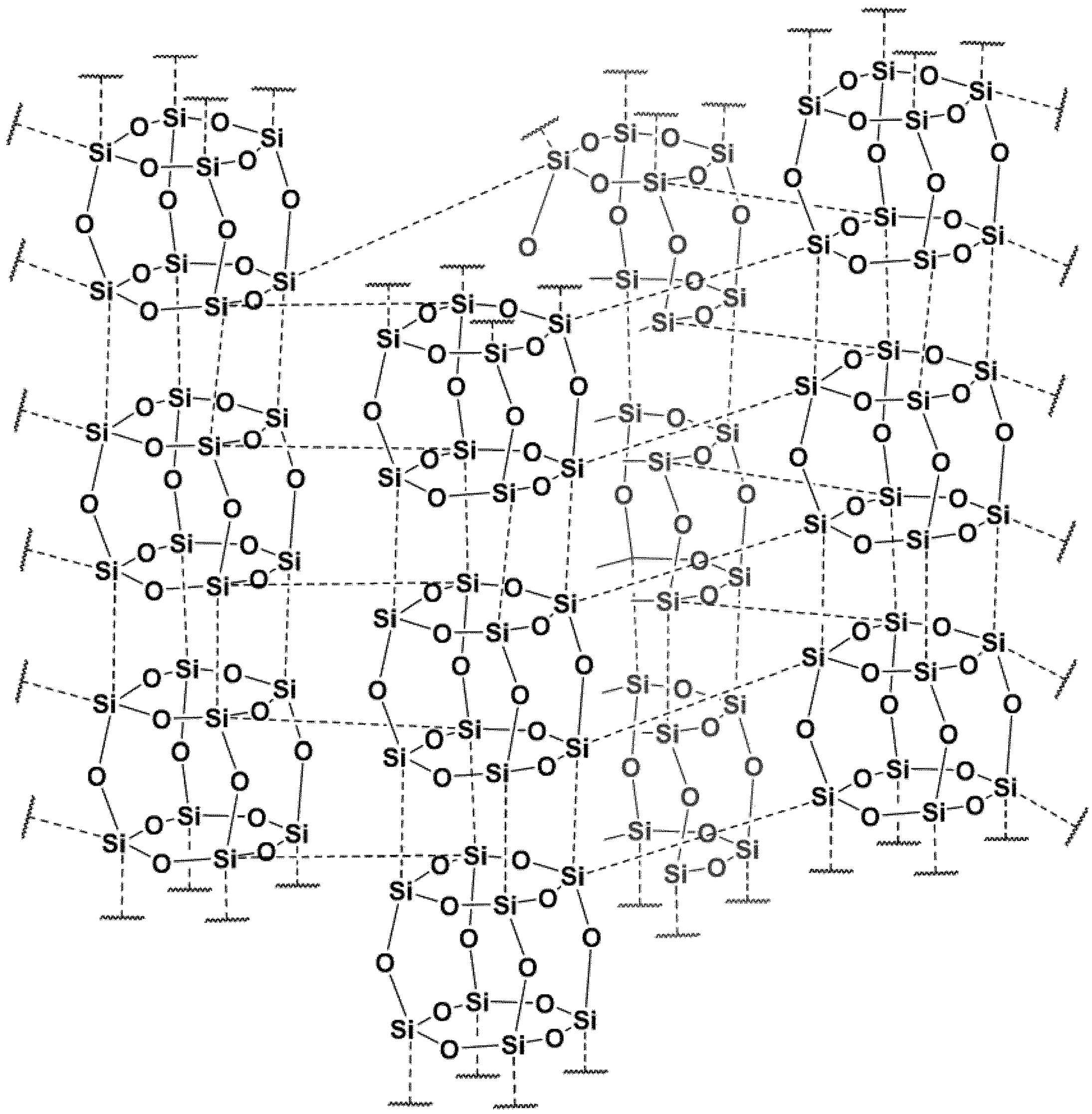

wherein a dashed line refers to omission of a bond including the following structure including a hydrogen bond:

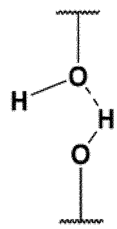

As will be described later, the crystal of the present invention can be prepared by recrystallization from a solution containing a silanol compound and, if necessary, an organic compound, and the obtained crystal may contain an organic compound. The substance contained in the crystal is not limited to the solvent used at the time of production and/or the organic compound added, and may be, for example, a transition metal complex, an inorganic substance, or an elemental substance.

The organic compound, transition metal complex, inorganic substance, and elemental substance may be included between assemblages in which silanol compounds are aligned by an interaction via a hydrogen bond, and when the crystal has a nanohoneycomb-shaped three-dimensional structure, they may be included in the nanohoneycomb structure.

The organic compound, transition metal complex, inorganic substance, and elemental substance, which are

substances contained in the crystal, are not particularly limited, and the molecular weight thereof is preferably 2 to 1000 g/mol.

The substances contained in the crystal are not particularly limited, and examples thereof include hydrogen (hydrogen gas), nitrogen (nitrogen gas), helium, diethyl ether, diisopropyl ether, tert-butyl ethyl ether, furan, glycidyl methyl ether, allyl glycidyl ether, glycidyl isopropyl ether, glycidyl propargyl ether, butyl glycidyl ether, glycidyl phenyl ether, benzyl glycidyl ether, glycidyl acrylate, glycidyl methacrylate, 1,2-epoxybutane, 3,4-epoxy-1-butene, 1,2:3,4-diepoxybutane, 1,2:5,6-diepoxyhexane, 1,2:7,8-diepoxyoctane, tetramethylene glycol diglycidyl ether, 1,2-epoxycyclohexane, 1,2-epoxy-4-vinylcyclohexane, tetrahydrofuran, tetrahydrothiophene, 1,3-dioxolane, ethylene carbonate, 1,4-dioxane, 1,3,5-trithiane, thiophene, selenophene, 2,5-dibromoselenophene, tellurophene, oxazole, isoxazole, isothiazole, pyrazole, imidazole, thiazole, 1H-1,2,3-triazole, 1,2,4-triazole, 1H-tetrazole, pyridine, pyrazine, triazine, benzoxazole, 1,2-benzoisoxazole, 2,1-benzoisoxazole, 1,2-benzoisothiazol-3(2H)-one, indole, benzoimidazole, 1,3-benzodioxol, benzothiazole, 2,1,3-benzothiadiazole, indazole, 1,2,3-benzotriazole, pyrazolo[3,4-b]pyridine, methyl acetate, ethyl acetate, methyl acrylate, methyl methacrylate, ethyl acrylate, ethyl methacrylate, allyl acrylate, allyl methacrylate, butyl acrylate, isobutyl acrylate, butyl methacrylate, isobutyl methacrylate, methacrylic acid-2-methoxyethyl, 1,4-phenylenediisocyanate, 1,4-phenylenediisothiocyanate, 1,5-diisocyanatonaphthalene, squaric acid (3,4-dihydroxy-3-cyclobutene-1,2-dione), cloconic acid (4,5-dihydroxy-4-cyclopentene-1,2,3-trione), dimethoxyethane, diethylene glycol dimethyl ether, triethylene glycol dimethyl ether, N,N-dimethylacetamide, N,N-dimethylformamide, N-methylacetamide, dimethylsulfoxide, dimethylurea, tetramethylurea, cyclopentanone, cyclohexanone, 1,2-cyclohexanedione, 1,3-cyclohexanedione, 1,4-cyclohexanedione, 1,4-benzoquinone, tetrafluoro-1,4-benzoquinone, hydroquinone, 1,2-naphthoquinone, 1,4-naphthoquinone, 2-methyl-1,4-naphthoquinone, anthraquinone, 1,4-anthraquinone, benzene, toluene, xylene, 1,2-bis(bromomethyl)benzene, 1,4-dibromo-2,5-dimethylbenzene, 1,4-dibromo-2,5-bis(bromomethyl)benzene, 1,2-dibromo-4,5-dimethylbenzene, 1,4-dibromo-2,5-dimethylbenzene, 1,4-bis(dimethylsilyl)benzene, 1,4-bis(trimethylsilyl)benzene, 1,4-bis(hydroxydimethylsilyl)benzene, styrene, 4-methylstyrene, 2,3,4,5,6-pentafluorostyrene, naphthalene, 2,3-dimethylnaphthalene, 2,6-dimethylnaphthalene, 2,7-dimethylnaphthalene, 2,6-dibromonaphthalene, 2,7-dibromonaphthalene, benzo[b]thiophene, 5-bromobenzo[b]thiophene, 6-bromobenzo[b]thiophene, anthracene, naphthacene, pentacene, 2,3-dimethylanthracene, 2-bromoanthracene, 2,6-dibromoanthracene, carbazole, 2-bromocarbazole, 3-bromocarbazole, 2,7-dibromocarbazole, 3,6-dibromocarbazole, dibenzothiophene, 3-bromodibenzothiophene, 2,8-dibromodibenzothiophene, 3,7-dibromodibenzothiophene, 4,6-dibromodibenzothiophene, 2-iododibenzothiophene, 2,8-diiododibenzothiophene, 2,8-dimethyldibenzothiophene, benzo[1,2-b':4,5-b']dithiophene, 2,6-dibromobenzo[1,2-b':4,5-b']dithiophene, 2,8-dimethylanthra[2,3-b:6,7-b']dithiophene, phenanthro[1,2-b:8,7-b']dithiophene, thieno[3,2-b]thiophene, 3-bromothieno[3,2-b]thiophene, 2,5-dibromothieno[3,2-b]thiophene, 2,5-di(2-thienyl)thieno[3,2-b]thiophene, 3,6-dibromothieno[3,2-b]thiophene, thieno[2,3-b]thiophene, 2-bromothieno[2,3-b]thiophene, 2,5-dibromothieno[2,3-b]thiophene, 3,4-dibromothieno[2,3-b]thiophene, dithieno[3,2-b:2',3'-d]thiophene, 2,6-dibromodithieno[3,2-b:2',3'-d]thiophene, 3,5-dibromodithieno[3,2-b:2',3'-d]thiophene, biphenyl, p-terphenyl, 4-bromo-p-terphenyl, 4,4"-dibromo-p-terphenyl, 4-bromobiphenyl, 4,4'-dibromobiphenyl, 2,2'-bithiophene, 3,3'-dibromo-2,2'-bithiophene, 5,5'-dibromo-2,2'-bithiophene, 3,3',5,5'-dibromo-2,2'-bithiophene, 2,2'-bithiophene-5-carboxyaldehyde, 5-bromo-2,2'-bithiophene-5'-carboxyaldehyde, 2,2'-bithiophene-5,5'-dicarboxyaldehyde, terthiophene, 5,5"-dibromo-2,2':5',2"-terthiophene, 5"-bromo-2,2':5',2"-terthiophene-5-carboxyaldehyde, 2,2':5',2"-terthiophene-5,5"-dicarboxyaldehyde, $\alpha$-quaterthiophene, $\alpha$-quinquethiophene, $\alpha$-sexithiophene, $\alpha$-septithiophene, 1,4-cyclohexadiene, 1-methyl-1,4-cyclohexadiene, azobenzene, 3,3'-dimethylazobenzene, trans-stilbene, trans-4-bromostilbene, 4,4'-dibromo-trans-stilbene, 4-methyl-trans-stilbene, 4,4'-dimethyl-trans-stilbene, 1,4-diethynylbenzene, diphenylacetylene, 1-ethynyl-4-(phenylethynyl)benzene, adamantane, 1,3-dimethyladamantane, 1-bromoadamantane, 2-bromoadamantane, 3-bromoadamantane, 1,3-dibromoadamantane, pentane, hexane, heptane, octane, nonane, decane, undecane, dodecane, tridecane, tetradecane, pentadecane, hexadecane, heptadecane, octadecane, nonadecane, eicosane, heneicosane, docosane, tricosane, tetracosane, adiponitrile, fumaronitrile, tetracyanoethylene, 1,1,3,3-tetramethyldisiloxane, hexamethyldisiloxane, 1,1,3,3,5,5-hexamethyltrisiloxane, 1,1,3,3,5,5,5-heptamethyltrisiloxane, 1,1,1,3,5,5,5-heptamethyltrisiloxane, 1,1,1,3,3,5,5,5-octamethyltrisiloxane, 1,1,1,3,5,7,7,7-octamethyltetrasiloxane, 1,1,3,3,5,5,7,7-octamethyltetra Siloxane, decamethyltetrasiloxane, 1,1,3,3,5,5,7,7,9,9-decamethylpentasiloxane, 1,1,3,3,5,5,7,7,9,9,11,11-dodecamethylhexasiloxane, ferrocene, nickelocene, ruthenocene, chromocene, manganocene, cobaltocene, osmocene, vanadocene, acetylacetonatobis(ethylene)rhodium, (2,4-pentanedionato)lithium, bis(2,4-pentanedionato)beryllium, bis(2,4-pentanedionato)magnesium, bis(2,4-pentanedionato)calcium, bis(2,4-pentanedionato)manganese, bis(2,4-pentanedionato)cobalt, bis(2,4-pentanedionato)nickel, bis(2,4-pentanedionato)copper, bis(2,4-pentanedionato)palladium, bis(2,4-pentandionato)platinum, tris(2,4-pentandionato)chromium, tris(2,4-pentandionato)cobalt, tris(2,4-pentandionato)gallium, tris(2,4-pentandionato)indium, tris(2,4-pentanedionato)iridium, tris(2,4-pentanedionato)iron, tris(2,4-pentanedionato)lanthanum, bis(benzene)chromium, (benzene)tricarbonylchromium, dicarbonylcyclopentadienylcobalt, tris(cyclopentadienyl)gadolinium, tris(cyclopentadienyl)yttrium, cyclopentadienylindium, bis(cyclopentadienyl)magnesium, cyclopentadienylmanganese tricarbonyl, cycloheptatrienemolybdenum tricarbonyl, tris(cyclopentadienyl)neodymium, allylpalladium chloride (dimer), bis(cyclooctatetraene)iron, cyclohexadiene iron tricarbonyl, dicarbonylcyclopentadienyliodoiron, cyclopentadienyliron

dicarbonyl (dimer), tricarbonyl(cyclooctatetraene)iron, iron(II) acetate, (acetylacetonato)(1,5-cyclooctadiene)iridium, chloro(1,5-cyclooctadiene)iridium (dimer), chlorobis(ethylene)iridium (dimer), (cycloheptatrienyl)(cyclopentadienyl)titanium, bis(1,5-cyclooctadiene)nickel, bis(1,5-cyclooctadiene)platinum, (trimethyl)cyclopentadienylplatinum, tris(cyclopentadienyl)praseodymium, cyclopentadienylrhenium tricarbonyl, dicarbonyl(2,4-pentanedionato)rhodium, hydroxy(1,5-cyclooctadiene)rhodium (dimer), acetylacetonato(norbornadiene)rhodium, chloro(1,5-cyclooctadiene)rhodium (dimer), rhodium acetate (dimer), chloro(norbornadiene)rhodium (dimer), dicarbonylcyclopentadienylruthenium (dimer), tris(cyclopentadienyl)samarium, cyclopentadienylthallium, dicarbonylbis(cyclo)pentadienyl)titanium, cyclopentadienylvanadium tetracarbonyl, bromine, iodine, sulfur, and mercury.

When the crystal of the present invention contains an organic compound, a transition metal complex, an inorganic substance, or an elemental substance, as described later, it may be added to a solution containing a silanol compound used for recrystallization, or the organic compound, transition metal complex, inorganic substance, or elemental substance may be added to the obtained crystal.

[Method of producing crystal]

The crystal of the present invention can be produced, for example, by preparing a solution containing hexamer, octamer, and decamer silanol compounds, and if necessary, further adding a substance selected from the group consisting of an organic compound, a transition metal complex, an inorganic substance, and an elemental substance to the solution, and carrying out recrystallization by a vapor diffusion process applied to the solution; or further adding, if necessary, a substance selected from the group consisting of an organic compound, a transition metal complex, an inorganic substance, and an elemental substance to the solution, and carrying out recrystallization by concentrating the solution under reduced pressure; or further adding, if necessary, at least one substance selected from the group consisting of an organic compound, a transition metal complex, an inorganic substance, and an elemental substance to the solution, and cooling the solution.

That is, one method of producing the crystal of the present invention is a method comprising: a step of preparing a solution containing the above silanol compound; and a step of further adding, if necessary, at least one substance selected from the group consisting of an organic compound, a transition metal complex, an inorganic substance, and an elemental substance to the solution, and carrying out recrystallization by a vapor diffusion process applied to the solution. In addition, one method of producing the crystal of the present invention is a method comprising: a step of preparing a solution containing the above silanol compound; and a step of further adding, if necessary, at least one substance selected from the group consisting of an organic compound, a transition metal complex, an inorganic substance, and an elemental substance to the solution, and carrying out recrystallization by concentrating the solution under reduced pressure. Further, one method of producing the crystal of the present invention is a method comprising: a step of preparing a solution containing the above silanol compound; and a step of further adding, if necessary, at least one substance selected from the group consisting of an organic compound, a transition metal complex, an inorganic substance, and an elemental substance to the solution, and carrying out recrystallization by cooling the solution. Here, cooling refers to lowering the temperature by heating the solution once and allowing the solution to stand or the like, or cooling the solution to, for example, -80°C to 10°C, and preferably -30°C to 10°C.
These methods can also be carried out in combination.

In the above production method, by distilling off the solvent from the solution containing the silanol compound or by cooling the solution, an interaction by a hydrogen bond can be generated between the silanol compounds.

One aspect of the present invention is a method of self-organizing at least one silanol compound selected from the group consisting of a hexamer, an octamer, and a decamer, the method comprising:
a step of forming an interaction by a hydrogen bond by a vapor diffusion process applied to a solution containing the silanol compound, or by concentrating the solution under reduced pressure, or by cooling the solution and distilling off the solvent.

When the crystal of the present invention contains an organic compound, a transition metal complex, an inorganic substance, or an elemental substance, the crystal of the present invention may be produced by a method involving further impregnating the crystal obtained by recrystallization as described above with a substance selected from the group consisting of an organic compound, a transition metal complex, an inorganic substance, and an elemental substance or a solution thereof. By this method, crystals containing various organic compounds, transition metal complexes, inorganic substances, and elemental substances can be obtained using the crystal obtained by the above recrystallization as a starting material.

The crystal to be impregnated is not particularly limited as long as the crystal is the crystal of the present invention, and specifically, the crystal may be any of: a crystal having a one-dimensional structure in which the silanol compounds are linearly aligned by the interaction via a hydrogen bond; a crystal having a two-dimensional structure in which the silanol compounds are planarly aligned by the interaction via a hydrogen bond; and a crystal having a three-dimensional structure in which the silanol compounds are sterically aligned by the interaction via a hydrogen bond.

In the present specification, a crystal containing a substance as a raw material is represented by a crystal (S), and a crystal containing a substance with which at least a part of the substance contained in the crystal (S) is replaced is represented by a crystal (P).

By the above impregnation method, the substance in the crystal (S) is replaced with a substance with which it is impregnated, to form the crystal (P). It is considered that this replacement takes place because, while the crystal (S) originally has a crystal structure formed by a first substance of an organic compound, a transition metal complex, an inorganic substance, or an elemental substance, and a silanol compound, for reasons such as excessive presence of a second substance of an organic compound, a transition metal complex, an inorganic substance, or an elemental substance there, and the higher affinity for the silanol compound, the formation of a crystal structure with the second substance takes precedence.

One aspect of the present invention is a method of producing a crystal (P) comprising at least one substance selected from the group consisting of an organic compound, a transition metal complex, an inorganic substance, and an elemental substance.
The method of producing a crystal (P) comprises:

a step of preparing a crystal (S) comprising a plurality of silanol compounds of at least one selected from the group consisting of a hexamer represented by the following formula (1), an octamer represented by the following formula (2), and a decamer represented by the following formula (3), having an interaction via a hydrogen bond by at least one hydroxy group between the silanol compounds, and comprising at least one first substance selected from the group consisting of an organic compound, a transition metal complex, an inorganic substance, and an elemental substance; and
a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second substance.

Here, at least a part of the substance after the replacement is preferably a substance different from the substance before the replacement.

That is, one aspect of the present invention is a method of producing a crystal (P) comprising a plurality of silanol compounds of at least one selected from the group consisting of a hexamer represented by formula (1), an octamer represented by formula (2), and a decamer represented by formula (3), having an interaction via a hydrogen bond by at least one hydroxy group between the silanol compounds, having a one-dimensional structure in which the silanol compounds are linearly aligned, and comprising at least one substance selected from the group consisting of an organic compound, a transition metal complex, an inorganic substance, and an elemental substance, the method comprising:

a step of preparing a crystal (S) comprising a plurality of silanol compounds of at least one selected from the group consisting of a hexamer represented by the formula (1), an octamer represented by the formula (2), and a decamer represented by the formula (3), having an interaction via a hydrogen bond by at least one hydroxy group between the silanol compounds, having a one-dimensional structure in which the silanol compounds are linearly aligned, and comprising at least one first substance selected from the group consisting of an organic compound, a transition metal complex, an inorganic substance, and an elemental substance; and
a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second substance.

In addition, one aspect of the present invention is a method of producing a crystal (P) comprising a plurality of silanol compounds of at least one selected from the group consisting of a hexamer represented by formula (1), an octamer represented by formula (2), and a decamer represented by formula (3), having an interaction via a hydrogen bond by at least one hydroxy group between the silanol compounds, having a two-dimensional structure in which the silanol compounds are planarly aligned, and comprising at least one substance selected from the group consisting of an organic compound, a transition metal complex, an inorganic substance, and an elemental substance, the method comprising:

a step of preparing a crystal (S) comprising a plurality of silanol compounds of at least one selected from the group consisting of a hexamer represented by the formula (1), an octamer represented by the formula (2), and a decamer represented by the formula (3), having an interaction via a hydrogen bond by at least one hydroxy group between the silanol compounds, having a two-dimensional structure in which the silanol compounds are planarly aligned, and comprising at least one first substance selected from the group consisting of an organic compound, a transition

metal complex, an inorganic substance, and an elemental substance; and

a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second substance.

In particular, when the crystal of the present invention has a nanohoneycomb-shaped three-dimensional structure and contains an organic compound, a transition metal complex, an inorganic substance, or an elemental substance inside the nanohoneycomb structure (the crystal in this case is also referred to as a "substance-containing nanohoneycomb-shaped crystal"), a method of producing a crystal (P) by impregnating the crystal produced by the above recrystallization method with a substance selected from the group consisting of an organic compound, a transition metal complex, an inorganic substance, and an elemental substance or a solution thereof is preferably applicable. When a substance-containing nanohoneycomb-shaped crystal is produced by the production method including the above recrystallization step, it may be difficult to include the substance inside the nanohoneycomb structure depending on the type of the substance. On the other hand, in the method of impregnation with a substance, the organic compound, transition metal complex, inorganic substance, or elemental substance originally contained in the substance-containing nanohoneycomb-shaped crystal as a raw material can be easily replaced with the substance with which it is impregnated, and as a result, a nanohoneycomb-shaped crystal containing a substance that is difficult to include inside the nanohoneycomb structure can be produced.

Therefore, one aspect of the present invention is a method of producing a crystal (P) having a nanohoneycomb-shaped three-dimensional structure and comprising at least one substance selected from the group consisting of an organic compound, a transition metal complex, an inorganic substance, and an elemental substance inside the nanohoneycomb structure.

The method of producing a crystal (P) comprises:

a step of preparing a crystal (S) comprising a plurality of silanol compounds of at least one selected from the group consisting of a hexamer represented by the formula (1), an octamer represented by the formula (2), and a decamer represented by the formula (3), having an interaction via a hydrogen bond by at least one hydroxy group between the silanol compounds, having a three-dimensional structure in which the silanol compounds are sterically aligned by the interaction via a hydrogen bond, and comprising at least one first substance selected from the group consisting of an organic compound, a transition metal complex, an inorganic substance, and an elemental substance; and

a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second substance.

Here, the step of carrying out the replacement in the present invention may be carried out twice or more. For example, when the step of carrying out the replacement is carried out twice, the first substance is replaced with the second substance by the first step of carrying out the replacement, and the second substance is replaced with the third substance by the second step of carrying out the replacement.

The crystal (S) may be prepared, for example, by the above method of producing a crystal, specifically, a method of producing a crystal comprising: a step of preparing a solution containing at least one compound selected from the group consisting of a hexamer represented by the formula (1), an octamer represented by the formula (2), and a decamer represented by the formula (3); and a step of adding, if necessary, at least one substance selected from the group consisting of an organic compound, a transition metal complex, an inorganic substance, and an elemental substance to the solution and carrying out recrystallization by a vapor diffusion process applied to the solution, or by concentrating the solution under reduced pressure, or by cooling the solution. The crystal (S) is preferably prepared by a method of producing a crystal comprising: a step of preparing a solution containing at least one compound selected from the group consisting of a hexamer represented by the formula (1), an octamer represented by the formula (2), and a decamer represented by the formula (3); and a step of adding the first substance to the solution and carrying out recrystallization by a vapor diffusion process applied to the solution, or by concentrating the solution under reduced pressure, or by cooling the solution.

As the crystal (S), the crystal obtained by the production method comprising a step of carrying out recrystallization may be used as it is, or the silanol compound not arranged in the above recrystallization step and/or the crystal after washing with a solvent in order to remove the reagent, and the like, at the time of producing the hexamer, octamer, and decamer silanol compounds described later may be used.

The solvent is not particularly limited, and examples thereof include acetonitrile, diethyl ether, diisopropyl ether, tert-butyl ethyl ether, furan, tetrahydrofuran, tetrahydropyran, 1,3-dioxolane, 1,4-dioxane, dimethoxyethane, diethylene glycol dimethyl ether, triethylene glycol dimethyl ether, N,N-dimethylacetamide, N,N-diethylacetamide, N,N-dimethylformamide, N-methylacetamide, dimethylsulfoxide, tetramethylurea, tetraethylurea, ethyl acetate, acetone, 2-butanone,

benzene, toluene, cyclohexane, and hexane. These may be used singly or as a mixture of two or more.

When a polar solvent such as tetrahydrofuran, diethylene glycol dimethyl ether, triethylene glycol dimethyl ether, dimethylacetamide, or dimethylurea is used as the solvent, it is preferable to make appropriate adjustment in such a way as to suppress the amount used in order to suppress the dissolution of the crystal. In addition, in order to suppress the dissolution of the crystal while maintaining the detergency, the above polar solvent and another solvent may be blended and used in an arbitrary ratio.

Specifically, the washing can be carried out by contacting the crystal obtained by the production method comprising a step of carrying out recrystallization with a solvent, and then separating the liquid and the crystal.

The organic compound, transition metal complex, inorganic substance, and elemental substance with which the crystal (S) is contacted may be liquid or solid. When the organic compound, the transition metal complex, the inorganic substance, and the elemental substance are solid, it is preferable to use a solution obtained by dissolving the solid in a solvent to contact it with the crystal (S). In addition, at this time, as the solvent, it is preferable to use a solvent bulkier than the pore diameter of the nanohoneycomb-shaped structure of the three-dimensional crystal. By using the bulkier solvent, the replacement of the substance contained in the crystal (S) tends to occur easily.

Hexamer, octamer, and decamer silanol compounds can be produced by an organic synthesis technique. Specifically, these can be produced as follows.

The hexamer, octamer, and decamer silanol compounds can be preferably produced by a production method comprising a proton exchange step of reacting a silicate having a structure represented by the following formula (1'), (2'), or (3'), respectively, (hereinafter, also abbreviated as a "silicate") with an acidic compound having an acid dissociation constant $pK_a$ in dimethylsulfoxide (DMSO) (hereinafter, also abbreviated as "$pK_a$ (DMSO)") of -1 to 20 (hereinafter, also abbreviated as an "acidic compound") to generate a silanol compound having a structure represented by the following formula (c) (hereinafter, also abbreviated as a "proton exchange step").

The silicate salts having the structures represented by the following formulas (1'), (2'), and (3') may also be produced by an organic synthesis technique or can also be obtained as commercially available products.

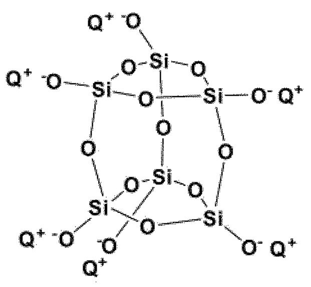
(1')

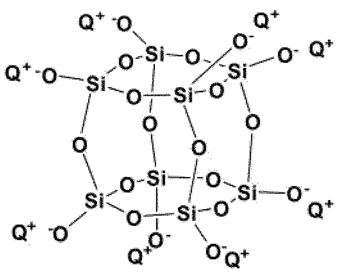
(2')

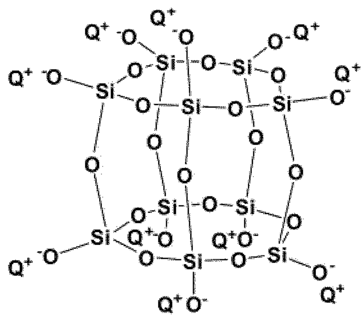
(3')

$pK_a$ (DMSO) means a known numerical value calculated from the concentration of each component in acid dissociation equilibrium at 25°C of the acidic compound in DMSO. Specifically, $pK_a$ is a common logarithmized numerical value of a value $K_a$ calculated by the following expression.

$$HA \rightleftarrows H^+ + A^-$$

$$K_a = \frac{[H^+][A^-]}{[HA]}$$

Examples of $Q^+$ in the silicate include an alkali metal ion such as a lithium ion ($Li^+$) , a sodium ion ($Na^+$), or a potassium ion ($K^+$), an alkaline earth metal ion such as a magnesium ion ($Mg^{2+}$) or a calcium ion ($Ca^{2+}$), a transition metal ion such as an iron(III) ion ($Fe^{3+}$), a copper(II) ion ($CU^{2+}$), or a zinc ion ($Zn^{2+}$), and an ammonium ion such as an ammonium ion ($NH_4^+$), a tetramethylammonium ion ($NMe_4^+$), an ethyltrimethylammonium ion ($NEtMe_3^+$), a diethyldimethylammonium ion ($NEt_2Me_2^+$), a triethylmethylammonium ion ($NEt_3Me^+$), a tetraethylammonium ion ($NEt_4^+$), a tetrap-

ropylammonium ion ($NPr_4^+$), or a tetrabutylammonium ion ($NBu_4^+$) . Among these, a sodium ion ($Na^+$) , a potassium ion ($K^+$), a tetramethylammonium ion ($NMe_4^+$), a tetraethylammonium ion ($NEt_4^+$), and an ethyltrimethylammonium ion ($NEtMe_3^+$) are preferable.

The acidic compound is a compound having a $pK_a$ (DMSO) of -1 to 20, and $pK_a$ (DMSO) is preferably 0 or more, more preferably 1 or more, further preferably 3 or more, and preferably 16 or less, more preferably 14 or less, further preferably 8 or less. Within the above range, a silanol compound can be efficiently produced. The specific structure, or the like, of the acidic compound is not particularly limited as long as $pK_a$ (DMSO) is -1 to 20.

Examples of the acidic compound include an inorganic acid such as nitric acid ($pK_a$ (DMSO) of 1.4), sulfuric acid ($pK_a1$ (DMSO) of 1.4, $pK_a2$ (DMSO) of 14.7), or hydrochloric acid ($pK_a$ (DMSO) of 2.1), phosphoric acid (pKa1 (DMSO) of 1.83, pKa2 (DMSO) of 6.43, pKa3 (DMSO) of 11.46), or at least one organic acid selected from the group consisting of acetic acid or compounds having the structures represented by the following formulas (b-1) to (b-5) .

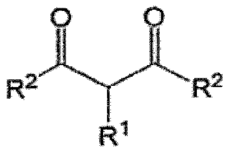
(b − 1)

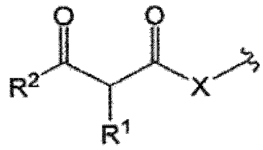
(b − 2)

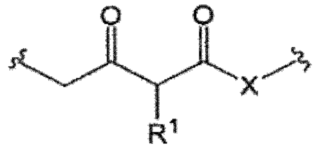
(b − 3)

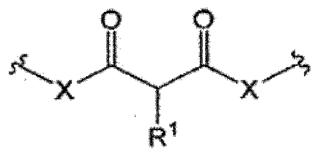
(b − 4)

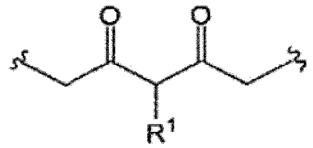
(b − 5)

wherein each X independently represents an oxygen atom, a sulfur atom, or an amino group ($-NR^3-$), and $R^1$ represents a hydrogen atom or a hydrocarbon group having 1 to 14 carbon atoms, and each $R^2$ independently represents a hydrogen atom or a hydrocarbon group having 1 to 14 carbon atoms.

The wavy line in formulas (b-2) to (b-5) means that there is an arbitrary structure ahead thereof. For example, the acidic compound may contain a functional group, or the like, that does not participate in the reaction. Therefore, for example, an acidic compound having a structure represented by formula (b-4) may be a compound containing a hydrocarbon group such as a methyl group ahead of the oxygen atom corresponding to X, such as dimethyl malonate of the following formula. In addition, for example, an acidic compound having a structure represented by formula (b-4) may be a compound in which hydrocarbon groups ahead of the oxygen atoms corresponding to X are bonded to form a ring structure, such as Meldrum's acid of the following formula.

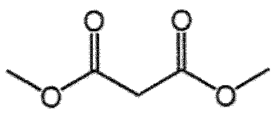
Dimethyl malonate

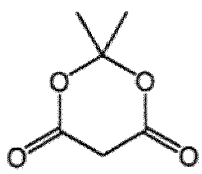
Meldrum's acid

When a proton exchange reaction using an organic acid is carried out in N,N-dimethylacetamide (DMAc), methanol (MeOH), and/or the like, which are each a reaction medium, the ammonium salt produced is dissolved in the reaction medium. Because of this, the ammonium salt, which is a by-product, needs to be separated by column purification, or the like. On the other hand, when a proton exchange reaction using an inorganic acid is carried out in tetrahydrofuran (THF), or the like, which is a reaction medium, the ammonium salt produced is not dissolved in the reaction medium. Because of this, the ammonium salt can be separated by a simple separation unit such as filter filtration to obtain a silanol compound solution, which is a filtrate. Therefore, the acidic compound is preferably an inorganic acid.

Among the inorganic acids, nitric acid, sulfuric acid, hydrochloric acid, and phosphoric acid are preferable, and nitric acid or sulfuric acid is particularly preferable. This is because a nitrate ion, a hydrogensulfate ion, and a sulfate ion have a weak interaction (a hydrogen bond, or the like) with a silanol compound, and it is difficult for the silanol compound and the ammonium salt produced as a by-product to form a complex insoluble in the reaction medium. On

the other hand, a chloride ion, a dihydrogenphosphate ion, a hydrogenphosphate ion, and a phosphate ion have a strong interaction (a hydrogen bond, or the like) with a silanol compound. Because of this, in proton exchange using hydrochloric acid or phosphoric acid, a silanol compound and the ammonium salt may form a complex insoluble in the reaction medium, and the yield of the target silanol compound may be slightly lowered.

Examples of the amino group ($-NR^3-$), which is X, include a secondary amino group (-NH-). X is particularly preferably an oxygen atom. When $R^1$ is a hydrocarbon group, the number of carbon atoms is preferably 6 or less, more preferably 5 or less, and further preferably 4 or less. Examples of $R^1$ includes a hydrogen atom, a methyl group (-Me), an ethyl group (-Et), a n-propyl group ($-^nPr$), an i-propyl group ($-^iPr$), a n-butyl group ($-^nBu$), and a phenyl group (-Ph), and $R^1$ is preferably a hydrogen atom.

When $R^2$ is a hydrocarbon group, the number of carbon atoms is preferably 5 or less, more preferably 4 or less, and further preferably 3 or less. Examples of $R^2$ includes a hydrogen atom, a methyl group (-Me), an ethyl group (-Et), a n-propyl group ($-^nPr$), an i-propyl group ($-^iPr$), and a n-butyl group ($-^nBu$), and $R^2$ is preferably a hydrogen atom.

Examples of the acidic compound represented by formula (b-4) include an acidic compound represented by the following formula (b-4-1). Examples of the acidic compound represented by formula (b-5) include an acidic compound represented by the following formula (b-5-1).

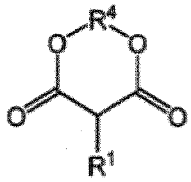

(b-4-1)

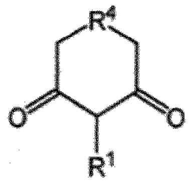

(b-5-1)

wherein $R^1$ is a hydrogen atom or a hydrocarbon group having 1 to 14 carbon atoms, and $R^4$ is a divalent hydrocarbon group having 1 to 14 carbon atoms.

Examples of $R^4$ include a methylene group ($-CH_2-$), an ethylene group ($-CH_2CH_2-$), a n-propylene group ($-CH_2CH_2CH_2-$), a dimethylmethylene group ($-C(CH_3)_2-$), and an i-propylene group ($-CH(CH_3)\ CH_2-$).

Examples of the acidic compound include acetic acid ($pK_a$ (DMSO) of 12.6), benzoic acid ($pK_a$ (DMSO) of 11.1), Meldrum's acid ($pK_a$ (DMSO) of 7.3), a Meldrum's acid derivative, dimedone ($pK_a$ (DMSO) of 11.2), a dimedone derivative, acetylacetone ($pK_a$ (DMSO) of 13.3), and an acetylacetone derivative (see the formulas below).

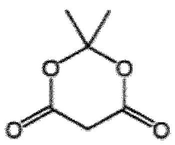

Meldrum's acid

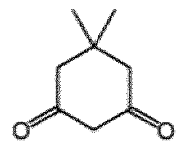

Dimedone

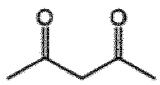

Acetylacetone

As an acidic compound, a low molecular weight compound such as Meldrum's acid, or an organic solid material such as a resin or an inorganic solid material such as silica or carbon to which a compound represented by any of the formulas (b-2) to (b-5) is introduced can be utilized. When the acidic compound is such a solid, the acidic compound can be packed in a column and utilized like an ion exchange resin. Because of this, a silanol compound can be produced very efficiently.

In particular, the acidic compound is preferably a resin having at least one structure selected from the group consisting of the formulas (b-2) to (b-5), and the acidic compound can preferably be regenerated as an acidic compound by carrying out a proton exchange step and then exposure to an acidic aqueous solution such as hydrochloric acid.

The amount of the acidic compound used in the proton exchange step is usually 1 time or more, preferably 1.05 times or more, more preferably 1.1 times or more, and usually 50 times or less, preferably 20 times or less, more preferably 5 times or less that of the silicate in terms of the amount of substance. Within the above range, a silanol compound can be efficiently produced.

The reaction in the proton exchange step is preferably carried out in a liquid. Examples of such a liquid include an ether-based liquid such as tetrahydrofuran (THF), tetrahydropyran, dioxane, diethyl ether ($Et_2O$), dimethyl ether, diisopropyl ether, diphenyl ether, methyl ethyl ether, diethylene glycol dimethyl ether, or triethylene glycol dimethyl ether, an alcohol-based liquid such as methanol, ethanol, n-propanol, or i-propanol, an amide-based liquid such as formamide, N,N-dimethylformamide (DMF), acetamide, N-methylacetamide, N,N-dimethylacetamide (DMAc), urea, or tetramethylurea, an ester-based liquid such as ethyl acetate, n-amyl acetate, or ethyl lactate, a halogen-based liquid such as methylene chloride, chloroform, carbon tetrachloride, tetrachloroethane, or hexachloroethane, acetone, methyl ethyl ketone, phenyl methyl ketone, DMSO, and water. The liquid is not limited to a single liquid, and two or more liquids may be combined.

The amount of the liquid used in the proton exchange step is preferably an amount such that the content of the silicate is 0.005 to 0.04 mol/L. This is because a silanol compound can be efficiently produced with such a content of the silicate. The reaction temperature in the proton exchange step is usually -80°C or more, preferably 0°C or more, more preferably 20°C or more, and usually 200°C or less, preferably 70°C or less, more preferably 40°C or less. The reaction time in the proton exchange step is usually 48 hours or less, preferably 24 hours or less, more preferably 8 hours or less, and particularly preferably 1 hour or less. Within the above ranges, a silanol compound can be efficiently produced.

The method of producing a hexamer, octamer, or decamer silanol compound may include a step other than the proton exchange step. Examples of a specific step other than the proton exchange step include an ammonium salt addition step of adding an ammonium salt to the product obtained in the proton exchange step (hereinafter, also abbreviated as an "ammonium salt addition step"), and a freeze-drying step of freezing the product obtained in the proton exchange step or the product obtained in the ammonium salt addition step and exposing the product to reduced pressure (hereinafter, also abbreviated as a "freeze-drying step").

(Ammonium salt addition step)

The type and amount of the ammonium salt used are not particularly limited, and can be appropriately selected depending on the intended purpose. The "ammonium salt" means a compound composed of an ammonium ion and a counter anion, and the structures of the ammonium ion and the counter anion are not particularly limited. It is considered that the addition of the ammonium salt suppresses the condensation of the silanol compound. Examples of the ammonium ion include a tetrahydroammonium ion ($NH_4^+$), a tetramethylammonium ion ($NMe_4^+$), a tetrapropylammonium ion ($NPr_4^+$), a tetrabutylammonium ion ($NBu_4^+$), a benzyltributylammonium ion ($NBnBu_3^+$), a tributyl (methyl) ammonium ($NBu_3Me^+$) ion, a tetrapentylammonium ion ($NPen_4^+$), a tetrahexylammonium ion ($NHex_4^+$), a tetraheptylammonium ion ($NHep_4^+$), a 1-butyl-lmethylpyrrolidium ion ($BuMePyr^+$), a methyltrioctylammonium ion ($NMeOct_3^+$), a dimethyldioctadecylammonium ion, and a Meldrum's acid-tetramethylammonium salt.

Examples of the counter anion include a fluoride ion ($F^-$), a chloride ion ($Cl^-$), a bromide ion ($Br^-$), an iodide ion ($I^-$), an acetoxy ion ($AcO^-$), a nitrate ion ($NO_3^-$), an azide ion ($N_3^-$), a tetrafluoroborate ion ($BF_4^-$), a perchlorate ion ($ClO_4^-$), and a sulfate ion ($SO_4^-$).

The ammonium salt is particularly preferably tetrabutylammonium chloride ($NBu_4Cl$), tetrabutylammonium bromide ($NBu_4Br$), tetrapentylammonium chloride ($NPen_4Cl$), a Meldrum's acid-tetramethylammonium salt, or dimethyldioctadecylammonium chloride. The ammonium salt contained in a composition is not limited to a single ammonium salt, and two or more ammonium salts may be contained. The amount of the ammonium salt used is preferably 1 to 4 times that of the silanol compound in terms of the amount of substance.

(Freeze-drying step)

The freezing temperature, drying temperature, drying pressure, drying time, and the like in the freeze-drying step are not particularly limited and can be appropriately selected depending on the intended purpose. The freezing temperature is not particularly limited as long as the freezing temperature is a temperature at which the product obtained in the proton exchange step or the product obtained in the ammonium salt addition step freezes, and is usually 10°C or less, preferably 0°C or less, more preferably -20°C or less, and usually -196°C or more, preferably -150°C or more, more preferably - 100°C or more.

The drying temperature is usually 10°C or less, preferably 0°C or less, more preferably -20°C or less, and usually -196°C or more, preferably -150°C or more, more preferably -100°C or more. The drying pressure is usually 100 Pa or less, preferably 20 Pa or less, more preferably 3 Pa or less, and usually $10^{-5}$ Pa or more, preferably 0.01 Pa or more, more preferably 1 Pa or more. The drying time is usually 200 hours or less, preferably 100 hours or less, more preferably 50 hours or less, and usually 1 hour or more, preferably 5 hours or more, more preferably 10 hours or more.

When the crystal of the present invention is produced, the desired one-dimensional structure, two-dimensional structure, or three-dimensional structure can be obtained by controlling the formation of a hydrogen bond in the recrystallization step.

Examples of a method of controlling the formation of a hydrogen bond include a method of selecting the type of a solvent for dissolving a silanol compound, a method of controlling the temperature during recrystallization, a method of controlling the degree of decompression when removing the solvent, and a method of adding a substance selected from the group consisting of an organic compound, a transition metal complex, an inorganic substance, and an elemental

substance, preferably an organic compound, in addition to the solvent. Among these control methods, a method of selecting the type of a solvent for dissolving a silanol compound is preferable.

In particular, by using a solvent having a low hydrogen bonding ability with a silanol compound as the solvent, the control is carried out such that the formation of a hydrogen bond between the silanol compound and the solvent molecule is suppressed and that the formation of a hydrogen bond between the silanol compounds is promoted. The solvent may be appropriately selected from diethyl ether, diisopropyl ether, tert-butyl ethyl ether, furan, tetrahydrofuran, tetrahydropyran, 1,3-dioxolane, 1,4-dioxane, dimethoxyethane, diethylene glycol dimethyl ether, triethylene glycol dimethyl ether, N,N-dimethylacetamide, N,N-diethylacetamide, N,N-dimethylformamide, N-methylacetamide, dimethylsulfoxide, tetramethylurea, tetraethylurea, and the like, and these may be used singly or as a mixture of two or more. In addition, also by using a mixed solvent of two or more as the solvent and changing the mixing ratio of the two, the degree of formation of a hydrogen bond between the silanol compound and the solvent molecule can be adjusted, and the desired one-dimensional structure, two-dimensional structure, or three-dimensional structure can be produced.

## Examples

Next, the present invention will be described further specifically with reference to Examples, but the present invention is not limited to these Examples.

[Example 1] $Q_8H_8$ (one-dimensional (rod-shaped) structure) (with tetramethylurea added)

3.04 mL (48.04 mmol) of nitric acid was added to a dispersion obtained by suspending 8.062 g (4.00 mmol) of octakis (tetramethylammonium) pentacyclo [9.5.1.1$^{3,9}$.1$^{5,15}$.1$^{7,13}$.] octasiloxane-1,3,5,7,9,11,13,15-octakis(yloxide) hydrate (CAS No. 69667-29-4 (hereinafter, also abbreviated as "$Q_8(TMA)_8 \cdot nH_2O$")), $Q_8(TMA)_8 \cdot 48.7H_2O$, in 150 mL of THF, and the resulting mixture was stirred for 30 minutes to obtain a suspension. This suspension was subjected to filter filtration (washed with 50 mL of THF).

20 mL of tetramethylurea was added to the filtrate, then distillation was carried out under reduced pressure for concentration, and recrystallization was carried out at room temperature by a poor solvent process (vapor diffusion), to isolate a colorless solid (columnar crystal) that was a composition containing 54.3% by mass of the composition formula $Si_8O_{20}H_8$ (the compound represented by formula (2)) (hereinafter, also abbreviated as "$Q_8H_8$") in a yield of 90% (3.663 g) ($^1$H-NMR (DMF-$d_7$) : 7.72 ppm, $^{29}$Si-NMR (DMF-$d_7$) : -100.0 ppm) .

In addition, single crystal X-ray crystal structure analysis revealed that the crystal obtained had a crystal structure in which configurations of four molecules of tetramethylurea per molecule of $Q_8H_8$ assembled, and a one-dimensional (rod-shaped) structure in which $Q_8H_8$ molecules were hydrogen-bonded to each other and stabilized.

The crystal structure determined from the single crystal X-ray crystal structure analysis is shown in Figure 2. In the crystal structure shown in Figure 2, a hydrogen atom is omitted.

[Example 2] $Q_8H_8$ (one-dimensional (ladder-shaped) structure)

0.76 mL (12.01 mmol) of nitric acid was added to a dispersion obtained by suspending 2.016 g (1.00 mmol) of $Q_8(TMA)_8 \cdot 48.7H_2O$ in 40 mL of tetrahydrofuran, and the resulting mixture was stirred for 30 minutes to obtain a suspension. This suspension was subjected to filter filtration (washed with 10 mL of THF).

10 mL of N,N-dimethylacetamide was added to the filtrate, then distillation was carried out under reduced pressure for concentration, and recrystallization was carried out at -5°C by a poor solvent process, to isolate a colorless solid that was a composition containing $Q_8H_8$ and N,N-dimethylacetamide. Subsequently, 20 mg of the obtained crystal was dissolved in 1.00 mL of tetrahydrofuran, and the insoluble matter was separated by filter filtration. This solution was recrystallized at -30°C to isolate a colorless solid (prismatic crystal) containing 68.4% by mass of $Q_8H_8$ in a yield of 20% (3.180 mg) ($^1$H-NMR (DMF-$d_7$) : 7.72 ppm, $^{29}$Si-NMR (DMF-$d_7$) : -100.0 ppm) .

In addition, single crystal X-ray crystal structure analysis revealed that the crystal obtained had a crystal structure in which configurations of one molecule of N,N-dimethylacetamide and two molecules of tetrahydrofuran per molecule of $Q_8H_8$ assembled, and a one-dimensional (ladder-shaped) structure in which $Q_8H_8$ molecules were hydrogen-bonded to each other and stabilized.

[Example 3] $Q_8H_8$ (two-dimensional (sheet-shaped) structure)

3.04 mL (48.04 mmol) of nitric acid was added to a dispersion obtained by suspending 8.062 g (4.00 mmol) of $Q_8(TMA)_8 \cdot 48.7H_2O$ in 150 mL of THF, and the resulting mixture was stirred for 30 minutes to obtain a suspension. This suspension was subjected to filter filtration (washed with 50 mL of THF).

30 mL of diethylene glycol dimethyl ether was added to the filtrate, then distillation was carried out under reduced

pressure for concentration, and after that recrystallization was carried out at room temperature by a poor solvent process (vapor diffusion) using diethyl ether as a poor solvent, to isolate a colorless solid (plate-shaped crystal) that was a composition containing 78.9% by mass of $Q_8H_8$ in a yield of 88% (2.467 g) ($^1$H-NMR (DMF-$d_7$) : 7.73 ppm, $^{29}$Si-NMR (DMF-$d_7$) : -99.8 ppm) .

In addition, single crystal X-ray crystal structure analysis revealed that the crystal obtained had a crystal structure in which configurations of one molecule of $Q_8H_8$ and two molecules of diethyl ether ($Et_2O$) assembled, and a two-dimensional (sheet-shaped) structure in which $Q_8H_8$ molecules were hydrogen-bonded to each other and stabilized.

The crystal structure determined from the single crystal X-ray crystal structure analysis is shown in Figure 3. In the crystal structure shown in Figure 3, a hydrogen atom is omitted.

[Example 4] $Q_8H_8$ (two-dimensional (sheet-shaped) structure) (with diethylene glycol dimethyl ether (diglyme) added)

1.52 mL (24.02 mmol) of nitric acid was added to a dispersion obtained by suspending 8.062 g (2.00 mmol) of $Q_8(TMA)_8 \cdot 48.7H_2O$ in 75 mL of THF, and the resulting mixture was stirred for 30 minutes to obtain a suspension. This suspension was subjected to filter filtration (washed with 25 mL of THF).

20 mL of diethylene glycol dimethyl ether was added to the filtrate. This solution was concentrated under conditions of 40°C and a degree of decompression of 267 Pa (2 torr) to isolate a colorless solid (needle-shaped crystal) that was a composition containing 80.5% by mass of $Q_8H_8$ in a yield of 60% (0.824 g) ($^1$H-NMR (DMF-$d_7$) : 7.42 ppm, $^{29}$Si-NMR (DMF-$d_7$) : -100.1 ppm).

In addition, single crystal X-ray crystal structure analysis revealed that the obtained crystal had a two-dimensional (sheet-shaped) structure in which $Q_8H_8$ molecules were hydrogen-bonded to each other and stabilized. $^1$H-NMR analysis confirmed that the crystal had a crystal structure in which $Q_8H_8$ and diglyme assembled. Diglyme was not included in the crystal structure in an orderly manner, and thus the ratio of the numbers of molecules of $Q_8H_8$ and diglyme in the crystal structure unit was not calculated.

[Example 5] $Q_8H_8$ (three-dimensional (nanohoneycomb-shaped) structure)

3.04 mL (48.04 mmol) of nitric acid was added to a dispersion obtained by suspending 8.062 g (4.00 mmol) of $Q_8(TMA)_8 \cdot 48.7H_2O$ in 150 mL of THF, and the resulting mixture was stirred for 30 minutes to obtain a suspension. This suspension was subjected to filter filtration (washed with 50 mL of THF).

This filtrate was concentrated under conditions of 5°C and a degree of decompression of 6666 Pa (50 torr) to isolate a colorless solid (plate-shaped crystal) that was a composition containing 79.3% by mass of $Q_8H_8$ in a yield of 86% (2.397 g) ($^1$H-NMR (DMF-$d_7$) : 7.73 ppm, $^{29}$Si-NMR (DMF-$d_7$) : -100.1 ppm) .

In addition, single crystal X-ray crystal structure analysis revealed that the crystal obtained had a crystal structure in which configurations of one molecule of $Q_8H_8$ and two molecules of THF assembled, and a three-dimensional (nanohoneycomb-shaped) structure in which $Q_8H_8$ molecules were hydrogen-bonded to each other and stabilized.

The crystal structure determined from the single crystal X-ray crystal structure analysis is shown in Figure 4. In the crystal structure shown in Figure 4, a hydrogen atom is omitted.

[Example 6] $Q_8H_8$ (three-dimensional (nanohoneycomb-shaped) structure) (with 1,4-benzoquinone added)

1.52 mL (24.02 mmol) of nitric acid was added to a dispersion obtained by suspending 4.031 g (2.00 mmol) of $Q_8(TMA)_8 \cdot 48.7H_2O$ in 75 mL of THF, and the resulting mixture was stirred for 30 minutes to obtain a suspension. This suspension was subjected to filter filtration (washed with 25 mL of THF).

0.648 g (6.00 mmol) of 1,4-benzoquinone was added to this filtrate, and dissolved. This solution was concentrated under conditions of 5°C and a degree of decompression of 6666 Pa (50 torr) to isolate an orange solid (needle-shaped crystal) that was a composition containing 71.9% by mass of $Q_8H_8$ in a yield of 52% (0.795 g) ($^1$H-NMR (DMF-$d_7$) : 7.68 ppm, $^{29}$Si-NMR (DMF-$d_7$) : -100.1 ppm).

In addition, single crystal X-ray crystal structure analysis revealed that the crystal obtained had a crystal structure in which configurations of one molecule of $Q_8H_8$ and two molecules of 1,4-benzoquinone assembled, and a three-dimensional (nanohoneycomb-shaped) structure in which $Q_8H_8$ molecules were hydrogen-bonded to each other and stabilized.

[Example 7] $Q_8H_8$ (three-dimensional (nanohoneycomb-shaped) structure) (with dimethoxyethane added)

1.52 mL (24.02 mmol) of nitric acid was added to a dispersion obtained by suspending 4.031 g (2.00 mmol) of $Q_8(TMA)_8 \cdot 48.7H_2O$ in 75 mL of THF, and the resulting mixture was stirred for 30 minutes to obtain a suspension. This suspension was subjected to filter filtration (washed with 25 mL of THF).

40 mL of dimethoxyethane was added to the filtrate. This solution was concentrated under conditions of 5°C and a degree of decompression of 2666 Pa (20 torr) to isolate a colorless solid (needle-shaped crystal) that was a composition containing 86.0% by mass of $Q_8H_8$ in a yield of 85% (1.093 g) ($^1$H-NMR (DMF-$d_7$) : 7.28 ppm, $^{29}$Si-NMR (DMF-$d_7$) : -100.1 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and dimethoxyethane assembled. Dimethoxyethane was not included in the crystal structure in an orderly manner and thus, the ratio of the numbers of molecules of $Q_8H_8$ and dimethoxyethane in the crystal structure unit was not calculated.

[Example 8] $Q_8H_8$ (three-dimensional (nanohoneycomb-shaped) structure) (with ferrocene added)

3.04 mL (48.04 mmol) of nitric acid was added to a dispersion obtained by suspending 8.062 g (4.00 mmol) of $Q_8(TMA)_8{\cdot}48.7H_2O$ in 150 mL of THF, and the resulting mixture was stirred for 30 minutes to obtain a suspension. This suspension was subjected to filter filtration (washed with 50 mL of THF).

0.372 g (2.00 mmol) of ferrocene was added to this filtrate and dissolved. This solution was concentrated under conditions of 25°C and a degree of decompression of 15999 Pa (120 torr) to isolate a green solid (columnar crystal) that was a composition containing 74.8% by mass of $Q_8H_8$ in a yield of 57% (1.687 g) ($^1$H-NMR (DMF-$d_7$) : 7.74 ppm, $^{29}$Si-NMR (DMF-$d_7$): -100.1 ppm) .

In addition, single crystal X-ray crystal structure analysis revealed that the crystal obtained had a crystal structure in which configurations of one molecule of $Q_8H_8$ and one molecule of ferrocene assembled, and a three-dimensional (nanohoneycomb-shaped) structure in which $Q_8H_8$ molecules were hydrogen-bonded to each other and stabilized.

[Example 9] $Q_8H_8$ (three-dimensional (nanohoneycomb-shaped) structure) (with nickelocene added)

1.52 mL (24.02 mmol) of nitric acid was added to a dispersion obtained by suspending 8.062 g (2.00 mmol) of $Q_8(TMA)_8{\cdot}48.7H_2O$ in 75 mL of THF, and the resulting mixture was stirred for 30 minutes to obtain a suspension. This suspension was subjected to filter filtration (washed with 25 mL of THF).

0.378 g (2.00 mmol) of nickelocene was added to this filtrate and dissolved. This solution was concentrated under conditions of 5°C and a degree of decompression of 6666 Pa (50 torr) to isolate a green solid (columnar crystal) that was a composition containing 74.5% by mass of $Q_8H_8$ in a yield of 52% (0.768 g) ($^1$H-NMR (DMF-$d_7$) : 7.73 ppm, $^{29}$Si-NMR (DMF-$d_7$) : -100.2 ppm) .

In addition, single crystal X-ray crystal structure analysis revealed that the crystal obtained had a crystal structure in which configurations of one molecule of $Q_8H_8$ and one molecule of nickelocene assembled, and a three-dimensional (nanohoneycomb-shaped) structure in which $Q_8H_8$ molecules were hydrogen-bonded to each other and stabilized.

[Example 10] $Q_8H_8$ (three-dimensional (nanohoneycomb-shaped) structure) (with ruthenocene added)

0.76 mL (12.01 mmol) of nitric acid was added to a dispersion obtained by suspending 2.016 g (1.00 mmol) of $Q_8(TMA)_8{\cdot}48.7H_2O$ in 37.5 mL of THF, and the resulting mixture was stirred for 30 minutes to obtain a suspension. This suspension was subjected to filter filtration (washed with 12.5 mL of THF).

0.231 g (1.00 mmol) of ruthenocene was added to this filtrate and dissolved. This solution was concentrated under conditions of 5°C and a degree of decompression of 6666 Pa (50 torr) to isolate a red solid (columnar crystal) that was a composition containing 70.5% by mass of $Q_8H_8$ ($^{29}$Si-NMR (DMF-$d_7$) : -100.0 ppm) .

In addition, single crystal X-ray crystal structure analysis revealed that the crystal obtained had a crystal structure in which configurations of one molecule of $Q_8H_8$ and one molecule of ruthenocene assembled, and a three-dimensional (nanohoneycomb-shaped) structure in which $Q_8H_8$ molecules were hydrogen-bonded to each other and stabilized.

[Example 11] $Q_8H_8$ (three-dimensional (nanohoneycomb-shaped) structure) (with thiophene added)

1.52 mL (24.02 mmol) of nitric acid was added to a dispersion obtained by suspending 4.031 g (2.00 mmol) of $Q_8(TMA)_8{\cdot}48.7H_2O$ in 75 mL of THF, and the resulting mixture was stirred for 30 minutes to obtain a suspension. This suspension was subjected to filter filtration (washed with 25 mL of THF).

8 mL (101.5 mmol) of thiophene was added to this filtrate and mixed. This solution was concentrated under conditions of 5°C and a degree of decompression of 4666 Pa (35 torr) to isolate a colorless solid (columnar crystal) that was a composition containing 76.7% by mass of $Q_8H_8$ in a yield of 55% (0.793 g) ($^1$H-NMR (DMF-$d_7$) : 6.50 ppm, $^{29}$Si-NMR (DMF-$d_7$) : -100.1 ppm) .

In addition, single crystal X-ray crystal structure analysis revealed that the crystal obtained had a crystal structure

in which configurations of one molecule of $Q_8H_8$ and two molecules of thiophene assembled, and a three-dimensional (nanohoneycomb-shaped) structure in which $Q_8H_8$ molecules were hydrogen-bonded to each other and stabilized.

[Example 12] $Q_8H_8$ (three-dimensional (nanohoneycomb-shaped) structure) (with benzene added)

3.04 mL (48.04 mmol) of nitric acid was added to a dispersion obtained by suspending 8.062 g (4.00 mmol) of $Q_8(TMA)_8 \cdot 48.7H_2O$ in 150 mL of THF, and the resulting mixture was stirred for 30 minutes to obtain a suspension. This suspension was subjected to filter filtration (washed with 50 mL of THF).

70 mL (787.7 mmol) of benzene was added to this filtrate and mixed. This solution was concentrated under conditions of 5°C and a degree of decompression of 4666 Pa (35 torr) to isolate a colorless solid (columnar crystal) that was a composition containing 78.0% by mass of $Q_8H_8$ in a yield of 79% (2.245 g) ($^1$H-NMR (DMF-$d_7$) : 7.73 ppm, $^{29}$Si-NMR (DMF-$d_7$) : -100.1 ppm) .

In addition, single crystal X-ray crystal structure analysis revealed that the crystal obtained had a crystal structure in which configurations of one molecule of $Q_8H_8$ and two molecules of benzene assembled, and a three-dimensional (nanohoneycomb-shaped) structure in which $Q_8H_8$ molecules were hydrogen-bonded to each other and stabilized.

[Example 13] $Q_8H_8$ (three-dimensional (nanohoneycomb-shaped) structure) (with 1,4-benzoquinone and benzene added)

1.52 mL (24.02 mmol) of nitric acid was added to a dispersion obtained by suspending 4.031 g (2.00 mmol) of $Q_8(TMA)_8 \cdot 48.7H_2O$ in 75 mL of THF, and the resulting mixture was stirred for 30 minutes to obtain a suspension. This suspension was subjected to filter filtration (washed with 25 mL of THF).

0.216 g (2.00 mmol) of 1,4-benzoquinone and 35 mL (393.9 mmol) of benzene were added to this filtrate and mixed. This solution was concentrated under conditions of 5°C and a degree of decompression of 6000 Pa (45 torr) to isolate a pale yellow solid (columnar crystal) that was a composition containing 74.8% by mass of $Q_8H_8$ in a yield of 74% (1.090 g) ($^1$H-NMR (DMF-$d_7$) : 7.73 ppm, $^{29}$Si-NMR (DMF-$d_7$) : -100.1 ppm).

In addition, single crystal X-ray crystal structure analysis revealed that the crystal obtained had a crystal structure in which configurations of one molecule of $Q_8H_8$, one molecule of 1,4-benzoquinone, and one molecule of benzene assembled, and a three-dimensional (nanohoneycomb-shaped) structure in which $Q_8H_8$ molecules were hydrogen-bonded to each other and stabilized.

[Example 14] $Q_8H_8$ (three-dimensional (nanohoneycomb-shaped) structure) (with 1,4-benzoquinone and thiophene added)

1.52 mL (24.02 mmol) of nitric acid was added to a dispersion obtained by suspending 4.031 g (2.00 mmol) of $Q_8(TMA)_8 \cdot 48.7H_2O$ in 75 mL of THF, and the resulting mixture was stirred for 30 minutes to obtain a suspension. This suspension was subjected to filter filtration (washed with 25 mL of THF).

0.216 g (2.00 mmol) of 1,4-benzoquinone and 10 mL (126.9 mmol) of thiophene were added to this filtrate and mixed. This solution was concentrated under conditions of 5°C and a degree of decompression of 4666 Pa (35 torr) to isolate a pale yellow solid (columnar crystal) that was a composition containing 74.2% by mass of $Q_8H_8$ in a yield of 78% (1.158 g) ($^1$H-NMR (DMF-$d_7$) : 7.73 ppm, $^{29}$Si-NMR (DMF-$d_7$) : -100.1 ppm).

In addition, single crystal X-ray crystal structure analysis revealed that the crystal obtained had a crystal structure in which configurations of one molecule of $Q_8H_8$, one molecule of 1,4-benzoquinone, and one molecule of thiophene assembled, and a three-dimensional (nanohoneycomb-shaped) structure in which $Q_8H_8$ molecules were hydrogen-bonded to each other and stabilized.

[Example 15] $Q_8H_8$ (three-dimensional (nanohoneycomb-shaped) structure) (dodecane-containing composition)

3.04 mL (48.04 mmol) of nitric acid was added to a dispersion obtained by suspending 8.062 g (4.00 mmol) of $Q_8(TMA)_8 \cdot 48.7H_2O$ in 150 mL of THF, and the resulting mixture was stirred for 30 minutes to obtain a suspension. This suspension was subjected to filter filtration (washed with 50 mL of THF).

70 mL (787.7 mmol) of benzene was added to this filtrate and mixed. This solution was concentrated under conditions of 5°C and a degree of decompression of 4666 Pa (35 torr) to isolate a colorless solid (columnar crystal) that was a composition containing 78.0% by mass of $Q_8H_8$. This colorless solid was transferred into 40 mL of acetonitrile and allowed to stand at room temperature for 6 hours, and then the liquid (acetonitrile) and the colorless solid were separated. This operation was carried out 3 times (total amount used of 120 mL).

40 mL of benzene was added to the obtained colorless solid, and the resulting mixture was allowed to stand at room temperature for 6 hours, and then the liquid (benzene) and the colorless solid were separated. This operation

was carried out twice (total amount used of 80 mL) .

20 mL of dodecane was added to the obtained colorless solid, and the resulting mixture was allowed to stand at room temperature for 6 hours, and then the

liquid (dodecane) and the colorless solid were separated. This operation was carried out 3 times (total amount used of 60 mL) to isolate a colorless solid (columnar crystal) that was a composition containing 73.2% by mass of $Q_8H_8$ in a yield of 71% (2.142 g) ($^1$H-NMR (DMF-$d_7$) : 7.72 ppm, $^{29}$Si-NMR (DMF-$d_7$) : -100.1 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and dodecane assembled. Dodecane was not included in the crystal structure in an orderly manner and thus, the ratio of the numbers of molecules of $Q_8H_8$ and dodecane in the crystal structure unit was not calculated.

[Example 16] $Q_8H_8$ (three-dimensional (nanohoneycomb-shaped) structure) (hexane-containing composition)

1.680 g of a colorless solid (columnar crystal) that was a composition containing 92.1% by mass of $Q_8H_8$ was isolated by the same operation as in Example 15 except that dodecane was changed to hexane ($^1$H-NMR (DMSO-$d_6$): 7.50 ppm, $^{29}$Si-NMR (DMF-$d_7$) : -100.6 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and hexane assembled. Hexane was not included in the crystal structure in an orderly manner and thus, the ratio of the numbers of molecules of $Q_8H_8$ and hexane in the crystal structure unit was not calculated.

[Example 17] $Q_8H_8$ (three-dimensional (nanohoneycomb-shaped) structure) (benzene-containing composition)

5.0 mL (56.3 mmol) of benzene was added to 0.868 g (1.000 mmol) of 63.7% by mass of a $Q_8H_8$ dodecane composition prepared and obtained by the method according to Example 15, and the resulting mixture was allowed to stand at room temperature for 48 hours. The liquid (benzene) was removed to isolate 0.709 g of a colorless solid (columnar crystal) that was a composition containing 78.0% by mass of $Q_8H_8$ ($^1$H-NMR (DMF-$d_7$) : 7.73 ppm, $^{29}$Si-NMR (DMF-$d_7$) : -100.1 ppm) .

In addition, single crystal X-ray crystal structure analysis revealed that the crystal obtained had a crystal structure in which configurations of one molecule of $Q_8H_8$ and two molecules of benzene assembled, and a three-dimensional (nanohoneycomb-shaped) structure in which $Q_8H_8$ molecules were hydrogen-bonded to each other and stabilized.

[Example 18] $Q_8H_8$ (three-dimensional (nanohoneycomb-shaped) structure) (thiophene-containing composition)

5.0 mL (63.5 mmol) of thiophene was added to 0.868 g (1.000 mmol) of 63.7% by mass of a $Q_8H_8$ dodecane composition prepared and obtained by the method according to Example 15, and the resulting mixture was allowed to stand at room temperature for 48 hours. The liquid (thiophene) was removed to isolate 0.721 g of a colorless solid (columnar crystal) that was a composition containing 76.7% by mass of $Q_8H_8$ ($^1$H-NMR (DMF-$d_7$) : 7.73 ppm, $^{29}$Si-NMR (DMF-$d_7$) : -100.1 ppm) .

In addition, single crystal X-ray crystal structure analysis revealed that the crystal obtained had a crystal structure in which configurations of one molecule of $Q_8H_8$ and two molecules of thiophene assembled, and a three-dimensional (nanohoneycomb-shaped) structure in which $Q_8H_8$ molecules were hydrogen-bonded to each other and stabilized.

[Example 19] $Q_8H_8$ (three-dimensional (nanohoneycomb-shaped) structure) (selenophene-containing composition)

2.5 mL (30.9 mmol) of selenophene was added to 0.868 g (1.000 mmol) of 63.7% by mass of a $Q_8H_8$ dodecane composition prepared and obtained by the method according to Example 15, and the resulting mixture was allowed to stand at room temperature for 48 hours. The liquid (selenophene) was removed to isolate 0.985 g of a pale yellow solid (columnar crystal) that was a composition containing 56.1% by mass of $Q_8H_8$ ($^1$H-NMR (DMF-$d_7$) : 7.72 ppm, $^{29}$Si-NMR (DMF-$d_7$) : -100.0 ppm) .

In addition, single crystal X-ray crystal structure analysis revealed that the crystal obtained had a crystal structure in which configurations of one molecule of $Q_8H_8$ and two molecules of selenophene assembled, and a three-dimensional (nanohoneycomb-shaped) structure in which $Q_8H_8$ molecules were hydrogen-bonded to each other and stabilized.

[Example 20] $Q_8H_8$ (three-dimensional (nanohoneycomb-shaped) structure) (selenophene-containing composition)

A solution containing 5.0 mL of 1,3,5-triisopropylbenzene and 0.486 mL (6.012 mmol) of selenophene was added to 0.868 g (1.000 mmol) of 63.7% by mass of a $Q_8H_8$ dodecane composition prepared and obtained by the method according to Example 15, and the resulting mixture was allowed to stand at room temperature for 72 hours. The liquid (selenophene/1,3,5-triisopropylbenzene solution) was removed to isolate 0.985 g of a pale yellow solid (columnar crystal) that was a composition containing 56.1% by mass of $Q_8H_8$ ($^1$H-NMR (DMF-$d_7$) : 7.72 ppm, $^{29}$Si-NMR (DMF-$d_7$) : -100.0 ppm).

In addition, single crystal X-ray crystal structure analysis revealed that the crystal obtained had a crystal structure in which configurations of one molecule of $Q_8H_8$ and two molecules of selenophene assembled, and a three-dimensional (nanohoneycomb-shaped) structure in which $Q_8H_8$ molecules were hydrogen-bonded to each other and stabilized.

[Example 21] $Q_8H_8$ (three-dimensional (nanohoneycomb-shaped) structure) (1,4-cyclohexadiene-containing composition)

A solution containing 5.0 mL of 1,3,5-triisopropylbenzene and 0.935 mL (10.00 mmol) of 1,4-cyclohexadiene was added to 0.868 g (1.000 mmol) of 63.7% by mass of a $Q_8H_8$ dodecane composition prepared and obtained by the method according to Example 15, and the resulting mixture was allowed to stand at room temperature for 72 hours. The liquid (1,4-cyclohexadiene/1,3,5-triisopropylbenzene solution) was removed to isolate 0.718 g of a colorless solid (columnar crystal) that was a composition containing 77.0% by mass of $Q_8H_8$ ($^1$H-NMR (DMSO-$d_6$) : 7.50 ppm, $^{29}$Si-NMR (DMSO-$d_6$) : - 100.6 ppm).

In addition, single crystal X-ray crystal structure analysis revealed that the crystal obtained had a crystal structure in which configurations of one molecule of $Q_8H_8$ and two molecules of 1,4-cyclohexadiene assembled, and a three-dimensional (nanohoneycomb-shaped) structure in which $Q_8H_8$ molecules were hydrogen-bonded to each other and stabilized.

[Example 22] $Q_8H_8$ (three-dimensional (nanohoneycomb-shaped) structure) (1,4-benzoquinone-containing composition)

A solution containing 40.0 mL of 1,3,5-triisopropylbenzene and 0.649 g (6.000 mmol) of 1,4-benzoquinone was added to 0.868 g (1.000 mmol) of 63.7% by mass of a $Q_8H_8$ dodecane composition prepared and obtained by the method according to Example 15, and the resulting mixture was allowed to stand at room temperature for 72 hours. The liquid (1,4-benzoquinone/1,3,5-triisopropylbenzene solution) was removed to isolate 0.782 g of a red orange solid (columnar crystal) that was a composition containing 70.6% by mass of $Q_8H_8$ ($^1$H-NMR (DMF-$d_7$) : 7.73 ppm, $^{29}$Si-NMR (DMF-$d_7$) : -99.8 ppm) .

In addition, single crystal X-ray crystal structure analysis revealed that the crystal obtained had a crystal structure in which configurations of one molecule of $Q_8H_8$ and two molecules of 1,4-benzoquinone assembled, and a three-dimensional (nanohoneycomb-shaped) structure in which $Q_8H_8$ molecules were hydrogen-bonded to each other and stabilized.

[Example 24] $Q_8H_8$ (three-dimensional (nanohoneycomb-shaped) structure) (ferrocene-containing composition)

A solution containing 10.0 mL of 1,3,5-triisopropylbenzene and 0.558 g (3.000 mmol) of ferrocene was added to 0.868 g (1.000 mmol) of 63.7% by mass of a $Q_8H_8$ dodecane composition prepared and obtained by the method according to Example 15, and the resulting mixture was allowed to stand at 40°C for 96 hours. The liquid (ferrocene/1,3,5-triisopropylbenzene solution) was removed to isolate 0.796 g of a dark green solid (columnar crystal) that was a composition containing 69.4% by mass of $Q_8H_8$ ($^1$H-NMR (DMSO-$d_6$) : 7.51 ppm, $^{29}$Si-NMR (DMSO-$d_6$) : -100.0 ppm) .

In addition, single crystal X-ray crystal structure analysis revealed that the crystal obtained had a crystal structure in which configurations of one molecule of $Q_8H_8$ and one molecule of ferrocene assembled, and a three-dimensional (nanohoneycomb-shaped) structure in which $Q_8H_8$ molecules were hydrogen-bonded to each other and stabilized.

[Example 25] $Q_8H_8$ (three-dimensional (nanohoneycomb-shaped) structure) (ruthenocene-containing composition)

A solution containing 80 mL of 1,3,5-triisopropylbenzene and 0.463 g (2.000 mmol) of ruthenocene was added to 0.868 g (1.000 mmol) of 63.7% by mass of a $Q_8H_8$ dodecane composition prepared and obtained by the method according to Example 15, and the resulting mixture was allowed to stand at 40°C for 72 hours. The liquid (ruthenocene/1,3,5-triisopropylbenzene solution) was removed to isolate 0.750 g of a solid (columnar crystal) that was a composition containing 73.6% by mass of $Q_8H_8$ ($^1$H-NMR (DMSO-$d_6$) : 7.51 ppm, $^{29}$Si-NMR (DMSO-$d_6$) : - 100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and ruthenocene assembled. Ruthenocene was not included in the crystal structure in an orderly manner and thus, the ratio of the numbers of molecules of $Q_8H_8$ and ruthenocene in the crystal structure unit was not calculated.

[Example 26] $Q_8H_8$ (three-dimensional (nanohoneycomb-shaped) structure) (nickelocene-containing composition)

A solution containing 80 mL of 1,3,5-triisopropylbenzene and 0.378 g (2.000 mmol) of nickelocene was added to 0.868 g (1.000 mmol) of 63.7% by mass of a $Q_8H_8$ dodecane composition prepared and obtained by the method according to Example 15, and the resulting mixture was allowed to stand at 40°C for 72 hours. The liquid (nickelocene/1,3,5-triisopropylbenzene solution) was removed to isolate 0.730 g of a dark green solid (columnar crystal) that was a composition containing 75.7% by mass of $Q_8H_8$ ($^1$H-NMR (DMSO-$d_6$) : 7.50 ppm, $^{29}$Si-NMR (DMSO-$d_6$): -100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and nickelocene assembled. Nickelocene was not included in the crystal structure in an orderly manner and thus, the ratio of the numbers of molecules of $Q_8H_8$ and nickelocene in the crystal structure unit was not calculated.

[Example 27] $Q_8H_8$ (three-dimensional (nanohoneycomb-shaped) structure) (ferrocene and ruthenocene-containing composition)

A solution containing 60 mL of 1,3,5-triisopropylbenzene, 0.093 g (0.500 mmol) of ferrocene, and 0.463 g (2.000 mmol) of ruthenocene was added to 0.868 g (1.000 mmol) of 63.7% by mass of a $Q_8H_8$ dodecane composition prepared and obtained by the method according to Example 15, and the resulting mixture was allowed to stand at 40°C for 72 hours. The liquid (ferrocene/ruthenocene/1,3,5-triisopropylbenzene solution) was removed to isolate 0.745 g of a light brown solid (columnar crystal) that was a composition containing 74.2% by mass of $Q_8H_8$ ($^1$H-NMR (DMSO-$d_6$) : 7.50 ppm, $^{29}$Si-NMR (DMSO-$d_6$) : -100.6 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$,ferrocene, and ruthenocene assembled. Ferrocene and ruthenocene were not included in the crystal structure in an orderly manner and thus, the ratio of the numbers of molecules of $Q_8H_8$, ferrocene, and ruthenocene in the crystal structure unit was not calculated.

[Example 28] $Q_8H_8$ (three-dimensional (nanohoneycomb-shaped) structure) (1,6-dimethylnaphthalene-containing composition)

A solution containing 40.0 mL of 1,3,5-triisopropylbenzene and 0.469 g (3.000 mmol) of 1,6-dimethylnaphthalene was added to 0.868 g (1.000 mmol) of 63.7% by mass of a $Q_8H_8$ dodecane composition prepared and obtained by the method according to Example 15, and the resulting mixture was allowed to stand at 40°C for 96 hours. The liquid (1,6-dimethylnaphthalene/1,3,5-triisopropylbenzene solution) was removed to isolate 0.654 g of a colorless solid (columnar crystal) that was a composition containing 84.5% by mass of $Q_8H_8$ ($^1$H-NMR (DMF-$d_7$) : 7.75 ppm, $^{29}$Si-NMR (DMF-$d_6$) : -100.0 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and 1,6-dimethylnaphthalene assembled. 1,6-Dimethylnaphthalene was not included in the crystal structure in an orderly manner and thus, the ratio of the numbers of molecules of $Q_8H_8$ and 1,6-dimethylnaphthalene in the crystal structure unit was not calculated.

[Example 29] $Q_8H_8$ (three-dimensional (nanohoneycomb-shaped) structure) (anthracene-containing composition)

A solution containing 120.0 mL of 1,3,5-triisopropylbenzene and 0.356 g (2.000 mmol) of anthracene was added to 0.868 g (1.000 mmol) of 63.7% by mass of a $Q_8H_8$ dodecane composition prepared and obtained by the method according to Example 15, and the resulting mixture was allowed to stand at 40°C for 168 hours. The liquid (anthracene/1,3,5-triisopropylbenzene solution) was removed to isolate 0.730 g of a pale yellow solid (columnar crystal) that was a composition containing 75.7% by mass of $Q_8H_8$ ($^1$H-NMR (DMSO-$d_6$) : 7.51 ppm, $^{29}$Si-NMR (DMSO-$d_6$): -100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and anthracene assembled. Anthracene was not included in the crystal structure in an orderly manner and thus, the ratio of the numbers of molecules of $Q_8H_8$ and anthracene in the crystal structure unit was not calculated.

[Example 30] $Q_8H_8$ (three-dimensional (nanohoneycomb-shaped) structure) (2,2':5',2''-terthiophene-containing composition)

A solution containing 10.0 mL of 1,3,5-triisopropylbenzene and 0.497 g (2.000 mmol) of 2,2':5',2''-terthiophene was added to 0.868 g (1.000 mmol) of 63.7% by mass of a $Q_8H_8$ dodecane composition prepared and obtained by the method according to Example 15, and the resulting mixture was allowed to stand at 40°C for 96 hours. The liquid (2,2' :5', 2''-terthiophene/1,3,5-triisopropylbenzene solution) was removed to isolate 0.826 g of a light green solid (columnar crystal) that was a composition containing 66.9% by mass of $Q_8H_8$ ($^1$H-NMR (DMSO-$d_6$) : 7.51 ppm, $^{29}$Si-NMR (DMSO-$d_6$): -100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and 2,2':5',2''-terthiophene assembled. 2,2':5',2''-Terthiophene was not included in the crystal structure in an orderly manner and thus, the ratio of the numbers of molecules of $Q_8H_8$ and 2,2':5',2''-terthiophene in the crystal structure unit was not calculated.

[Example 31] $Q_8H_8$ (three-dimensional (nanohoneycomb-shaped) structure) (5,5'-dibromo-2,2':5',2''-terthiophene-containing composition)

A solution containing 10.0 mL of 1,3,5-triisopropylbenzene and 0.812 g (2.000 mmol) of 5,5'-dibromo-2,2':5',2''-terthiophene was added to 0.868 g (1.000 mmol) of 63.7% by mass of a $Q_8H_8$ dodecane composition prepared and obtained by the method according to Example 15, and the resulting mixture was allowed to stand at 40°C for 120 hours. The liquid (5,5'-dibromo-2,2':5',2''-terthiophene/1,3,5-triisopropylbenzene solution) was removed to isolate 0.935 g of a pale yellow solid (columnar crystal) that was a composition containing 59.1% by mass of $Q_8H_8$ ($^1$H-NMR (DMSO-$d_6$) : 7.50 ppm, $^{29}$Si-NMR (DMSO-$d_6$) : -100.6 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and 5,5'-dibromo-2,2':5',2''-terthiophene assembled. 5,5'-Dibromo-2,2':5',2''-terthiophene was not included in the crystal structure in an orderly manner and thus, the ratio of the numbers of molecules of $Q_8H_8$ and 5,5'-dibromo-2,2':5',2''-terthiophene in the crystal structure unit was not calculated.

[Example 32] $Q_8H_8$ (three-dimensional (nanohoneycomb-shaped) structure) (benzo[1,2-b':4,5-b']dithiophene-containing composition)

A solution containing 80.0 mL of 1,3,5-triisopropylbenzene and 0.381 g (2.000 mmol) of benzo[1,2-b':4,5-b']dithiophene was added to 0.868 g (1.000 mmol) of 63.7% by mass of a $Q_8H_8$ dodecane composition prepared and obtained by the method according to Example 15, and the resulting mixture was allowed to stand at 40°C for 168 hours. The liquid (benzo[1,2-b':4,5-b']dithiophene/1,3,5-triisopropylbenzene solution) was removed to isolate 0.731 g of a pale yellow solid (columnar crystal) that was a composition containing 75.6% by mass of $Q_8H_8$ ($^1$H-NMR (DMSO-$d_6$) : 7.51 ppm, $^{29}$Si-NMR (DMSO-$d_6$): -100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and benzo[1,2-b':4,5-b']dithiophene assembled. Benzo[1,2-b':4,5-b']dithiophene was not included in the crystal structure in an orderly manner and thus, the ratio of the numbers of molecules of $Q_8H_8$ and benzo[1,2-b':4,5-b']dithiophene in the crystal structure unit was not calculated.

[Example 33] $Q_8H_8$ (three-dimensional (nanohoneycomb-shaped) structure) (azobenzene-containing composition)

A solution containing 10.0 mL of 1,3,5-triisopropylbenzene and 0.911 g (5.000 mmol) of azobenzene was added to 0.868 g (1.000 mmol) of 63.7% by mass of a $Q_8H_8$ dodecane composition prepared and obtained by the method according to Example 15, and the resulting mixture was allowed to stand at 40°C for 72 hours. The liquid (azobenzene/1,3,5-triisopropylbenzene solution) was removed to isolate 0.761 g of an orange solid (columnar crystal) that was

a composition containing 72.6% by mass of $Q_8H_8$ ($^1$H-NMR (DMSO-$d_6$) : 7.51 ppm, $^{29}$Si-NMR (DMSO-$d_6$): -100.6 ppm).

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and azobenzene assembled. Azobenzene was not included in the crystal structure in an orderly manner and thus, the ratio of the numbers of molecules of $Q_8H_8$ and azobenzene in the crystal structure unit was not calculated.

[Example 34] $Q_8H_8$ (three-dimensional (nanohoneycomb-shaped) structure) (1,1,1,3,5,5,5-heptamethyltrisiloxane-containing composition)

A solution containing 2.000 mL of 1,3,5-triisopropylbenzene and 2.704 mL (10.000 mmol) of 1,1,1,3,5,5,5-heptamethyltrisiloxane was added to 0.868 g (1.000 mmol) of 63.7% by mass of a $Q_8H_8$ dodecane composition prepared and obtained by the method according to Example 15, and the resulting mixture was allowed to stand at 40°C for 72 hours. The liquid (1,1,1,3,5,5,5-heptamethyltrisiloxane/1,3,5-triisopropylbenzene solution) was removed to isolate 0.705 g of a colorless solid (columnar crystal) that was a composition containing 78.4% by mass of $Q_8H_8$ ($^1$H-NMR (DMSO-$d_6$) : 7.51 ppm, $^{29}$Si-NMR (DMSO-$d_6$) : -100.6 ppm) .

In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and 1,1,1,3,5,5,5-heptamethyltrisiloxane assembled. 1,1,1,3,5,5,5-Heptamethyltrisiloxane was not included in the crystal structure in an orderly manner and thus, the ratio of the numbers of molecules of $Q_8H_8$ and 1,1,1,3,5,5,5-heptamethyltrisiloxane in the crystal structure unit was not calculated.

[Example 35] $Q_8H_8$ (three-dimensional (nanohoneycomb-shaped) structure) 1,4-benzoquinone and thiophene-containing composition)

A solution containing 15.0 mL of 1,3,5-triisopropylbenzene and 0.216 g (2.000 mmol) of 1,4-benzoquinone and 1.009 g (12.000 mmol) of thiophene was added to 0.868 g (1.000 mmol) of 63.7% by mass of a $Q_8H_8$ dodecane composition prepared and obtained by the method according to Example 15, and the resulting mixture was allowed to stand at 25°C for 72 hours. The liquid (1,4-benzoquinone/thiophene/1,3,5-triisopropylbenzene solution) was removed to isolate 0.739 g of a pale yellow solid (columnar crystal) that was a composition containing 74.8% by mass of $Q_8H_8$ ($^1$H-NMR (DMSO-$d_6$) : 7.50 ppm, $^{29}$Si-NMR (DMSO-$d_6$) : -100.6 ppm) .

In addition, single crystal X-ray crystal structure analysis revealed that the crystal obtained had a crystal structure in which configurations of one molecule of $Q_8H_8$, one molecule of 1,4-benzoquinone, and one molecule of thiophene assembled, and a three-dimensional (nanohoneycomb-shaped) structure in which $Q_8H_8$ molecules were hydrogen-bonded to each other and stabilized.

[Example 36] $Q_8H_8$ (three-dimensional (nanohoneycomb-shaped) structure) (1,4-benzoquinone and benzene-containing composition)

A solution containing 15.0 mL of 1,3,5-triisopropylbenzene and 0.216 g (2.000 mmol) of 1,4-benzoquinone and 1.406 g (18.000 mmol) of benzene was added to 0.868 g (1.000 mmol) of 63.7% by mass of a $Q_8H_8$ dodecane composition prepared and obtained by the method according to Example 15, and the resulting mixture was allowed to stand at 25°C for 72 hours. The liquid (1,4-benzoquinone/benzene/1,3,5-triisopropylbenzene solution) was removed to isolate 0.717 g of a pale yellow solid (columnar crystal) that was a composition containing 77.1% by mass of $Q_8H_8$ ($^1$H-NMR (DMSO-$d_6$) : 7.50 ppm, $^{29}$Si-NMR (DMSO-$d_6$): -100.6 ppm).

In addition, single crystal X-ray crystal structure analysis revealed that the crystal obtained had a crystal structure in which configurations of one molecule of $Q_8H_8$, one molecule of 1,4-benzoquinone, and one molecule of benzene assembled, and a three-dimensional (nanohoneycomb-shaped) structure in which $Q_8H_8$ molecules were hydrogen-bonded to each other and stabilized.

[Example 37] $Q_8H_8$ (three-dimensional (nanohoneycomb-shaped) structure) (furan-containing composition)

A solution containing 5.0 mL of 1,3,5-triisopropylbenzene and 1.362 g (20.000 mmol) of furan was added to 0.868 g (1.000 mmol) of 63.7% by mass of a $Q_8H_8$ dodecane composition prepared and obtained by the method according to Example 15, and the resulting mixture was allowed to stand at 25°C for 48 hours. The liquid (furan/1,3,5-triisopropylbenzene solution) was removed to isolate 0.689 g of a light yellow solid (columnar crystal) that was a composition containing 80.2% by mass of $Q_8H_8$ ($^1$H-NMR (DMSO-$d_6$) : 7.50 ppm, $^{29}$Si-NMR (DMSO-$d_6$) : - 100.6 ppm).

In addition, single crystal X-ray crystal structure analysis revealed that the crystal obtained had a crystal structure in which configurations of one molecule of $Q_8H_8$ and two molecules of furan assembled, and a three-dimensional (nanohoneycomb-shaped) structure in which $Q_8H_8$ molecules were hydrogen-bonded to each other and stabilized.

[Example 38] $Q_8H_8$ (three-dimensional (nanohoneycomb-shaped) structure) (iodine-containing composition)

A solution containing 10.0 mL of 1,3,5-triisopropylbenzene and 0.761 g (3.000 mmol) of iodine was added to 0.868 g (1.000 mmol) of 63.7% by mass of a $Q_8H_8$ dodecane composition prepared and obtained by the method according to Example 15, and the resulting mixture was allowed to stand at 25°C for 168 hours. The liquid (iodine/1,3,5-triisopropylbenzene solution) was removed to isolate 0.798 g of a deep red purple solid (columnar crystal) that was a composition containing 69.2% by mass of $Q_8H_8$ ($^1$H-NMR (DMSO-$d_6$) : 7.48 ppm, $^{29}$Si-NMR (DMSO-$d_6$) : - 100.6 ppm).
In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and iodine assembled. Iodine was not included in the crystal structure in an orderly manner and thus, the ratio of the numbers of molecules of $Q_8H_8$ and iodine in the crystal structure unit was not calculated.

[Example 39] $Q_8H_8$ (three-dimensional (nanohoneycomb-shaped) structure) (sulfur-containing composition)

A solution containing 80.0 mL of 1,3,5-triisopropylbenzene and 0.513 g (2.000 mmol) of sulfur was added to 0.868 g (1.000 mmol) of 63.7% by mass of a $Q_8H_8$ dodecane composition prepared and obtained by the method according to Example 15, and the resulting mixture was allowed to stand at 40°C for 168 hours. The liquid (sulfur/1,3,5-triisopropylbenzene solution) was removed to isolate 0.785 g of a colorless solid (columnar crystal) that was a composition containing 70.4% by mass of $Q_8H_8$ ($^1$H-NMR (DMSO-$d_6$) : 7.50 ppm, $^{29}$Si-NMR (DMSO-$d_6$) : - 100.6 ppm).
In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and sulfur assembled. Sulfur was not included in the crystal structure in an orderly manner and thus, the ratio of the numbers of molecules of $Q_8H_8$ and sulfur in the crystal structure unit was not calculated.

[Example 40] $Q_8H_8$ (three-dimensional (nanohoneycomb-shaped) structure) (2,6-dibromonaphthalene-containing composition)

A solution containing 50.0 mL of 1,3,5-triisopropylbenzene and 0.858 g (3.000 mmol) of 2,6-dibromonaphthalene was added to 0.868 g (1.000 mmol) of 63.7% by mass of a $Q_8H_8$ dodecane composition prepared and obtained by the method according to Example 15, and the resulting mixture was allowed to stand at 40°C for 168 hours. The liquid (2,6-dibromonaphthalene/1,3,5-triisopropylbenzene solution) was removed to isolate 0.773 g of a colorless solid (columnar crystal) that was a composition containing 71.5% by mass of $Q_8H_8$ ($^1$H-NMR (DMSO-$d_6$) : 7.51 ppm, $^{29}$Si-NMR (DMSO-$d_6$) : -100.6 ppm) .
In addition, single crystal X-ray crystal structure analysis revealed that the obtained crystal had a three-dimensional (nanohoneycomb-shaped) structure in which $Q_8H_8$ molecules were hydrogen-bonded to each other and stabilized. $^1$H-NMR analysis confirmed that the crystal had a crystal structure in which $Q_8H_8$ and 2,6-dibromonaphthalene assembled. 2,6-Dibromonaphthalene was not included in the crystal structure in an orderly manner and thus, the ratio of the numbers of molecules of $Q_8H_8$ and 2,6-dibromonaphthalene in the crystal structure unit was not calculated.

[Example 41] $Q_8H_8$ (two-dimensional (sheet-shaped) structure) (allyl methacrylate-containing composition)

4.680 g (37.097 mmol) of allyl methacrylate was added to 0.701 g (1.000 mmol) of 78.9% by mass of a $Q_8H_8$ diethyl ether composition prepared and obtained by the method according to Example 3, and the resulting mixture was allowed to stand at 25°C for 24 hours. The liquid (diethyl ether/allyl methacrylate solution) was removed to isolate 0.932 g of a colorless solid (plate-shaped crystal) that was a composition containing 59.3% by mass of $Q_8H_8$ ($^1$H-NMR (DMSO-$d_6$) : 7.51 ppm, $^{29}$Si-NMR (DMSO-$d_6$) : - 100.6 ppm).
In addition, single crystal X-ray crystal structure analysis revealed that the obtained crystal had a two-dimensional (sheet-shaped) structure in which $Q_8H_8$ molecules were hydrogen-bonded to each other and stabilized. $^1$H-NMR analysis confirmed that the crystal had a crystal structure in which $Q_8H_8$ and allyl methacrylate assembled. Allyl methacrylate was not included in the crystal structure in an orderly manner and thus, the ratio of the numbers of molecules of $Q_8H_8$ and allyl methacrylate in the crystal structure unit was not calculated.

[Example 42] $Q_8H_8$ (two-dimensional (sheet-shaped) structure) (allyl glycidyl ether-containing composition)

4.855 g (42.534 mmol) of allyl glycidyl ether was added to 0.701 g (1.000 mmol) of 78.9% by mass of a $Q_8H_8$ diethyl ether composition prepared and obtained by the method according to Example 3, and the resulting mixture was allowed to stand at 25°C for 24 hours. The liquid (diethyl ether/allyl glycidyl ether solution) was removed to isolate 0.978 g of a colorless solid (plate-shaped crystal) that was a composition containing 56.5% by mass of $Q_8H_8$ ($^1$H-NMR (DMSO-$d_6$) : 7.51 ppm, $^{29}$Si-NMR (DMSO-$d_6$) : - 100.6 ppm).

In addition, single crystal X-ray crystal structure analysis revealed that the obtained crystal had a two-dimensional (sheet-shaped) structure in which $Q_8H_8$ molecules were hydrogen-bonded to each other and stabilized. $^1$H-NMR analysis confirmed that the crystal had a crystal structure in which $Q_8H_8$ and allyl glycidyl ether assembled. Allyl glycidyl ether was not included in the crystal structure in an orderly manner and thus, the ratio of the numbers of molecules of $Q_8H_8$ and allyl glycidyl ether in the crystal structure unit was not calculated.

Industrial Applicability

For example, by heating the crystal of the present invention or contacting the crystal with an acid, a base, and/or the like, a material having a regular fine structure can be obtained. In particular, by forming a complex with another organic compound, transition metal complex, inorganic substance, elemental substance, or the like, a finely structurally controlled material having an unprecedented physical property can be created.

In addition, the crystal of the present invention has industrial applicability as a raw material for obtaining a $SiO_2$ material that can be used for the application of drug delivery, or the like.

## Claims

1. A crystal
comprising a plurality of silanol compounds of at least one selected from the group consisting of a hexamer represented by following formula (1), an octamer represented by following formula (2), and a decamer represented by following formula (3), and
having an interaction via a hydrogen bond by at least one hydroxy group between the silanol compounds.

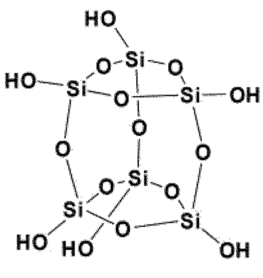
(1)

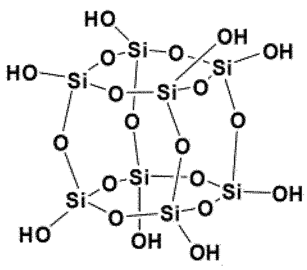
(2)

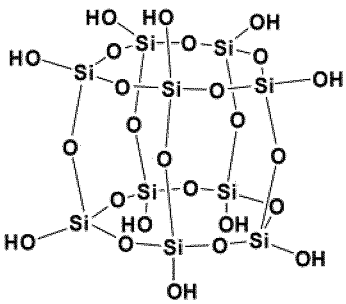
(3)

2. The crystal according to claim 1, wherein the crystal has a one-dimensional structure in which the silanol compounds are linearly aligned by the interaction via the hydrogen bond.

3. The crystal according to claim 1, wherein the crystal has a two-dimensional structure in which the silanol compounds are planarly aligned by the interaction via the hydrogen bond.

4. The crystal according to claim 1, wherein the crystal has a three-dimensional structure in which the silanol compounds are sterically aligned by the interaction via the hydrogen bond.

5. The crystal according to any one of claims 1 to 4, wherein the crystal comprises at least one substance selected from the group consisting of an organic compound, a transition metal complex, an inorganic substance, and an elemental substance.

6. A method of producing the crystal according to any one of claims 1 to 5, the method comprising:

a step of preparing a solution containing the silanol compounds; and
a step of carrying out recrystallization by a vapor diffusion process applied to the solution and, optionally, by further adding at least one substance selected from the group consisting of an organic compound, a transition metal complex, an inorganic substance, and an elemental substance to the solution.

**7.** A method of producing the crystal according to any one of claims 1 to 5, the method comprising:

a step of preparing a solution containing the silanol compounds; and
a step of carrying out recrystallization by concentrating the solution under reduced pressure and, optionally, by further adding at least one substance selected from the group consisting of an organic compound, a transition metal complex, an inorganic substance, and an elemental substance to the solution.

**8.** A method of producing the crystal according to any one of claims 1 to 5, the method comprising:

a step of preparing a solution containing the silanol compounds; and
a step of carrying out recrystallization by cooling the solution and, optionally, by further adding at least one substance selected from the group consisting of an organic compound, a transition metal complex, an inorganic substance, and an elemental substance to the solution.

**9.** A method of producing a crystal (P) comprising at least one substance selected from the group consisting of an organic compound, a transition metal complex, an inorganic substance, and an elemental substance, the method comprising:

a step of preparing a crystal (S) comprising a plurality of silanol compounds of at least one selected from the group consisting of a hexamer represented by following formula (1), an octamer represented by following formula (2), and a decamer represented by following formula (3), having an interaction via a hydrogen bond by at least one hydroxy group between the silanol compounds, and comprising at least one first substance selected from the group consisting of an organic compound, a transition metal complex, an inorganic substance, and an elemental substance; and
a step of obtaining the crystal (P) by contacting the crystal (S) with at least one second substance selected from the group consisting of an organic compound, a transition metal complex, an inorganic substance, and an elemental substance, to replace at least a part of the first substance contained in the crystal (S) with the second substance.

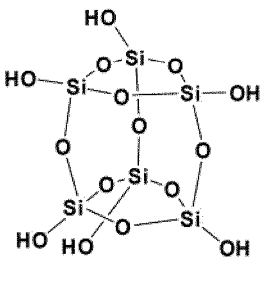
(1)

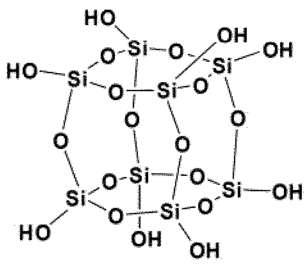
(2)

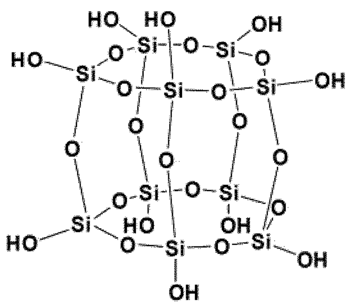
(3)

**10.** The method according to claim 9, wherein the step of preparing a crystal (S) comprises:

a step of preparing a solution containing the silanol compounds; and
a step of carrying out recrystallization by a vapor diffusion process applied to the solution or by concentrating the solution under reduced pressure or by cooling the solution, and, optionally, by further adding at least one substance selected from the group consisting of an organic compound, a transition metal complex, an inorganic substance, and an elemental substance to the solution.

**11.** A method of self-organizing at least one silanol compound selected from the group consisting of a hexamer represented by following formula (1), an octamer represented by following formula (2), and a decamer represented by following formula (3), the method comprising:
a step of forming an interaction by a hydrogen bond by a vapor diffusion process applied to a solution containing

the silanol compound or by concentrating the solution under reduced pressure or by cooling the solution.

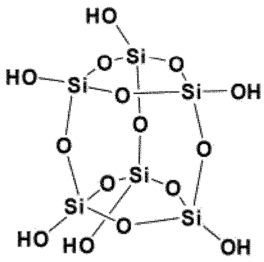

(1)

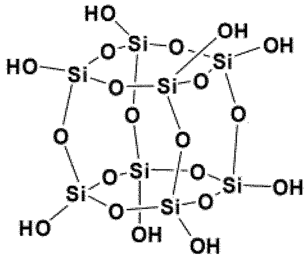

(2)

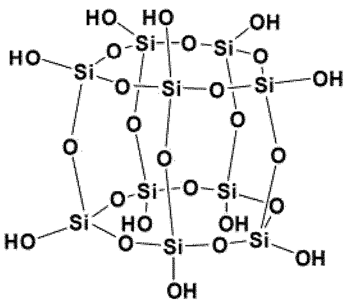

(3)

[Figure 1]

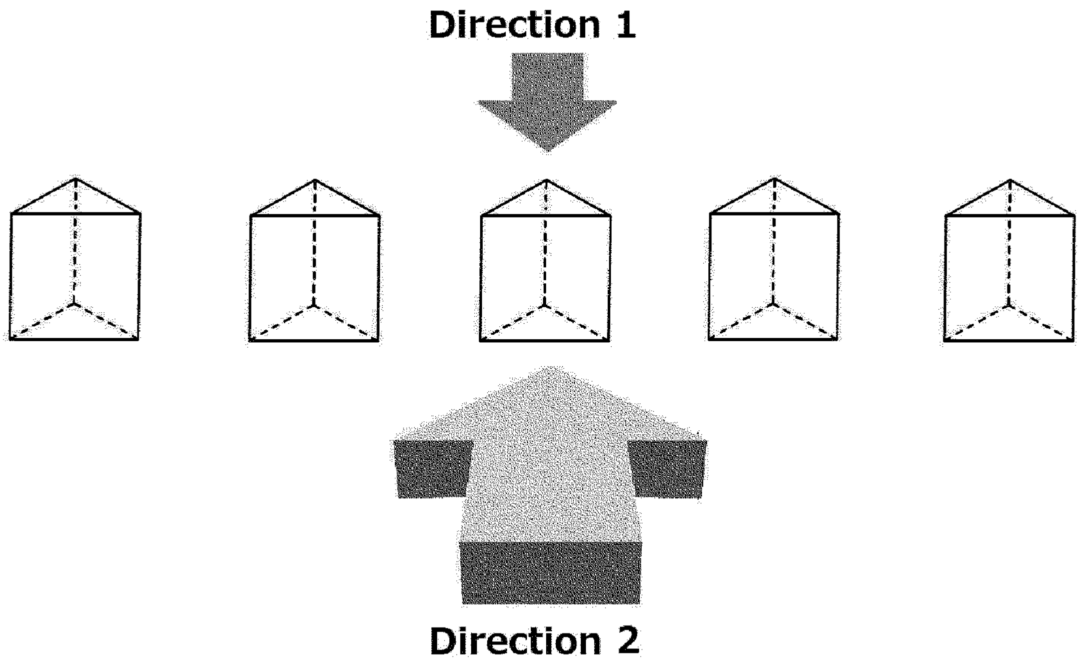

[Figure 2]

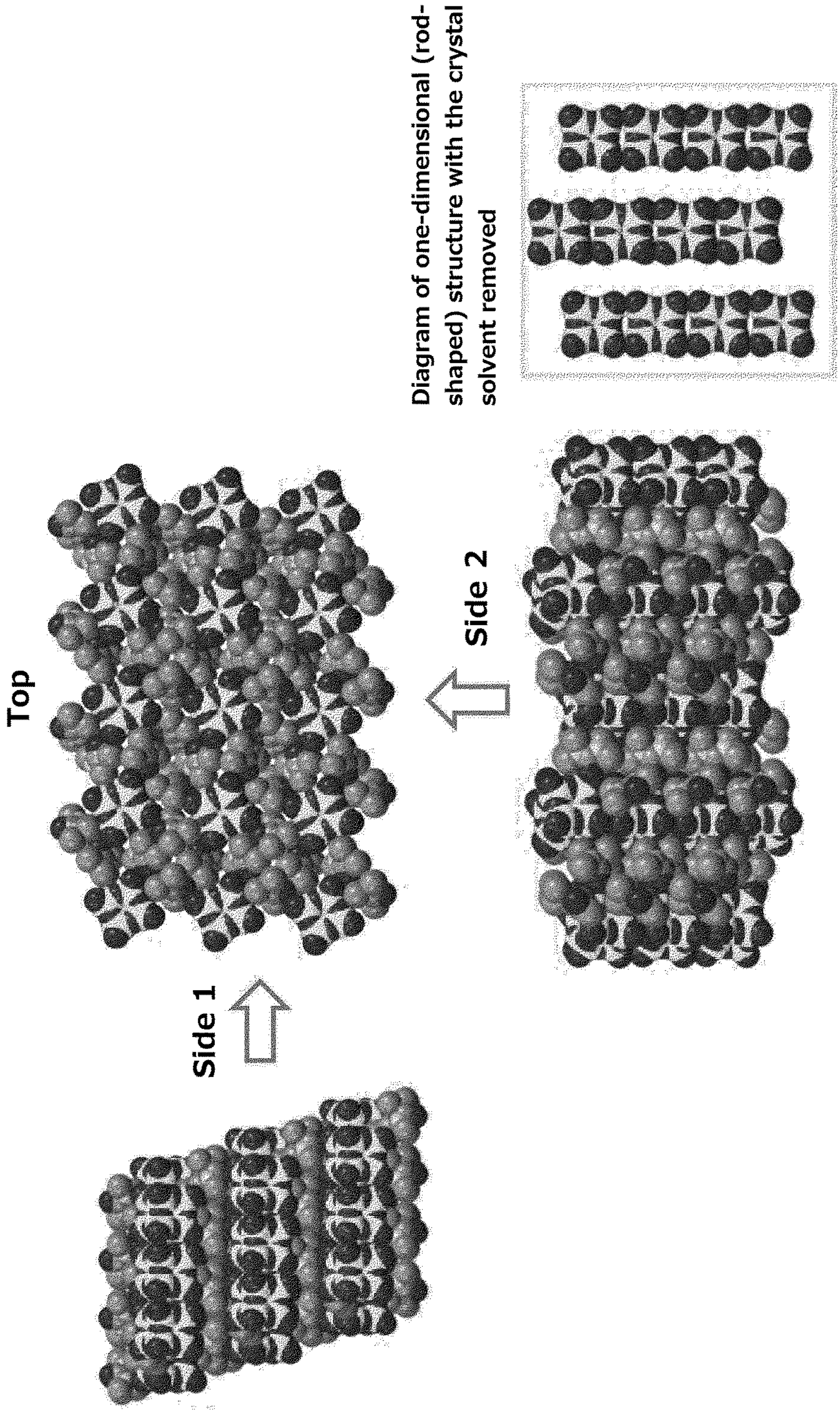
Top
Side 1
Side 2
Diagram of one-dimensional (rod-shaped) structure with the crystal solvent removed

[Figure 3]

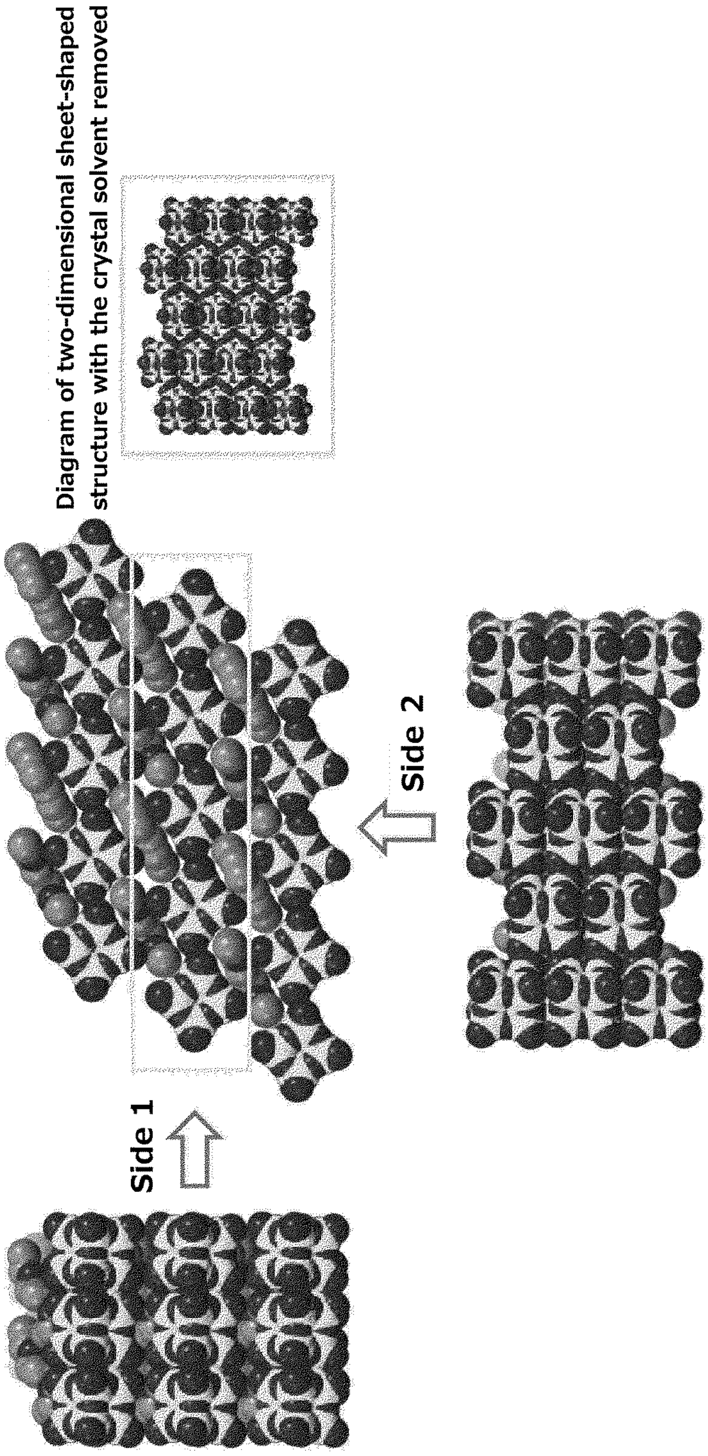
Diagram of two-dimensional sheet-shaped
structure with the crystal solvent removed
Top
Side 1
Side 2

[Figure 4]

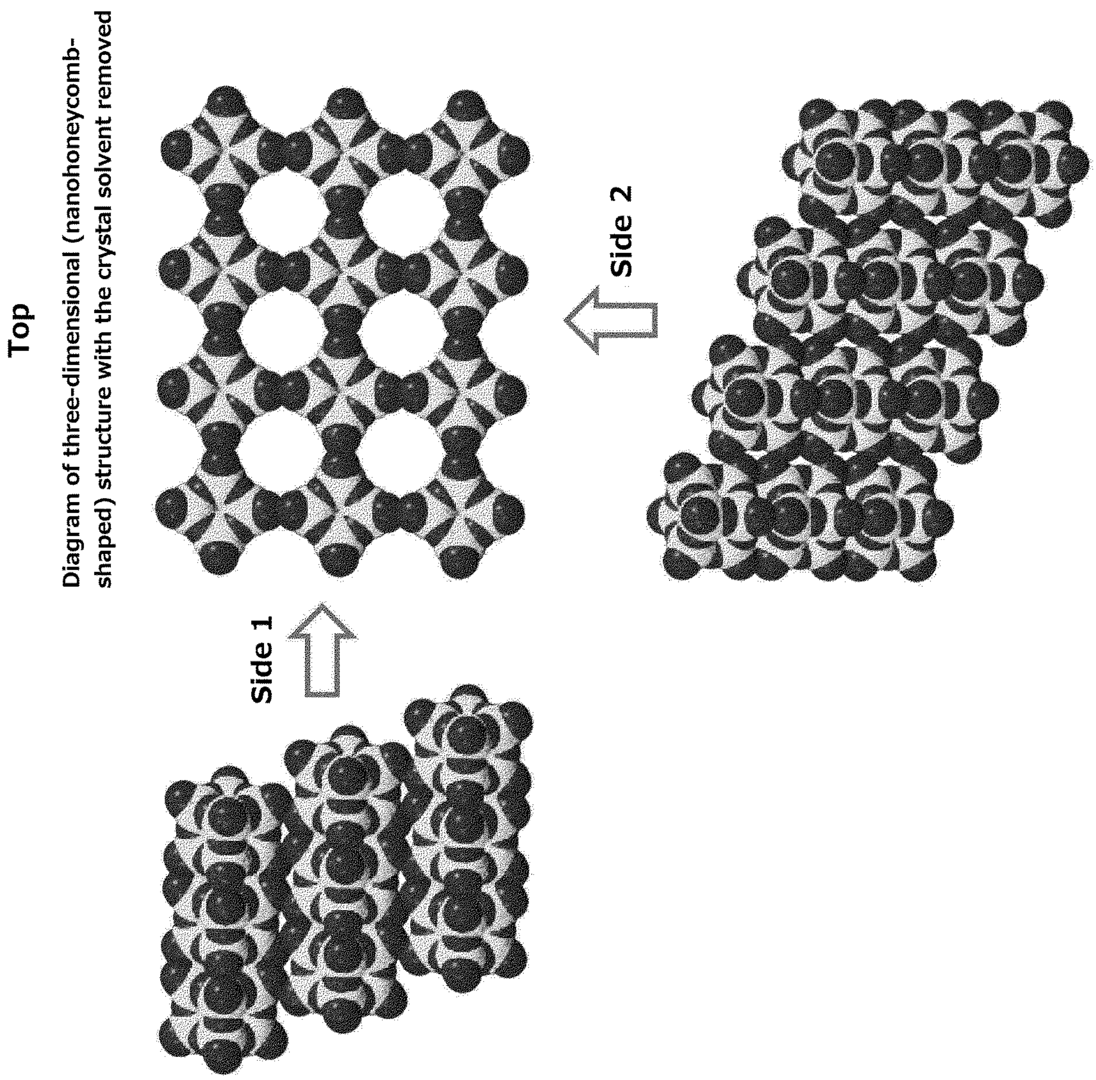
Top
Diagram of three-dimensional (nanohoneycomb-shaped) structure with the crystal solvent removed
Side 1
Side 2

**INTERNATIONAL SEARCH REPORT**

International application No.
PCT/JP2019/041579

A. CLASSIFICATION OF SUBJECT MATTER
Int.Cl. C30B29/60(2006.01)i, C01B33/00(2006.01)i, C01B33/12(2006.01)i

According to International Patent Classification (IPC) or to both national classification and IPC

B. FIELDS SEARCHED

Minimum documentation searched (classification system followed by classification symbols)
Int.Cl. C30B29/60, C01B33/00, C01B33/12

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
JSTPlus/JST7580 (JDreamIII), CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | VERLOOY, Pieter L. H. et al., "Synthesis and characterization of the new cyclosilicate hydrate (hexamethyleneimine)$_4$•[$Si_8O_{16}(OH)_4$]•$12H_2O$", Microporous and Mesoporous Materials, 13 October 2009, vol. 130, pp. 14-20 | 1-2,5,9<br>3-4,6-8,10-11 |
| A | 野澤 竹志ほか，シランテトラオールのかご型８量体の合成，構造および反応性， 日本化学会第 98 春季年会講演予稿集，06 March 2018, 3A8-05, (NOZAWA, Takeshi et al., "Synthesis,Structure and Reactivity of Cubic Octamer of Orthosilicic acid", Lecture preprints of the 98th Spring Annual Meeting of CSJ) | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 December 2019 (10.12.2019) | 17 December 2019 (17.12.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No. PCT/JP2019/041579

C (Continuation). DOCUMENTS CONSIDERED TO BE RELEVANT

| Category* | Citation of document, with indication, where appropriate, of the relevant passages | Relevant to claim No. |
|---|---|---|
| A | WO 2017 /065311 A1 (NATIONAL INSTITUTE OF ADVANCED INDUSTRIAL SCIENCE AND TECHNOLOGY) 20 April 2017 (Family: none) | 1-11 |
| A | JP 2002-363287 A (TOAGOSEI CO., LTD.) 18 December 2002 (Family: none) | 1-11 |
| P,A | WO 2018/193732 A1 (NATIONAL INSTITUTE OF ADVANCED INDUSTRIAL SCIENCE AND TECHNOLOGY) 25 October 2018 (Family: none) | 1-11 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Nature Communications,* 2017, vol. 8, 140
- *CHEMICAL ABSTRACTS,* 69667-29-4